(19) Europäisches Patentamt European Patent Office Office européen des brevets

(11) EP 1 840 622 A2

(12) EUROPÄISCHE PATENTANMELDUNG

(43) Veröffentlichungstag:
03.10.2007 Patentblatt 2007/40

(51) Int Cl.:
*G02B 17/06* (2006.01)

(21) Anmeldenummer: 07005743.5

(22) Anmeldetag: 21.03.2007

(84) Benannte Vertragsstaaten:
AT BE BG CH CY CZ DE DK EE ES FI FR GB GR
HU IE IS IT LI LT LU LV MC MT NL PL PT RO SE
SI SK TR
Benannte Erstreckungsstaaten:
AL BA HR MK YU

(30) Priorität: 27.03.2006 DE 102006014380
27.03.2006 US 786744 P

(71) Anmelder: Carl Zeiss SMT AG
73447 Oberkochen (DE)

(72) Erfinder:
• Singer, Wolfgang
73431 Aalen (DE)
• Mann, Hans-Jürgen
73447 Oberkochen (DE)

(74) Vertreter: Sawodny, Michael-Wolfgang
Dreiköniggasse 10
89073 Ulm (DE)

(54) Projektionsobjektiv und Projektionsbelichtungsanlage mit negativer Schnittweite der Eintrittspupille

(57) Die Erfindung betrifft ein Projektionsobjektiv umfassend:
- eine Objektebene (20, 100, 300 2103), in der ein Objektfeld ausgebildet wird,
- eine Eintrittspupille (VE)
- eine gespiegelte Eintrittspupille (RE) in einer gespiegelten Eintrittspupillenebene (103), die durch Spiegelung der Eintrittspupille (VE) an der Objektebene erhalten wird,
- eine Bildebene (21, 102, 302, 2102),
- eine optische Achse (HA)

- wenigstens einen ersten Spiegel (S1) und einen zweiten Spiegel (S2), wobei das Projektionsobjektiv eine negative Schnittweite der Eintrittspupille aufweist, und ein Hauptstrahl (CR, CRP) der von einem zentralen Punkt des Objektfeldes ausgeht und das Objektiv von der Objektebene zur Bildebene durchläuft die optische Achse (HA) in mindestens einem Schnittpunkt (CROSS) schneidet, wobei sämtliche Schnittpunkte (CROSS, CROSS1, CROSS2) geometrisch zwischen der Bildebene (21, 102,302, 2102) und der gespiegelten Eintrittspupillenebene (103) liegen

FIG. 2a

6M-System 4x NA=0.25 F=2mm

EP 1 840 622 A2

## Beschreibung

## Gebiet der Erfindung

Die Erfindung betrifft ein Projektionsobjektiv und eine Projektionsbelichtungsanlage.

## Beschreibung des Standes der Technik

Aus der US 2005/0088760 ist ein Beleuchtungssystem bekannt geworden, bei dem die von einem reflektiven Objekt in einer Objektebene reflektierten Strahlen divergent in das Projektionsobjektiv hineinlaufen, was für den Fall eines axialsymmetrischen Projektionsobjektives, welches eine optische Achse umfasst, bedeutet, dass das Projektionsobjektiv eine negative Schnittweite der Eintrittspupille aufweist. Für axialsymmetrische Systeme bedeutet das, dass am reflektiven Objekt in der Objektebene ein positiver Hauptstrahlwinkel $\gamma$ vorliegt. Der positive Haupstrahlwinkel $\gamma$ beträgt bei dem in der US 2005/0088760 gezeigten Ausführungsbeispielen weniger als 7°, bevorzugt weniger als 6°.

Bei einer negativen Schnittweite der Eintrittspupille wird durch Spiegelung an der Objektebene eine gespiegelte Eintrittspupille in einer gespiegelten Eintrittspupillenebene erhalten. Die gespiegelte Eintrittspupillenebene liegt dann bildseitig von der Objektebene.

Eine positive Schnittweite liegt vor, wenn der Hauptstrahlwinkel $\gamma$ in der Objektebene negativ ist, d. h. der Hauptstrahl des zentralen Feldpunktes weist nach der Reflektion an einem reflektiven Objekt in der Objektebene bspw. am reflektiven Retikel zur optischen Achse des Projektionsobjektives hin. Bei einer positiven Schnittweite der Eintrittspupille liegt die Eintrittspupille des Projektionsobjektives bildseitig von der Objektebene und entsprechend die gespiegelte Eintrittspupillenebene auf der gegenüberliegenden Seite der Objektebene.

Die Schnittweite ist durch den Abstand der Objektebene zum Schnittpunkt des Haupstrahles, welcher zum zentralen Feldpunkt des in der Objektebene ausgeleuchteten Feldes läuft, mit der optischen Achse gegeben. Bei einem positiven Hauptstrahlwinkel von bspw. $\gamma$=8° am Objekt bzw. Retikel und einen Feldradius r=125 mm ist z.B. die Schnittweite $S_{EP}$ gegeben durch $S_{EP}$=-R/tan$\gamma$ = - 889,4 mm. Der Hauptstrahlwinkel $\gamma$ am Objekt ist bei Systemen mit negativer Schnittweite der Eintrittspupille positiv.

## Zusammenfassung der Erfindung

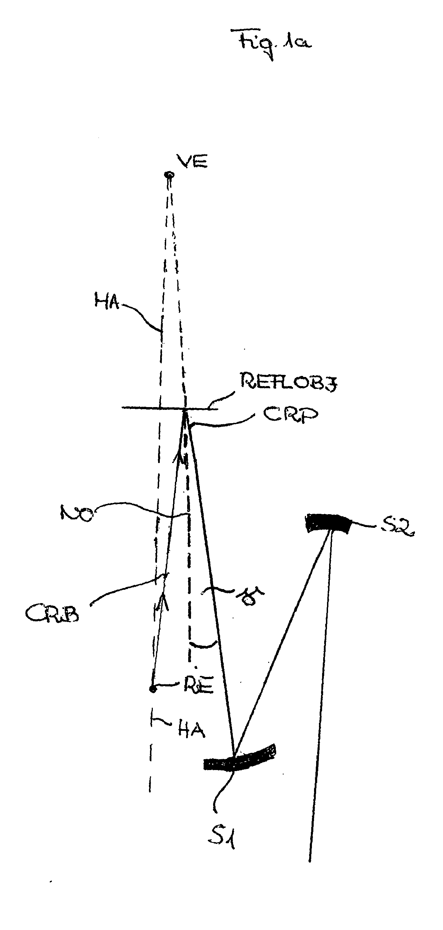

Gemäß einem ersten Aspekt der Erfindung wird in einer ersten Ausgestaltung ein Mikrolithographie-Projektionsobjektiv mit einer negativen Schnittweite der Eintrittspupille, zur Verfügung gestellt, das wenigstens zwei Spiegel, nämlich einen ersten Spiegel (S1) und einen zweiten Spiegel (S2) umfasst, wobei das Objektiv derart aufgebaut ist, dass ein Hauptstrahl CR, der von einem zentralen Punkt des Objektfeldes ausgeht und das Objektiv von der Objektebene zur Bildebene durchläuft, die optische Achse (HA) mindestens einmal in jeweils einem Schnittpunkt schneidet, wobei die jeweiligen Schnittpunkte geometrisch zwischen der Bildebene des Projektionsobjektives und der gespiegelten Eintrittspupillenebene der gespiegelten Eintrittspupille des Projektionsobjektives liegen. Die Begriffe Eintrittspupille und gespiegelte Eintrittspupille sind in Fig.1a näher erläutert.

Gemäß dem ersten Aspekt der Erfindung liegen alle Schnittpunkte der Hauptstrahlen mit der optischen Achse des Projektionsobjektives zwischen der gespiegelten Eintrittspupillenebene und der Bildebene des Projektionsobjektives

In einer vorteilhaften Ausgestaltung können die Spiegel rotationssymmetrisch um die optische Achse HA angeordnet sein.

In einer vorteilhaften Ausgestaltung der Erfindung weist der mindestens eine Schnittpunkt entlang der optischen Achse einen ersten Abstand A1 zur Objektebene auf und die gespiegelte Eintrittspupille einen zweiten Abstand A2 zur Objektebene wobei für die Abstände zueinander gilt, dass A2 stets kleiner als A1 ist, d. h. A2 bevorzugt A2 < 0,9 • A1; ganz bevorzugt A2 < 0,8 • A1; insbesondere bevorzugt A2 < 0,70 • A1; insbesondere ganz bevorzugt A2 < 0,5 • A1 ist.

Ein derartiges Objektiv wie oben beschrieben verfügt im Bereich der gespiegelten Eintrittspupille über ausreichend Bauraum, so dass dort beispielsweise ein optisches Element angeordnet werden kann.

Insbesondere ermöglicht ein derartiges Projektionsobjektiv mit einer negativen Schnittweite der Eintrittspupille bei Verwendung in einer Projektionsbelichtungsanlage einen modularen Aufbau. Projektionsbelichtungsanlagen bestehen im Allgemeinen aus einem Beleuchtungssystem und einem Projektionsobjektiv. Mit dem Beleuchtungssystem wird in einer Objektebene ein Feld ausgeleuchtet, und mit dem Projektionsobjektiv ein in der Objektebene angeordnetes Objekt in eine Bildebene abgebildet. Bei modular aufgebauten Projektionsbelichtungsanlagen ist der Strahlengang so gewählt, dass die Elemente des Beleuchtungssystems in einem ersten Bauraum angeordnet sind und die Elemente des Projektionsobjektives in einem zweiten Bauraum. Das Beleuchtungssystem bildet somit ein erstes Modul und das Projektionsobjektiv ein zweites Modul. Die beiden Module können voneinander getrennt werden, ohne dass das andere Modul beeinflusst wird. Sind bspw. Wartungs- oder Justagearbeiten am Beleuchtungssystem erforderlich, so kann bspw. das Beleuchtungssystem getauscht werden, ohne dass das Projektionssystem hiervon betroffen ist.

Des Weiteren zeichnet sich eine derartige Projektionsbelichtungsanlage durch eine erhöhte Transmission aus, da bei einer negativen Schnittweite der Eintrittspupille im Beleuchtungssystem Spiegel eingespart werden können, wie in der US 2005/008760 beschrieben.

Ein optisches Element, wie bspw. ein Pupillenfacettenspiegel eines doppelt facettierten Beleuchtungssystems kann bei den Systemen gemäß der Erfindung mit negativer Schnittweite im Bereich der optischen Achse des Projektionsobjektives angeordnet werden, da dieser Bauraum von den Spiegeln des Projektionsobjektives nicht benötigt wird, und auch keine Strahlen des Abbildungsstrahlenganges den Bauraum für einen solchen Facettenspiegel durchkreuzen.

In einer weiteren, besonders vorteilhaften Ausgestaltung der Erfindung ist das Projektionssystem derart aufgebaut, dass ein grazing-incidence-Spiegel, der zur Faltung des Strahlengangs im Beleuchtungssystem vor der Objektebene eingebracht wird, vermieden wird. Auch diese Maßnahme dient dazu, die Transmission einer Mikrolithographie-Projektionsbelichtungsanlage, in der ein derartiges Objektiv verwendet wird, zu erhöhen.

In einer bevorzugten Ausführungsform der Erfindung umfasst das Projektionsobjektiv wenigstens vier Spiegel, in einer besonders bevorzugten Ausführungsform wenigstens sechs Spiegel.

In einer bevorzugten Ausführungsform der Erfindung wird in dem Projektionsobjektiv nur eine Blendenebene ausgebildet. Bevorzugt ist das Objektiv in ein erstes und ein zweites Subobjektiv mit einer ersten und einer zweiten Anzahl von Spiegel geteilt, wobei das zweite Subobjektiv die Blendenebene enthält. Bevorzugt umfasst das zweite Subobjektiv zwei Spiegel, nämlich in einer Ausführungsform, die insgesamt sechs Spiegel umfasst, den fünften und den sechsten Spiegel, wohingegen das erste Subobjektiv den ersten, den zweiten, den dritten und den vierten Spiegel umfasst.

Bevorzugt ist die bildseitige numerische Apertur des Projektionsobjektives mit negativer Schnittweite der Eintrittspupille gemäß der Erfindung NA ≥ 0,2; bevorzugt NA ≥ 0,25; ganz besonders bevorzugt NA ≥ 0,3.

In einer Ausgestaltung des Projektionsobjektives ist die Spiegelfläche des ersten Spiegels als konvexe Spiegelfläche, die Spiegelfläche des zweiten Spiegels als konkave Spiegelfläche, die Spiegelfläche des dritten Spiegels als konkave Spiegelfläche, die Spiegelfläche des vierten Spiegels als konvexe Spiegelfläche, die Spiegelfläche des fünften Spiegels als konvexe Spiegelfläche und die Spiegelfläche des sechsten Spiegels als konkave Spiegelfläche ausgebildet.

Um möglichst große Driftstrecken innerhalb des Objektives zur Verfügung zu stellen, ist vorgesehen, dass eine Ausführungsform des Projektionsobjektives, die wenigstens sechs Spiegel oder genau sechs Spiegel umfasst, in ein erstes Teilobjektiv mit einem ersten und einem zweiten Spiegel und ein zweites Teilobjektiv mit einem dritten, vierten, fünften und sechsten Spiegel unterteilt ist, wobei das erste Teilobjektiv zum zweiten Teilobjektiv entlang der optischen Achse einen geometrischen Abstand zueinander aufweisen, der größer als 30 %, bevorzugt größer als 40 %, ganz bevorzugt größer als 50 %, insbesondere größer als 60 % der Baulänge des Objektives ist. Unter Baulänge des Objektivs wird der Abstand von der Objektebene des Projektionsobjektives bis zur Bildebene entlang der optischen Achse verstanden.

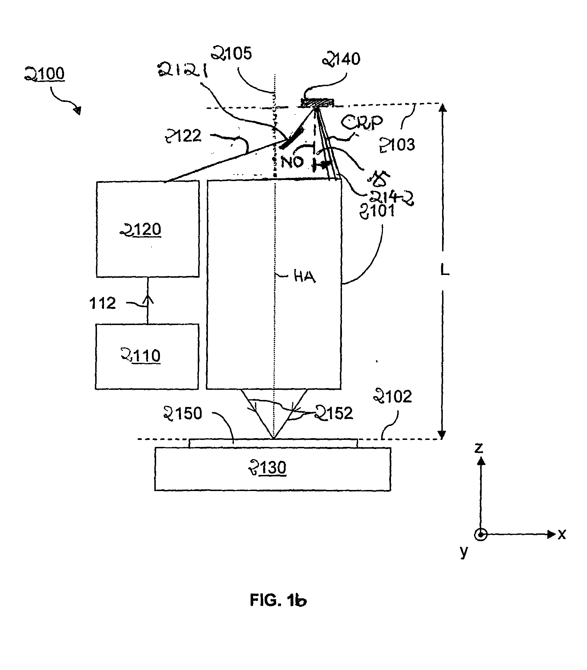

In einer weiteren bevorzugten Ausgestaltung der Erfindung ist vorgesehen, dass bei einem Projektionsobjektiv mit negativer Schnittweite der Eintrittspupille ein, auf den ersten Spiegel des Projektionsobjektives einfallender Hauptstrahl (CRE) in der Meridionalebene des Projektionsobjektives zwischen dem an der Spiegeloberfläche reflektierten Hauptstrahl (CRR) und der optischen Achse (HA) des Projektionsobjektives verläuft. Dies ist in Figur 1 h gezeigt. Hierbei sind sowohl der einfallende Hauptstrahl (CRE), wie der reflektierte Hauptstrahl (CRR) demselben Feldpunkt, beispielsweise dem zentralen Feldpunkt zugeordnet.

Durch den Verlauf des auf den ersten Spiegel von der Objektebene her einfallenden Hauptstrahles (CRE) in der Meridionalebene des Objektives zwischen dem an der Spiegeloberfläche reflektierten Hauptstrahl (CRR) und der optischen Achse (HA) des Projektionsobjektives wird erreicht, dass insbesondere im vorderen Objektivteil ausreichend Bauraum zum Einbringen eines optischen Elementes z.B. des Pupillenfacettenspiegel des Beleuchtungssystem oder aber eines grazing-incidence Spiegels vorhanden ist.

In einer alternativen Ausgestaltung des Projektionsobjektives kann vorgesehen sein, dass im Lichtweg von der Objektebene zur Bildebene wenigstens ein Zwischenbild ausgebildet wird.

In einer alternativen Ausgestaltung eines Projektionsobjektives mit negativer Schnittweite der Eintrittspupille ist das Objektiv derart aufgebaut, dass in einer Meridionalebene des Projektionsobjektives der Lichtweg von der Objektebene zum ersten Spiegel (S1) sich mit dem Lichtweg vom zweiten Spiegel (S2) zur Bildebene überkreuzt und zwischen Objektebene und erstem Spiegel (S1) kein weiterer Spiegel eingebracht ist.

Als Meridionalebene wird in vorliegender Anmeldung die Ebene verstanden, die die optische Achse (HA) des Projektionsobjektives und den zentralen Feldpunkt des Feldes in der Objektebene umfasst. Bevorzugt überkreuzt sich der Lichtweg im Projektionsobjektiv in dem Objektivteil, der am nächsten zur Objektebene liegt. Dieser Teil des Projektionsobjektives umfasst diejenigen Spiegel, die einen geringen Abstand zu der Objektebene aufweisen, in der das Retikel angeordnet ist. Ganz bevorzugt kreuzt sich das Strahlbüschel, das vom Objekt zum ersten Spiegel läuft, mit dem Strahlbüschel, das vom zweiten zum dritten Spiegel läuft. Dadurch ist es möglich, dass insbesondere der zweite Spiegel mit einem großen Abstand zur optischen Achse angeordnet werden kann. Die Aperturblende ist bevorzugt zwischen dem zweiten und dritten Spiegel angeordnet und hat ebenso wie der dritte Spiegel einen großen axialen Abstand zur Objektebene.

Bevorzugt kann ein derartiges Projektionsobjektiv wenigstens vier Spiegel, ganz besonders bevorzugt wenigstens sechs Spiegel umfassen.

Bei den erfindungsgemäßen Projektionsobjektiven mit negativer Schnittweite der Eintrittspupille ist es möglich, aufgrund des großen Abstandes von erstem und zweitem Spiegel zur optischen Achse in oder in der Nähe des Schnittpunktes der optischen Achse mit dem Hauptstrahl (CR) zum zentralen Feldpunktes, ein optisches Element bspw. einen optischen Integrator anzuordnen.

Im Gegensatz zu dem aus der US 2005/0088760 bekannten System mit negativer Schnittweite ist es bei den erfindungsgemäßen Ausführungsformen von Projektionsobjektiven nicht mehr notwendig, einen Spiegel vor der Objektebene zur Faltung des Strahlenganges anzuordnen. Hierdurch wird die Transmission des Systems deutlich erhöht. Des Weiteren wird bei Verwendung eines derartigen Projektionsobjektives in einer Projektionsbelichtungsanlage eine Kreuzung zwischen den Strahlengängen im Beleuchtungssystem und im Projektionssystem vermieden, so dass die Projektionsbelichtungsanlage räumlich und konstruktionstechnisch modular aufgebaut werden kann.

In einer besonders bevorzugten Ausgestaltung wird bei einem Projektionsobjektiv mit einem Zwischenbild das Zwischenbild bevorzugt zwischen dem vierten und dem fünften Spiegel des Objektivs, wenn das Objektiv sechs Spiegel umfasst, ausgebildet.

In einem weiteren Aspekt der Erfindung umfasst das Projektionsobjektiv eine Eintrittspupille, eine Objektebene, in der ein Objektfeld ausgebildet wird, eine Bildebene sowie einen Lichtweg von der Objektebene zur Bildebene . Gemäß dem weiteren Aspekt der Erfindung weist das Objektiv mindestens fünf Spiegel auf und eine negative Schnittweite der Eintrittspupille. Des weiteren ist das Objektiv derart aufgebaut, dass kein Zwischenbild im Lichtweg von der Objektebene zur Bildebene ausgebildet wird. Hierdurch können die Brechkräfte der einzelnen Spiegel klein gehalten werden. Dies bedingt geringe Aberrationen der einzelnen Spiegel.

In einer bevorzugten Ausführungsform des Projektionsobjektives ohne Zwischenbild wird in oder nahe einer Pupillenebene eine Blende angeordnet. Bevorzugt bildet eine erste Anzahl von Spiegeln, die im Lichtweg von der Objektebene zur Bildebene vor der Blendenebene liegen, ein erstes Subobjektiv aus und eine zweite Anzahl von Spiegeln ein zweites Subobjektiv, wobei das zweite Subobjektiv die Blende umfasst.

In einer besonderen Ausgestaltung umfasst das zweite Subobjektiv zwei Spiegel, nämlich bevorzugt den fünften und den sechsten Spiegel, falls das System insgesamt sechs Spiegel, nämlich einen ersten Spiegel, einen zweiten Spiegel, einen dritten Spiegel, einen vierten Spiegel, einen fünften Spiegel und einen sechsten Spiegel aufweist.

In einer besonderen Ausgestaltung umfasst ein System mit insgesamt sechs Spiegeln - einem ersten Spiegel, einem zweiten Spiegel, einem dritten Spiegel, einem vierten Spiegel, einem fünften Spiegel und einem sechsten Spiegel - bilden der erste und der zweite Spiegel ein erstes Teilsystem, sowie der dritte, der vierte, der fünfte und der sechste Spiegel ein zweites Teilsystem, wobei in einer besonders bevorzugten Ausführungsform ein geometrischer Abstand vom ersten Teilsystem zum zweiten Teilsystem entlang der optischen Achse HA größer als 30 %; bevorzugt größer als 40 %; ganz bevorzugt größer als 50 %; insbesondere größer als 60 % der Baulänge des Objektives ist.

In einem weiteren Aspekt der Erfindung umfasst das Projektionsobjektiv eine Eintrittspupille; eine Objektebene, in der ein Objektfeld ausgebildet wird; eine Bildebene sowie ein Lichtweg von der Objektebene zur Bildebene; eine nicht obskurierte Austrittspupille; wenigstens einen ersten Spiegel und einen zweiten Spiegel. Das Projektionsobjektiv weist eine negative Schnittweite der Eintrittspupille auf und ist derart aufgebaut, dass in einer Meridionalebene des Projektionsobjektives sich der Lichtweg von der Objektebene zum ersten Spiegel mit dem Lichtweg vom zweiten Spiegel zur Bildebene überkreuzt und zwischen Objektebene und erstem Spiegel kein weiterer Spiegel abgeordnet ist. Durch den überkreuzten Strahlengang bzw. Lichtweg können die Winkel auf den ersten beiden Spiegeln gering gehalten werden.

In einer ersten Ausgestaltung der Erfindung weist das Projektionsobjektiv nach dem weiteren Gedanken der Erfindung wie oben wenigstens vier Spiegel, einen ersten Spiegel (S1), einen zweiten Spiegel (S2), einen dritten Spiegel (S3) und einen vierten Spiegel (S4) auf.

In einer weiteren Ausgestaltung weist das Projektionsobjektiv nach dem weiteren Gedanken der Erfindung wenigstens sechs Spiegel, einen ersten Spiegel (S1), einen zweiten Spiegel (S2), einen dritten Spiegel (S3), einen vierten Spiegel (S4), einen fünften Spiegel (S5) sowie einen sechsten Spiegel (S6) auf.

Bei dem Objektiv gemäß dem weiteren Gedanken der Erfindung kreuzt in der Meridionalebene der Lichtweg vom Objekt zum ersten Spiegel den Lichtweg vom zweiten zum dritten Spiegel.

Bei dem Projektionsobjektiv gemäß dem weiteren Gedanken der Erfindung kann auch im Lichtweg von der Objektebene zur Bildebene ein Zwischenbild ausgebildet werden. Bevorzugt wird das Zwischenbild zwischen dem vierten und dem fünften Spiegel ausgebildet. Bei dem Projektionsobjektiv gemäß dem weiteren Aspekt der Erfindung ist bevorzugt der erste Spiegel konkav, der zweite Spiegel konkav, der dritte Spiegel konvex, der vierte Spiegel konkav, der fünfte Spiegel konvex und der sechste Spiegel konkav ausgebildet.

In einer ersten Ausgestaltung gemäß dem weiteren Aspekt der Erfindung ist eine Blende zwischen dem zweiten und dem dritten Spiegel angeordnet. Alternativ hierzu kann vorgesehen sein, dass eine Blende (B) auf dem dritten Spiegel (S3) angeordnet ist.

In einer weitergebildeten Ausführungsform weist das Projektionsobjektiv gemäß dem weiteren Aspekt der Ertfindung eine bildseitige numerische Apertur NA $\geq$ 0,2; bevorzugt $\geq$ 0,25; ganz bevorzugt $\geq$ 0,3 auf.

Bei allen Ausführungsformen ist es bevorzugt, wenn die Spiegel des Projektionsobjektives rotationssymmetrisch um eine optische Achse (HA) angeordnet sind.

Ist das Projektionsobjektiv mit negativer Schnittweite gemäß der Erfindung als Objektiv, das sechs Spiegel umfasst, ausgebildet, so ist in einer bevorzugten Ausführungsform die Spiegelfläche des ersten Spiegels konkav, die Spiegelfläche des zweiten Spiegels konkav, die Spiegelfläche des dritten Spiegels konvex, die Spiegelfläche des vierten Spiegels konkav, die Spiegelfläche des fünften Spiegels konvex und die Spiegelfläche des sechsten Spiegels konkav ausgebildet.

Bevorzugt ist die Aperturblende zwischen dem zweiten und dem dritten Spiegel angeordnet. Die bildseitige numerische Apertur NA des Projektionsobjektives beträgt bevorzugt mehr als 0,2; bevorzugt mehr als 0,25; ganz besonders bevorzugt mehr als 0,3.

In einer bevorzugten Ausführungsform gemäß einem weiteren Aspekt der Erfindung ist das erfindungsgemäße Objektiv ein katoptrisches Projektionsobjektiv mit negativer Schnittweite der Eintrittspupille, einem bildseitigen Wellenfrontfehler $W_{RMS}$ von weniger als 0,01 λ und einem maximalen Einfallswinkel auf jedem Spiegel kleiner als 21 °. Bevorzugt ist der bildseitige Wellenfrontfehler $W_{RMS} \leq 0,07$ λ, insbesondere $\leq 0,06$ λ. Der maximale Einfallswinkel in der Meridionalebene auf jeden Spiegel ist bevorzugt $\leq 20°$. λ beschreibt hierbei die Wellenlänge, die das Projektionsobjektiv von der Objektebene zur Bildebene in einem Abbildungsstrahlengang durchläuft. Hierdurch wird ein für Lithographiezwecke besonders geeignetes Projektionsobjektiv zur Verfügung gestellt, dass sich durch niedrige Abbildungsfehler und geringe Reflexionsverluste and den Vielfachschichtsystemen der einzelnen Spiegel auszeichnet.

Bevorzugt ist das Projektionsobjektiv derart aufgebaut, dass der bildseitige Wellenfrontfehler $W_{RMS} \leq 0,007$ λ, insbesondere $\leq 0,006$ λ ist.

In einer weitergebildeten Ausführungsform der Erfindung ist das Projektionsobjektiv so aufgebaut, daß der maximale Einfallswinkel in der Meridionalebene $\Theta_{max(max)} \leq 19,5°$ ist.

Bevorzugt Projektionsobjektiv beträgt bei einem Projektionsobjektiv gemäß einem weiteren Aspekt der Erfindung die bildseitige numerische Apertur NA $\geq$ 0,25; insbesondere NA $\geq$ 0,30.

Bei einem Projektionsobjektiv gemäß einem weiteren Aspekt der Erfindung umfasst das Projektionsobjektiv wenigstens vier Spiegel, wobei der in einem Lichtweg von der Objektebene zur Bildebene erste Spiegel (S1) und der vierte Spiegel (S4) je ein Konvexspiegel sind.

In einer weitergebildeten Ausführungsform gemäß einem weiteren Aspekt der Erfindung weisen die Spiegel eine Dimension ($M_y$) in der Meridionalebene auf und die maximale Dimension ($M_y$) aller Spiegel in der Meridionalebene ist kleiner 190 mm, bevorzugt kleiner 180 mm.

Die Projektionsobjektive gemäß der Erfindung ist in einer ersten Ausgestaltung ein katoptrisches Projektionsobjektiv ist.

Alternativ kann das Projektionsobjektiv aber auch ein katadioptrisches Projektionsobjektiv sein.

In einem weiteren Aspekt der Erfindung ist das Projektionsobjektiv aufgebaut, um Strahlung von einer Objektebene in eine Bildebene zu leiten umfassend wenigstens vier Spiegel, wobei das Projektionsobjektiv ein katoptrisches Projektionsobjektiv ist und eine negative Schnittweite der Eintrittspupille aufweist,

wobei der in einem Lichtweg von der Objektebene zur Bildebene erste Spiegel und vierte Spiegel ein Konvexspiegel ist. Hierdurch kann die Bildfeldkrümmung , die durch die Konkavspiegel erzeugt wird kompensiert werden, ohne, dass eine einzelner Konvexspiegel mit einer zu starken Krümmung ausgebildet werden muß. Bevorzugt sind bei einem 4-Spiegel-System zwei Konvexspiegel eingesetzt; bei einem 6-Spiegel-Objektiv drei Konvexspiegel eingesetzt.

Bevorzugt wird bei einem Projektionsobjektiv gemäß einem weiteren Aspekt der Erfindung in dem Lichtweg von der Objektebene zur Bildebene kein Zwischenbild ausgebildet.

Das Projektionsobjektiv gemäß dem weiteren Aspekt der Erfindung weist eine bildseitige numerische Apertur NA $\geq$ 0,25; insbesondere $\geq$ 0,30 auf.

In einem weiteren Aspekt der Erfindung ist das Projektionsobjektiv aufgebaut, um Strahlung von einer Objektebene in eine Bildebene zu leiten und umfasst eine Vielzahl von Spiegeln, wobei die Spiegel je eine Dimension ($M_y$) in der Meridionalebene aufweisen und die maximale Dimension ($M_y$) aller Spiegel in der Meridionalebene kleiner 190 mm, bevorzugt kleiner 180 mm ist. Hierdurch wird ein Projektionsobjektiv zur Verfügung gestellt, dass sich besonders einfach fertigen lässt, insbesondere können Beschichtungskammern mit geringen Abmessungen eingesetzt werden.

Bei einem Projektionsobjektiv gemäß einem weiteren Aspekt der Erfindung ist der maximale Einfallswinkel $\Theta_{max(max)}$ aller auf einen Spiegel einfallenden Strahlen auf jedem Spiegel < 25°, insbesondere $\leq$ 21 °, bevorzugt $\leq$ 20°.

Das Projektionsobjektiv gemäß dem weiteren Aspekt der Erfindung weist einen ersten Spiegel (S1), einen zweiten Spiegel (S2), einen dritten Spiegel (S3), einen vierten Spiegel (S4), einen fünften Spiegel (S5) sowie einen sechsten Spiegel (S6) auf.

Bevorzugt sind die Projektionsobjektiv derart aufgebaut, um Strahlung von einer Objektebene in eine Bildebene mit einer Wellenlänge λ zu leiten, wobei λ $\leq$ 193 nm, bevorzugt λ $\leq$ 100 nm, insbesondere bevorzugt im Bereich von 1 nm < λ $\leq$ 30 nm liegt.

In einer bevorzugten Ausführungsform umfasst das Projektionsobjektiv wenigstens vier Spiegel, wobei der in einem Lichtweg von der Objektebene zur Bildebene erste und vierte Spiegel jeweils ein Konvexspiegel ist.

Besonders bevorzugt ist der maximal Spiegeldurchmesser aller Spiegel in der Meridionalebene < 190 mm, bevorzugt < 180 mm.

Sämtliche zuvor genannten Einzelmaßnahmen, wie z. B. Größe der Apertur, Anzahl der Spiegel eines Objektives, Einfallswinkel, Spiegeldurchmesser usw. können beliebig für alle dargestellten Ausführungsformen kombiniert werden, ohne dass vom Gegenstand der Erfindung abgewichen wird. Diese Kombinationen sind vom Offenbarungsgehalt der Erfindung mit eingeschlossen.

Neben dem Mikrolithographie-Projektionsobjektiv, stellt die Erfindung auch eine Mikrolithographie-Projektionsbelichtungsanlage zur Verfügung. Die erfindungsgemäße Mikrolithographie-Projektionsbelichtungsanlage umfasst ein Beleuchtungssystem, das von einem Beleuchtungsstrahlbüschel durchlaufen wird, eine Objektebene, in der ein Objektfeld ausgeleuchtet wird, ein Projektionsobjektiv, wobei das Projektionsobjektiv von einem Abbildungsstrahlengang von der Objektebene zur Bildebene durchlaufen wird, und wobei das Projektionsobjektiv eine Eintrittspupille mit negativer Schnittweite aufweist. Die Mikrolithographie-Projektionsbelichtungsanlage ist derart aufgebaut, dass das Beleuchtungsstrahlbüschel, das von einer in einem Lichtweg vorletzten optischen Komponente des Beleuchtungssystems bis zur Objektebene verläuft, sich mit dem Abbildungsstrahlengang bis auf den Bereich am reflektiven Objekt, d.h. am Retikel, nicht in einer Meridionalebene überkreuzt.

Bei einer Projektionsbelichtungsanlage mit negativer Schnittweite der Eintrittspupille ist es möglich, ein optisches Element bspw. Teile des optischen Integrators, bspw. das zweite facettierte optische Element, den sog. Pupillenfacettenspiegel im Bereich der der gespiegelten Eintrittspupille. Hierdurch kann das abbildende optische Element zur Abbildung des zweiten facettierten optischen Elementes entfallen.

Hierdurch ist es möglich, Mikrolithographie-Projektionsanlagen anzugeben, die gemäß der Erfindung derart aufgebaut sind, dass die Transmission gegenüber den aus dem Stand der Technik bekannten Mikrolithographie-Projektionsbelichtungsanlagen mit positiver Schnittweite erhöht ist. Unter Transmission wird der Anteil des Lichtes verstanden, der von der Lichtquelle emittiert wird, die Mikrolithographie-Projektionsbelichtungsanlage durchläuft, und in der Bildebene, in der das zu belichtende Objekt angeordnet ist, auftrifft. Für die Transmission ist die Anzahl der Spiegel in einer Mikrolithographie-Projektionsbelichtungsanlage von besonderer Bedeutung, da bei EUV-Wellenlängen die Reflektivität der Multilayer-Spiegel in etwa maximale 70% beträgt. Sind in einer ersten Ausgestaltung einer Mikrolithographie-Projektionsbelichtungsanlage zwei Spiegel mehr als in einer zweiten Ausgestaltung einer Mikrolithographie-Projektionsbelichtungsanlage angeordnet, so ist durch die zwei zusätzlichen Spiegel die Transmission der ersten Ausgestaltung einer Mikrolithographie-Projektionsbelichtungsanlage in etwa um einen Faktor 2 gegenüber der zweiten Ausgestaltung verringert, da die Reflektivität eines solchen Spiegels ca. 70% beträgt.

Da sich die Strahlengänge von Beleuchtungs- und Abbildungsstrahlengang nicht mehr kreuzen, kann durch den erfindungsgemäßen Aufbau das System modular aufgebaut sein, d. h. das Beleuchtungssystem kann vom Projektionsobjektiv räumlich und konstruktionstechnisch getrennt werden. Dies wird dadurch erreicht, dass die Elemente des Beleuchtungssystems in einem ersten Bauraum angeordnet sind und die Elemente des Projektionsobjektives in einem zweiten Bauraum. Bei derartigen Mikrolithographie-Projektionsbelichtungsanlagen kann das Beleuchtungssystem sehr einfach vom Projektionsobjektiv getrennt werden.

In einer ersten Ausgestaltung der Erfindung wird das Projektionsobjektiv derart ausgelegt, dass es im Strahlengang von der Objektebene zur Bildebene kein Zwischenbild aufweist. In einer alternativen Ausführungsform weißt das Objektiv eine Strahlkreuzung in dem Objektivteil auf, der der Objektebene am nächsten liegt, d. h. einen geringen geometrischen Abstand zur Objektebene besitzt.

Das Beleuchtungssystem einer Mikrolithographie-Projektionsbelichtungsanlage, die ein Objektiv mit negativer Schnittweite der Eintrittspupille umfasst, kann unterschiedlich ausgebildet sein.

So kann in einer ersten Ausführungsform vorgesehen sein, dass das Beleuchtungssystem ein doppelt facettiertes Beleuchtungssystem ist.

Ein doppelt facettiertes Beleuchtungssystem zeichnet sich durch einen ersten facettierten Spiegel mit einer Vielzahl von ersten Facetten, sog. Feldfacetten aus sowie einem zweiten facettierten Spiegel mit einer Vielzahl von zweiten Facetten sog. Pupillenfacetten. Bei einem derartigen System ist wie zuvor beschrieben in oder nahe der gespiegelten Eintrittspupille des Projektionsobjektivs das zweite facettierte Element mit Pupillenfacetten angeordnet. Der Pupillenfacettenspiegel kann in einer bevorzugten Ausführungsform etwa 200 bis 300 Pupillenfacetten umfassen, die optional schaltbar ausgelegt sein können, so dass die Zuordnung der ersten Facetten zu den zweiten Facetten verändert werden kann. Eine Änderung der Zuordnung von ersten zu zweiten Facetten zur Einstellung des Settings kann in einem doppelt facettierten Beleuchtungssystem beispielsweise durch den Tausch des ersten facettierten optischen Elementes mit Feldfacetten erreicht werden. Bei Systemen, die für eine Wellenlänge ≤ 193 nm, insbesondere für Wellenlängen ≤ 100 nm, bevorzugt im EUV-Wellenlängenbereich von 10 bis 30 nm ausgelegt sind, sind die Facetten reflektiv, d. h. als Spiegel ausgelegt.

Anstelle eines doppelt facettierten Beleuchtungssystems kann auch ein Beleuchtungssystem vorgesehen sein, bei dem im oder nahe der gespiegelten Eintrittspupille des Projektionsobjektiv ein Diffusor, angeordnet ist. Beispielsweise kann ein derartiger Diffusor eine Vielzahl von Streuzentren aufweisen. Diese Streuzentren können bspw. 500 bis 1000 oder mehr kleine Spiegelfacetten sein, die auf einem Träger angeordnet sind, oder ein holographisches Gitter. Licht, das auf diesen Diffusor trifft, wird durch die Streuzentren in alle Richtungen gestreut.

Durch die Anordnung der Streuzentren - vorwiegend in einer runden oder leicht ovalen Form - wird eine Lichtquelle erzeugt, die das von der Lichtquelle auftreffende Licht in der vorbestimmten Form, also einer bogenförmigen Form, in große Raumwinkelelemente streut.

Der Vorteil einer derartigen Ausgestaltung mit einer Diffusorplatte liegt darin, dass im Gegensatz zu einem doppelt facettierten Beleuchtungssystem ein optisches Element weniger zur Ausleuchtung des Feldes in der Objektebene und zur Ausleuchtung einer Pupillenebene eingesetzt werden muss. Damit wird gegenüber dem doppelt facettierten Beleuchtungssystem die Transmission erhöht.

Zur Einstellung des Beleuchtungssettings in einer Pupillenebene kann vorgesehen sein, dass eine Blende im Lichtweg vor oder nach dem Diffusor eingebracht wird.

Eine ganz besonders vorteilhafte Ausführungsform eines Beleuchtungssystems besteht darin, einen ortsvarianten Diffusor bzw. optischen Integrator zur Beleuchtung sowohl der Feldebene wie auch einer Pupillenebene vorzusehen, der bevorzugt außerhalb, d. h. nicht in der Nähe einer Pupillenebene oder einer konjugierten Pupillenebene, angeordnet ist. Ein derartiger Diffusor wird auch als spekularer Reflektor bezeichnet. Da der spekulare Reflektor nicht in der Pupillenebene oder einer hierzu konjugierten Ebene angeordnet werden muss, kann die Mikrolithographie-Projektionsbelichtungsanlage so ausgelegt werden, dass der Diffusor mit Bezug auf andere Systemkomponenten im Lichtweg optimal platziert wird. Bevorzugt weist er eine derartige Größe auf, dass die einzelnen Facetten mit einer hohen Winkelgenauigkeit einfach zu fertigen sind. Bevorzugt ist die Größe der Abmessungen der Spiegelfacette größer als 2 mm, besonders bevorzugt größer als 3mm und insbesondere bevorzugt größer als 5mm

Um den bevorzugt als nierenförmig auszulegenden ortsvarianten Diffusor bzw. feldabhängigen Diffusor optimal auszuleuchten, d. h. weitgehend verlustfrei, ist vorgesehen im Lichtweg von der Lichtquelle zum Diffusor vor dem Diffusor eine optische Komponente, bspw. einen normal-incidence-Spiegel voranzustellen, der bevorzugt als Freiformfläche mit einem außeraxialen konischen Anteil ausgebildet ist. Ein derartiger Spiegel ist ein Ausschnitt aus einem Konus, wobei die Konusachse nicht enthalten ist. Wird ein außeraxiales Segment eines derartigen Konus beleuchtet, so resultiert hieraus eine nicht ganz vollständige annulare Ausleuchtung, die der Nierenform des Diffusors weitgehend entspricht.

Ein weiterer Vorteil der Voranstellung eines normal-incidence-Spiegels im Lichtweg ist die Filterwirkung. Die Multilayer-Beschichtung des normal-incidence-Spiegel reflektiert im Wesentlichen nur die Strahlung der Nutzwellenlänge und bewirkt so, dass auf dem Diffusor lediglich Nutzlicht im Bereich der Wellenlänge von bspw. λ=13,5 nm für EUV-Systeme ankommt. Die Filtereinwirkung des Mulitlayer-Spiegels ist unabhängig von seiner Form.

Will man die einzelnen Facetten des Diffusors als Planspiegel auslegen, was fertigungstechnisch Vorteile hat, so kann ein optisches Element bspw. ein normal-incidence-Spiegel im Lichtweg nach dem Diffusor angeordnet werden. Der dem Diffusor nachgeordnete normal-incidence-Spiegel bildet dann die Quelle in die Objektebene, in der das auszuleuchtende Objekt angeordnet ist, stark vergrößert ab. Der ortsvariante Diffusor bzw. feldabhängige Diffusor sorgt für eine Überlagerung einer Vielzahl von Quellbildern in dieser Objektebene. Ist der normal-incidence-Spiegel zusätzlich noch mit Brechkraft versehen, so kann durch den normal-incidence-Spiegel der Abbildungsmaßstab eingestellt werden. Damit ergibt sich unabhängig von der Größe des ortsvarianten Diffusors bzw. feldabhängig stets aufgrund des eingestellten Abbildungsmaßstabs die gleiche Ausleuchtung in einer Pupillenebene.

Dies ermöglicht es den Diffusor sehr groß auszulegen. Dies hat den Vorteil, dass die Strahlenbelastung auf dem Diffusor aufgrund der großen Fläche verteilt wird und damit die Thermallast reduziert wird.

Um den ortsvarianten Diffusor nierenförmig auszuleuchten, kann anstelle des zuvor beschriebenen Spiegels mit einer Freiformfläche mit einem außeraxialen konischen Anteil vorgesehen sein, den Kollektor, der das Licht der Lichtquelle sammelt und auf den Diffusor reflektiert, nierenförmig auszugestalten. Aufgrund der geringen Anzahl von Reflektionen wird hier ein besonders effizientes Beleuchtungssystem mit einer hohen Transmission zur Verfügung gestellt. Besonders bevorzugt ist es, wenn als Kollektor der Mikrolithographie-Projektionsbelichtungsanlage ein grazing-incidence-Kollektor verwendet wird und der Strahlengang im Beleuchtungssystem kein Zwischenbild aufweist. Dies erlaubt die Anordnung des Diffusores direkt vor dem Retikel.

Gemäß einem weiteren Aspekt der Erfindung umfasst eine Projektionsbelichtungsanlage aufgebaut um Strahlung von einer Lichtquelle in eine Bildebene zu leiten, eine Vielzahl von Elementen, die derart angeordnet sind, dass die Strahlung von der Lichtquelle in die Bildebene geleitet wird, wobei die Vielzahl von Elementen Spiegel sind, wobei die Anzahl der Spiegel, die die Strahlung unter normal-incidence-Bedingungen reflektiert, maximal 10 ausschließlich eines in der Objektebene angeordneten reflektiven Objektes ist, wobei die Mikrolithographie-Projektionsbelichtungsanlage eine bildseitige numerische Apertur NA > 0,25; insbesondere > 0,26; bevorzugt ≥ 0,3 und eine maximale Dimension ($D_x$, $D_y$) eines bildseitigen Feldes von mehr als 1 mm; bevorzugt mehr als 4 mm; ganz bevorzugt mehr als 8 mm; insbesondere bevorzugt mehr als 12 mm; insbesondere bevorzugt mehr als 16 mm; ganz besonders bevorzugt mehr als 20 mm; insbesondere bevorzugt mehr als 25 mm aufweist. Durch die geringe Anzahl an Reflexionen im Gesamtsystem an nur 10 reflektierenden Flächen ausgenommen das Retikel kann ein System mit einer sehr hohen Lichttransmission und geringen Verlusten zur Verfügung gestellt werden.

**Detaillierte Beschreibung bevorzugter Ausführungsformen**

Die Erfindung soll nachfolgenden anhand der Ausführungsbeispiele beschrieben werden:

Es zeigen

Fig. 1a: Veranschaulichung der negativen Schnittweite der Eintrittspupille

Fig. 1b: schematische Ansicht einer Mikrolithographie-Projektionsbelichtungsanlage

Fig. 1c: Darstellung eines Strahlkegels zur Definition der bildseitigen numerischen Apertur

Fig. 1d: Teil einer Spiegeloberfläche im Meridionalschnitt

Fig. 1e: Ausschnitt einer Spiegeloberfläche in einer Ebene, die senkrecht auf der Meridionalebene steht

Fig. 1f: Form eines Ringfeldes

Fig. 1g: eine Mikrolithographie-Projektionsbelichtungsanlage gemäß dem Stand der Technik in Form der US 2005/088760 mit einem Projektionsobjektiv mit negativer Schnittweite der Eintrittspupille

Fig. 1h: eine Darstellung zum Verlauf des Strahlenganges im Bereich des ersten Spiegels

Fig.2a: ein erstes Ausführungsbeispiel eines erfindungsgemäßen Projektionsobjektives mit negativer Schnittweite der Eintrittspupille, wobei im Lichtweg von der Objektebene zur Bildebene kein Zwischenbild ausgebildet wird.

Fig. 2b: Tabelle 1

Fig. 3a: eine alternative Ausführungsform eines Projektionsobjektives gemäß der ersten Ausführrungsform

Fig. 3b: Tabelle 2

Fig. 4: eine Mikrolithographie-Projektionsbelichtungsanlage umfassend ein Projektionsobjektiv gemäß Fig. 2a.

Fig. 5a: eine zweite Ausführungsform eines Projektionsobjektiv mit negativer Schnittweite der Eintrittspupille, wobei sich der Strahlengang in der Meridionalebene im ersten Objektivteil schneidet.

Fig. 5b: Tabelle 3

Fig. 6a: ein erstes alternatives System eines Projektionsobjektives gemäß der zweiten Ausführrungsform

Fig. 6b: Tabelle 4

Fig. 6c: ein zweites, alternatives System eines Projektionsobjektives gemäß der zweiten Ausführrungsform.

Fig. 6d: Tabelle 5

Fig. 7: eine erste Ausführungsform einer Mikrolithographie-Projektionsbelichtungsanlage mit einem Projektionsobjektiv mit negativer Schnittweite, einem normal-incidence-Spiegel, der als schmalbandiger Wellenlängenfilter dient sowie einem ersten und einem zweiten facettierten optischen Element.

Fig. 8: eine Mikrolithographie-Projektionsbelichtungsanlage mit einem Diffusor der in der Pupillenebene oder im Lichtweg nach der Pupillenebene angeordnet ist.

Fig. 9: eine dritte Ausführungsform einer Mikrolithographie-Projektionsbelichtungsanlage

Fig. 10: eine vierte Ausführungsform einer Mikrolithographie-Projektionsbelichtungsanlage mit einem ortsvarianten Diffusor

Fig. 11: der Strahlengang von der Lichtquelle zum Diffusor, wobei dem ortsvarianten Diffusors im Lichtweg ein normal-incidence-Spiegel mit einer Freiformfläche und konischem Anteil vorangestellt ist.

Fig. 12: eine fünfte Ausführungsform einer Mikrolithographie-Projektionsbelichtungsanlage mit einem ortsvarianten Diffusor und einem Kollektorspiegel der im Lichtweg vor dem Diffusor angeordnet ist zur nierenförmigen Ausleuchtung des Diffusors.

Fig. 13: eine sechste Ausführungsform einer Mikrolithographie-Projektionsbelichtungsanlage mit einem Beleuchtungssystem ohne Zwischenbild und mit einem ortsvariantem Diffusor.

Die Erfindung soll nunmehr anhand der Zeichnungen beispielhaft ohne Beschränkungen hierauf beschrieben werden.

In den Figuren 1a bis 1h sind allgemeine Begriffe, die in sämtlichen Ausführungsbeispielen verwendet werden und sich auf sämtliche Ausführungsbeispiele beziehen, detailliert anhand der Figuren beschrieben.

In Figur 1a ist bildlich dargestellt was vorliegend unter negativer Schnittweite verstanden wird.

In Figur 1a ist der Hauptstrahl CRB eines Beleuchtungsstrahlbüschels zum zentralen Feldpunkt eines ausgeleuchteten Feldes wie bspw. in Fig. 1e dargestellt gezeigt. Der Hauptstrahl CRB des Beleuchtungsstrahlbüschels wird, wie vorliegend dargestellt, an einem reflektiven Objekt REFLOBJ bspw. einem Retikel, reflektiert und tritt als Haupstrahl CRP eines Projektionsstrahlbüschels in ein Projektionsobjektiv, von dem der erste Spiegel S1 und der zweite Spiegel S2 dargestellt sind, ein. Negative Schnittweite der Eintrittspupille bedeutet, dass der Hauptstrahlwinkel $\gamma$ am reflektiven Objekt, bspw. dem Retikel positiv ist. Der Haupstrahlwinkel $\gamma$ ist der Winkel, um den der Hauptstrahl CRP gegenüber der Normalen NO des reflektiven Objekties REFLOBJ geneigt ist. Der Winkel $\gamma$ ist für Systeme mit negativer Eintrittspupille definitionsgemäß positiv und wird gegen den Uhrzeigersinn gemessen.

Die gespiegelte Eintrittspupille RE erhält man durch Spiegelung der Eintrittspupille VE an der Objektebene, in der das reflektive Objekt REFLOBJ angeordnet ist. Bei negativer Schnittweite der Eintrittspupille VE wird die gespiegelte Eintrittspupille RE bildseitig von der Objektebene ausgebildet.

In Figur 1 b ist eine Mikrolithographie-Projektionsbelichtungsanlage 2100 gezeigt. Die Mikrolithographie-Projektionsbelichtungsanlage umfasst eine Lichtquelle 2110, ein Beleuchtungssystem 2120, ein Projektionsobjektiv 2101 sowie eine Trägerstruktur bzw. Arbeitsfläche 2130. Des Weiteren ist ein karthesisches Koordinatensystem dargestellt. Die Strahlung der Lichtquelle 2110 wird einem Beleuchtungssystem 2120 zugeführt. Das Beleuchtungssystem 2120 beeinflusst die von der Lichtquelle 2110 ausgehende Strahlung, bspw. in dem die Strahlung homogenisiert wird oder indem ein Strahlbündel 2122 der Strahlung bspw. mit Hilfe des eingezeichneten Umlenkspiegels 2121 auf eine Maske 2140, die in einer Objektebene 2103 positioniert ist, gelenkt wird. Das Projektionsobjektiv 2101 bildet die von der Maske 2140 reflektierte Strahlung auf eine Substratoberfläche 2150, die in einer Bildebene 2102 positioniert ist ab. Das Strahlbüschel 2142 auf der Objektseite weist erfindungsgemäß einen Hauptstrahl CRP mit positivem Hauptstrahlwinkel $\gamma$ auf. Des Weiteren eingezeichnet ist die Normale NO auf die Objektebene 2103 im Bereich der Maske 2140. Das Substrat 2150 wird von einer Trägerstruktur 2130 unterstützt bzw. getragen, wobei die Trägerstruktur 2130 das Substrat 2150 relativ zum Projektionsobjektiv 2101 bewegt, so dass das Projektionsobjektiv 2101 die Maske 2140 auf unterschiedliche Bereiche des Substrats 2150 abbildet.

Das Projektionsobjektiv 2101 umfasst eine optische Achse 2105. Wie in Figur 1a dargestellt bildet das Projektionsobjektiv 2101 ein Teil der Maske 2140, die nicht die optische Achse des Projektionsobjektives 2101 umfasst, in eine Bildebene 2102 ab. Die Lichtquelle 2110 wird derart ausgewählt, dass sie elektromagnetische Strahlung bei einer Betriebswellenlänge $\lambda$, mit der die Mikrolithographie-Projektionsbelichtungsanlage 2100 betrieben wird, zur Verfügung stellt. In einigen Ausführungsbeispielen ist die Lichtquelle 2110 eine Laserplasmaquelle oder eine Plasmaentladungsquelle für die Emission von EUV-Strahlung. Alternativ können auch Lichtquellen bevorzugt für andere Wellenlängen eingesetzt werden, wie bspw. Leuchtdioden (LED), die Strahlung im blauen oder UV-Bereich des elektromagnetischen Spektrums, bspw. bei 365 nm, 280 nm oder 227 nm emittieren, oder Laserlichtquellen für beispielsweise 193nm bzw. 248nm.

Dies wird insbesondere bei Systemen bevorzugt, bei denen breitbandige Lichtquellen zusammen mit Spiegelsystemen eingesetzt werden.

Die Betriebswellenlänge $\lambda$ der Mikrolithographie-Projektionsbelichtungsanlage liegt im ultraviolettem oder extremen ultravioletten (EUV)-Bereich des elektromagnetischen Spektrums. Die Betriebswellenlänge kann beispielsweise 193 nm oder weniger, ganz besonders 100 nm oder weniger, betragen. In den Ausführungsbeispielen kann beispielsweise die Betriebswellenlänge im Bereich von 193 nm, bevorzugt im Bereich von 157 nm, ganz besonders bevorzugt im EUV-Wellenlängenbereich, insbesondere im Bereich um 13 nm, liegen.

Die Verwendung von besonders kurzwelliger Strahlung ist besonders wünschenswert, da im Allgemeinen die Auflösung eines Projektionsobjektives proportional zur verwendeten Betriebswellenlänge ist. Deswegen können bei Verwendung kürzerer Wellenlängen Projektionsobjektive kleinere Strukturen eines Bildes als gleichartige Projektionsobjektive, die längere Wellenlängen benutzen, auflösen.

Das Beleuchtungssystem 2120 umfasst optische Komponenten, die einen kollimierten Strahl mit einem weitgehenden homogenen Intensitätsprofil zur Verfügung stellen. Das Beleuchtungssystem 2120 umfasst des Weiteren Optiken, um das Strahlbüschels 2122 auf die Maske 2140 zu lenken. In einer besonders bevorzugten Ausführungsform umfasst das Beleuchtungssystem 2120 des Weiteren Komponenten, die ein bestimmtes Polarisationsprofil des Strahlbüschels zur Verfügung stellen.

Die Bildebene 2103 weist zur Objektebene 2102 einen Abstand L auf, der auch als Baulänge B des Projektionsobjektives 2101 bezeichnet wird.

In den beschriebenen Ausführungsbeispielen liegt die Baulänge im Bereich von einem Meter bis ungefähr drei Meter, bevorzugt im Bereich von ungefähr 1,3 m bis 2,5 m.

In bestimmten Ausführungsbeispielen ist die Baulänge geringer als 2 m, bspw. geringer als 1,9 m, bevorzugt geringer als 1,8 m, ganz bevorzugt geringer als 1,7 m, insbesondere bevorzugt geringer als 1,6 m insbesondere bevorzugt geringer als 1,5 m.

Das Projektionsobjektiv 2101 hat einen Abbildungsfaktor, der sich auf das Verhältnis der Abmessungen des Feldes in der Objektebene 2103 zu den korrespondierenden Abmessungen des abgebildeten Feldes in der Bildebene 2102 bezieht. Typischerweise sind die Projektionsobjektive, die in Lithographieanlagen verwandt werden, Reduktions-Projektionsobjektive, d.h. dass die Abmessungen des Bildes kleiner als die des Objektes sind. In einigen Ausführungsbeispielen kann daher das Projektionsobjektiv 2101 ein Feld in der Bildebene 2102 erzeugen, dessen Dimensionen um einen Faktor 2-10, bevorzugt um einen Faktor 4 oder Faktor 5 verringert wird, verglichen mit den Dimensionen in der Objektebene 2103. Es können aber auch Projektionsobjektive entwickelt werden, die ein vergrößertes Bild oder ein Bild gleicher Größe, wie das Objekt zur Verfügung stellen.

In Figur 1 c sind die Randstrahlen 2152 des Lichtbüschels, die das Objekt in die Bildebene 2102 abbilden, dargestellt. Die Randstrahlen 2152 definieren einen Strahlkonus.

Der Winkel des Strahlenkonus steht in Beziehung zur bildseitigen numerischen Apertur (NA) des Projektionsobjektives 2101. Die bildseitige numerische Apertur kann ausdrückt werden als $NA = N_0 * \sin\Theta_{NA}$, wobei $n_0$ sich auf den Brechungsindex des Mediums bezieht, der dem Substrat 2150 benachbart ist. Dieses Medium kann bspw. Luft, Stickstoff, Wasser oder Vakuum sein. $\Theta_{NA}$ ist der Winkel, der durch die Randstrahlen des Projektionsobjektives 2101 definiert wird.

Im Allgemeinen weisen Projektionsobjektive 2101 eine relativ hohe bildseitige numerische Apertur NA auf. Bspw. beträgt die bildseitige numerische Apertur NA des Projektionsobjektives 2101 in einigen Ausführungsbeispielen mehr als 0,15; insbesondere mehr als 0,20; insbesondere mehr als 0,25. Im Allgemeinen variiert die Auflösung des Projektionsobjektives 2101 in Abhängigkeit von der Wellenlänge und der bildseitigen numerischen Apertur NA.

Die Auflösung eines Projektionsobjektives kann mit Bezug auf die Wellenlänge und auf die bildseitige numerische Apertur durch die nachfolgende Formel

$$R = k \cdot \frac{\lambda}{NA}$$

abgeschätzt werden. Hierbei bezeichnet R die minimale Auflösung des Projektionsobjektives, k ist eine dimensionslose Konstante und wird als Prozessfaktor bezeichnet. Der Prozessfaktor k variiert in Abhängigkeit von verschiedenen Faktoren, bspw. den Polarisationseigenschaften der Abbildung oder den gewählten Beleuchtungsmodi. Typischerweise liegt k im Bereich von 0,4 bis 0,8, aber es kann auch unterhalb von 0,4 und höher als 0,8 liegen, für spezielle Anwendungen.

In einigen Ausführungsbeispielen weist das Projektionsobjektiv 2101 eine relativ hohe Auflösung, d.h. der Wert von R ist relativ klein, auf. Bspw. kann R einen Wert von 150 nm oder weniger, bevorzugt 130 nm oder weniger, ganz besonders bevorzugt 100 nm oder weniger, insbesondere bevorzugt 75 nm oder weniger, ganz besonders bevorzugt 50 nm oder weniger, bevorzugt 40 nm oder weniger, insbesondere bevorzugt 35 nm oder weniger, ganz bevorzugt 32 nm oder weniger, insbesondere 30 nm oder weniger, bevorzugt 28 nm oder weniger, insbesondere 25 nm oder weniger, besonders bevorzugt 22 nm oder weniger, bevorzugt 20 nm oder weniger, insbesondere bevorzugt 18 nm oder weniger, insbesondere 17 nm oder weniger, ganz bevorzugt 16 nm oder weniger, insbesondere 15 nm oder weniger, insbesondere bevorzugt 14 nm oder weniger, ganz bevorzugt 13 nm oder weniger, insbesondere 12 nm oder weniger, bevorzugt 11 nm oder weniger, insbesondere bevorzugt 10 nm oder weniger annehmen. Die Qualität eines Bildes, das durch das Projektionsobjektiv 2001 ausgebildet wird, kann auf verschiedene Arten und Weisen quantifiziert werden.

Beispielsweise können Bilder charakterisiert bzw. quantifiziert werden, basierend auf den gemessenen oder berechneten Abweichungen des Bildes vom idealen Punktbild. Diese Abweichungen sind im Allgemeinen als Aberrationen bekannt. Ein Maß, das benutzt wird, um die Abweichung einer Wellenfront von der Ideal- oder gewünschten Form zu quantifizieren, ist der "root-mean-square"-Wellenfrontfehler, sog. RMS-Wert $W_{RMS}$. $W_{RMS}$ ist bspw. wie in "Handbook of optics", Vol. 1, 2nd, edited by Michael Bass (McGraw Hill), Inc. 1995 auf Seite 35.3 definiert. Im Allgemeinen gilt, dass je niedriger der $W_{RMS}$-Wert für ein Objektiv ist, umso weniger weicht die Wellenfront von der gewünschten oder idealen Form ab und umso besser ist die Qualität des Bildes.

In bevorzugten Ausführungsformen weist das Projektionsobjektiv 2101 sehr kleine Werte für $W_{RMS}$ des Bildes in der Bildebene 2102 auf. Bspw. kann ein Projektionsobjektiv 2101 einen $W_{RMS}$-Wert von ungefähr $0,1 \cdot \lambda$ oder weniger, insbesondere weniger als $0,07 \cdot \lambda$, besonders bevorzugt weniger als $0,06 \cdot \lambda$, insbesondere weniger als $0,05 \cdot \lambda$, bevorzugt weniger als $0,045 \cdot \lambda$, insbesondere weniger als $0,04 \cdot \lambda$, ganz besonders bevorzugt weniger als $0,035 \cdot \lambda$, insbesondere bevorzugt weniger als $0,03 \cdot \lambda$, insbesondere bevorzugt weniger als $0,025 \cdot \lambda$, besonders bevorzugt weniger als $0,02 \cdot \lambda$, insbesondere bevorzugt weniger als $0,15 \cdot \lambda$, besonders bevorzugt weniger als $0,01 \cdot \lambda$, insbesondere weniger als $0,008 \lambda$, ganz besonders bevorzugt weniger als $0,006 \lambda$ aufweisen.

Ein anderes Maß, dass dazu verwendet werden kann, die Qualität eines Bildes zu evaluieren ist die Bildfeldwölbung, die sog. field curvature. Die Bildfeldkrümmung ist definiert als peak-to-valley-Wert der axialen Fokalebenenposition in Abhängigkeit vom Feldpunkt, also die maximale Feldvariation der Fokalebene. In einigen Ausführungsbeispielen weist das Projektionsobjektiv 2101 eine relativ geringe Bildfeldkrümmung für Bilder in der Bildebene 2102 auf. Bspw. weist das Projektionsobjektiv 2101 eine bildseitige Bildfeldkrümmung von weniger als 20 nm, bevorzugt weniger als 15 nm, besonders bevorzugt weniger als 12 nm, insbesondere bevorzugt weniger als 10 nm, ganz besonders bevorzugt weniger als 9 nm, bevorzugt weniger als 8 nm, bevorzugt weniger als 7 nm, ganz bevorzugt weniger als 6 nm, insbesondere bevorzugt weniger als 5 nm, ganz besonders bevorzugt weniger als 4 nm, insbesondere bevorzugt weniger als 3 nm, bevorzugt weniger als 2 nm, ganz bevorzugt weniger als 1 nm auf.

Ein anderes Maß, das dazu verwendet werden kann, die optische Performance eines Projektionsobjektives zu evaluieren, ist die Verzeichnung. Die Verzeichnung ist definiert als der maximale absolute Wert der feldpunktabhängigen Abweichung des Bildpunktes von der idealen Bildpunktposition in der Bildebene. In einigen Beispielen hat das Projektionsobjektiv eine relativ geringe Verzeichnung von 10 nm oder weniger, bevorzugt 9 nm oder weniger, ganz bevorzugt 8 nm oder weniger, insbesondere bevorzugt 7 nm oder weniger, ganz bevorzugt 6 nm oder weniger, insbesondere bevorzugt 5 nm oder weniger, insbesondere 4 nm oder weniger, bevorzugt 3 nm oder weniger, ganz bevorzugt 2 nm, bevorzugt 1 nm oder weniger.

Das Projektionsobjektiv kann ein katoptrisches Projektionsobjektiv oder ein katadioptrisches Projektionsobjektiv sein. Bei einem katoptrischen Projektionsobjektiv weist dieses ausschließlich reflektive optische Elemente wie bspw. Spiegel auf. Katadioptrische Systeme weisen sowohl reflektive wie refraktive optische Elemente auf.

Ist das Objektiv als katoptrisches System ausgebildet, so umfasst es eine Vielzahl von Spiegeln, die derart angeordnet sind, dass die Strahlung, die von einer Maske 2140 zu einem Substrat 2150 verläuft, derart reflektiert wird, dass ein Bild der Maske 2140 auf der Oberfläche des Substrats 2150 ausgebildet wird. Spezielle Ausgestaltungen eines Projektionsobjektives sind wie in der nachfolgenden Beschreibung beschrieben, ausgebildet. Allgemein gesprochen wird die Anzahl, die Größe und die Struktur der Spiegel von den gewünschten optischen Eigenschaften des Projektionsobjektives 2101 und den physikalischen Randbedingungen der Projektionsbelichtungsanlage 2100 determiniert.

Die Anzahl der Spiegel im Projektionsobjektiv 2101 kann variieren. Typischerweise ist die Spiegelanzahl mit verschiedenen Anforderungen an die optischen Eigenschaften des Objektivs verknüpft.

In bestimmten Ausführungsbeispielen hat das Projektionsobjektiv 2101 wenigstens zwei Spiegel, bevorzugt wenigstens vier Spiegel, bevorzugt wenigstens fünf Spiegel, ganz bevorzugt wenigstens sechs Spiegel, insbesondere bevorzugt wenigstens sieben Spiegel, ganz besonders bevorzugt wenigstens acht Spiegel. In besonders bevorzugten Ausführungsbeispielen der Erfindung, bei denen Spiegel des Objektives zwischen der Objektebene und der Bildebene angeordnet sind, weist das Projektionsobjektiv 2101 eine gerade Spiegelanzahl auf, bspw. vier Spiegel, sechs Spiegel, acht Spiegel auf.

Das Projektionsobjektiv 2101 umfasst im Allgemeinen einen oder mehrere Spiegel mit positiver optischer Brechkraft. Mit anderen Worten bedeutet dies, dass der reflektierende Abschnitt des Spiegels eine konkave Oberfläche hat und demgemäß als Konkavspiegel oder konkaver Spiegel bezeichnet wird. Das Projektionsobjektiv 2101 kann zwei oder mehr bspw. drei oder mehr, insbesondere vier oder mehr Konkavspiegel umfassen. Das Projektionsobjektiv 2101 kann auch einen oder mehrere Spiegel umfassen, die negative optische Brechkraft aufweisen. Dies bedeutet, dass ein oder mehrere der Spiegel einen reflektierenden Abschnitt mit einer konvexen Oberfläche haben. Derartige Spiegel werden auch als konvexe Spiegel oder Konvexspiegel bezeichnet. In einigen Ausführungsbeispielen kann das Projektionsobjektiv 2101 zwei oder mehr, insbesondere drei oder mehr, ganz besonders vier oder mehr konvexe Spiegel aufweisen.

In bestimmten Ausführungsbeispielen sind die Spiegel derart in Projektionsobjektiven 2101 angeordnet, dass die Strahlung, die von der Objektebene 2103 ausgeht, ein oder mehrere Zwischenbilder ausbildet.

Ausführungsbeispiele der Erfindung, die eines oder mehrere Zwischenbilder haben, umfassen zwei oder mehr Pupillenebenen. In bevorzugten Ausführungsbeispielen ist wenigstens in einer dieser Pupillenebenen physikalisch zugänglich eine Aperturblende angeordnet.

Im Allgemeinen sind die Spiegel derart ausgebildet, dass ein großer Anteil des Lichtes der Betriebswellenlänge des Projektionsobjektives, die unter einem Winkel oder einem Winkelbereich auf die Spiegelfläche auftreffen, im Wesentlichen reflektiert wird. Die Spiegel können so ausgebildet sein, dass sie beispielsweise mehr als 50%, bevorzugt mehr als 60%, ganz bevorzugt mehr als 70%, insbesondere bevorzugt mehr als 80%, ganz besonders bevorzugt mehr als 90% der auf die Fläche auftreffenden Strahlung mit einer Wellenlänge $\lambda$ reflektieren. In einigen Ausführungsbeispielen umfassen die Spiegel einen Vielfach-Schicht-Stapel, einen so genannten multilayer stack, von Schichten unterschiedlichen Materials, wobei der Stapel so aufgebaut ist, dass er auf die Fläche einfallende Strahlung der Wellenlänge $\lambda$ im wesentlich reflektiert. Jeder Film des Stapels hat eine optische Dicke von ungefähr $\dfrac{\lambda}{4}$. Die Vielfach-Schicht-Stapel können 20 oder mehr, bevorzugt 30 oder mehr, insbesondere bevorzugt 40 oder mehr, ganz besonders bevorzugt 50 oder mehr Schichten umfassen. Beispielsweise besteht das Vielfach-Schicht-System aus alternierenden Vielfach-Schichten bestehend aus Molybdän und Silizium oder Molybdän und Beryllium, um Spiegel auszubilden, die Strahlung im Wellenlängenbereich von 10 nm bis 30 nm reflektieren, beispielsweise bei einem Wellenlängenwert $\lambda$ von 13 nm oder 11 nm.

In bestimmten Ausführungsformen sind die Spiegel aus Quarzglas hergestellt, die mit einer einzigen Aluminiumschicht beschichtet sind. Dieser wiederum ist überbeschichtet mit dielektrischen Schichten die Materialien wie $MgF_2$, $LaF_2$, $Al_2O_3$ beispielsweise für Wellenlängen von ungefähr 193 nm umfassen.

Im Allgemeinen variiert der Anteil der Strahlung, der von einem Spiegel reflektiert wird, als Funktion des Einfallswinkels der Strahlung auf die Spiegeloberfläche. Da die abbildende Strahlung durch ein katoptrisches Projektionsobjektiv entlang einer Vielzahl von unterschiedlichen Wegen propagiert wird, kann der Einfallswinkel der Strahlung auf jedem Spiegel variieren. Dies ist gezeigt in Figur 1d, die einen Teil eines Spiegels 2300 im meridionalen Schnitt, das heißt in der Meridionalebene zeigt. Der Spiegel 2300 umfasst eine konkave reflektive Spiegeloberfläche 2301. Die abbildende Strahlung, die auf die Fläche 2301 entlang unterschiedlicher Wege auftrifft, umfasst bspw. die Wege, die durch die Strahlen 2310, 2320, 2330 dargestellt sind. Die Strahlen 2310, 2320 und 2330 treffen auf einen Teil der Spiegeloberfläche 2301 auf. Die Normalen auf die Oberfläche des Spiegels sind in diesem Bereich der Spiegeloberfläche 2301 unterschiedlich. Die Richtung der Oberflächennormalen sind in diesem Bereich durch die Geraden 2311, 2321 und 2331, die korrespondierend zu den Strahlen 2310, 2320 und 2330 sind, dargestellt. Die Strahlen 2310, 2320, und 2330 treffen auf die Oberfläche unter den Winkeln $\Theta_{2310}$, $\Theta_{2320}$ und $\Theta_{2330}$ auf.

Für jeden Spiegel im Projektionsobjektiv 2100 können die Einfallswinkel der abbildenden Strahlen auf eine Vielzahl von Wegen dargestellt werden. Eine mögliche Darstellung ist der maximale Winkel der auf jeden Spiegel auftreffenden Strahlen im Meridionalschnitt des Projektionsobjektives 2101. Dieser maximale Winkel wird mit $\Theta_{max}$ bezeichnet. Im Allgemeinen kann der Winkel $\Theta_{max}$ verschiedener Spiegel des Projektionsobjektives 2101 variieren. In bestimmten Ausführungsbeispielen der Erfindung beträgt der maximale Wert $\Theta_{max(max)}$ für alle Spiegel des Projektionsobjektivs 2101 60° oder weniger, bevorzugt 55° oder weniger, insbesondere 50° oder weniger, insbesondere 45° oder weniger. In einigen Ausführungsbeispielen ist der maximale Winkel $\Theta_{max(max)}$ relativ gering. Beispielsweise kann der maximale Winkel $\Theta_{max(max)}$ 40° oder weniger, bevorzugt 35° oder weniger, ganz bevorzugt 30° oder weniger, insbesondere 25° oder weniger, besonders bevorzugt 20° oder weniger, betragen.

Eine andere Möglichkeit der Charakterisierung ist die Charakterisierung über den Einfallswinkel des Hauptstrahls des zentralen Feldpunktes des in der Objektebene auszuleuchtenden Feldes auf jedem Spiegel im meridionalen Schnitt. Dieser Winkel wird als $\Theta_{CR}$ bezeichnet. Bezüglich des Hauptstrahlwinkels $\Theta_{CR}$ wird auch auf den einleitenden Teil der Anmeldung verwiesen. Wiederum kann ein maximaler Winkel $\Theta_{CR(max)}$ im Projektionsobjektiv als maximaler Hauptstrahlwinkel des zentralen Feldpunktes definiert werden. Dieser Winkel $\Theta_{CR(max)}$ kann relativ niedrig sein, beispielsweise kann der maximale Winkel $\Theta_{CR(max)}$ im Projektionsobjektiv geringer als 40°, bevorzugt geringer als 35°, ganz bevorzugt geringer als 30°, insbesondere geringer als 25°, insbesondere geringer als 20°, insbesondere bevorzugt geringer als 15° sein.

Jeder Spiegel im Projektionsobjektiv 2101 kann des Weiteren durch einen Bereich der Einfallswinkel im meridionalen Schnitt des Projektionsobjektives 2101 charakterisiert sein. Der Bereich, in dem der Winkel $\Theta$ auf jedem Spiegel variiert, wird als $\Delta\Theta$ bezeichnet. Für jeden Spiegel wird $\Delta\Theta$ durch den Unterschied zwischen einem Winkel $\Theta_{(max)}$ und $\Theta_{(min)}$ definiert, wobei $\Theta_{(min)}$ der minimale Einfallswinkel der abbildenden Strahlen auf eine Spiegeloberfläche im meridionalen Schnitt des Projektionsobjektives 2101 und $\Theta_{(max)}$ der maximale Wert der einfallenden abbildenden Strahlen auf eine Spiegeloberfläche ist, wie bereits zuvor definiert. Im Allgemeinen variiert der Bereich $\Delta\Theta$ für jeden Spiegel im Projektionsobjektiv 2101. Für einige Spiegel kann $\Delta\Theta$ relativ gering sein. Beispielsweise kann $\Delta\Theta$ geringer als 25°, bevorzugt geringer als 20°, insbesondere bevorzugt geringer als 15°, ganz bevorzugt geringer als 10°, sein. Alternativ hierzu, kann für andere Spiegel im Projektionsobjektiv 2101 $\Delta\Theta$ relativ groß sein. Beispielsweise kann $\Delta\Theta$ für einige Spiegel 20° oder mehr, insbesondere 25° oder mehr, besonders bevorzugt 30° oder mehr, insbesondere bevorzugt 35° oder mehr, ganz besonders 40° oder mehr sein. In einigen Ausgestaltungen kann der Maximalwert für $\Delta\Theta$, der Wert $\Delta\Theta_{max}$ der Maximalwert der Winkelvariation auf einem Spiegel für alle Spiegel im Projektionsobjektiv 2101 relativ gering sein. Beispielsweise kann der Wert $\Delta\Theta_{max}$ geringer als 25°, insbesondere geringer als 20°, ganz besonders geringer als 15°, insbesondere geringer als 12°, insbesondere geringer als 10°, insbesondere geringer als 8° sein.

Ein Beispiel eines Spiegels 2660, wie er im Projektionsobjektiv verwendet wird, ist in Fig. 1e gezeigt. Der Spiegel 2660 weißt die Form eines Ringsegmentes auf. Der Spiegel 2660 korrespondiert in der Form zu einem Segment eines kreisförmigen Spiegels 2670 mit einem Durchmesser D. Der Spiegel 2660 hat eine maximale Dimension bzw. Abmessung in x Richtung, die durch $M_x$ gegeben ist. In den Ausführungsbeispielen kann $M_x$ 800 mm oder weniger, bevorzugt 700 mm oder weniger, insbesondere 600 mm oder weniger, insbesondere 500 mm oder weniger, bevorzugt 400 mm oder weniger, insbesondere 300 mm oder weniger, bevorzugt 200 mm oder weniger, insbesondere 100 mm oder weniger betragen.

Der Spiegel 2660 ist symmetrisch mit Bezug auf den Meridionalschnitt 2675. Die Meridionalebene wird durch die y- und z-Achse des lokalen Koordinatensystems aufgespannt. Der Spiegel 2660 hat eine Dimension $M_y$ entlang der Meridionallinie 2675. $M_y$ kann geringer oder größer sein als $M_x$. Bei kreisrunden Spiegeln, z.B. bei Spiegeln, die in einer Blendenebene angeordnet sind, ist $M_x = M_y$. In einigen Ausführungsbeispielen ist $M_y$ im Bereich von 0.1 $M_x$, bevorzugt 0.2 $M_x$ oder mehr, insbesondere 0,3 $M_x$ oder mehr, insbesondere 0,4 $M_x$ oder mehr, bevorzugt 0,5 $M_x$ oder mehr, insbesondere 0,6 $M_x$ oder mehr, bevorzugt 0,7 oder mehr, insbesondere 0,8 $M_x$ oder mehr, ganz bevorzugt 0,9 $M_x$ oder mehr. Alternativ kann in bestimmten Ausführungsformen $M_y$ 1,1 $M_x$ oder mehr, bevorzugt 1, 5 $M_x$ oder mehr, oder im Bereich von 2 $M_x$ bis 10 $M_x$ liegen. $M_y$ kann ungefähr 800 mm oder weniger, bevorzugt 700 mm oder weniger, insbesondere 600 mm oder weniger, bevorzugt 500 mm oder weniger, insbesondere 400 mm oder weniger, besonders 300 mm oder weniger, insbesondere 200 mm oder weniger, bevorzugt 100 mm oder weniger betragen.

Die Spiegel des Projektionsobjektives können so angeordnet sein, dass die optische Achse 2105 den Spiegel schneidet oder aber auch das die optische Achse 2105 den Spiegel nicht schneidet.

Im Allgemeinen kann das Projektionsobjektiv 2100 in Abhängigkeit vom Design Spiegel unterschiedlicher Form und Größe umfassen. In einigen Beispielen kann die maximale Dimension D jedes Spiegels des Projektionsobjektivs 1000 mm oder weniger, insbesondere 900 mm oder weniger, bevorzugt 800 mm oder weniger, insbesondere 700 mm oder weniger sein.

Im Allgemeinen kann die Form des Feldes des Projektionsobjektives 2101 variieren. In Figur 1f ist ein Ringsegment 2700 bzw. Ringfeld dargestellt. Dieses Ringsegment 2700 kann durch eine x-Dimension $D_x$, eine y-Dimension $D_y$ und eine radiale Dimension $D_r$ charakterisiert werden. $D_x$ und $D_y$ korrespondieren zur Dimension des Feldes bzw. zur Abmessung des Feldes entlang der x-Richtung und der y-Richtung. Diese Größen werden in der nachfolgenden Beschreibung angegeben. So beträgt bei einem Feld mit einer von bspw. 26 x 2 mm$^2$ in der Bildebene $D_x$=26 mm und $D_y$=2 mm. $D_r$ korrespondiert zum Ringradius gemessen von der optischen Achse 2105 zur inneren Grenze des Feldes 2700. Das Ringfeldsegment 2700 ist symmetrisch bezogen auf die Ebene parallel zur y-z-Ebene, wie durch die Linie 2710 angedeutet. Im Allgemeinen ist die Größe von $D_x$, $D_y$ und $D_r$ variabel und hängt von dem Design des Projektionsobjektives 2101 ab. Typischerweise ist $D_x$ größer als $D_y$. Die relative Größe der Felddimensionen bzw. Feldabmessungen $D_x$, $D_y$ und $D_r$ in der Objektebene 2103 und der Bildebene 2102 variieren in Abhängigkeit von der Vergrößerung oder Verkleinerung des Projektionsobjektives 2101. In einigen Ausführungsbeispielen ist $D_x$ in der Bildebene 2103 relativ groß. Beispielsweise kann $D_x$ in der Bildebene 2101 größer als 1 mm, bevorzugt größer als 3 mm, insbesondere größer als 4 mm, bevorzugt größer als 5 mm, insbesondere größer als 6 mm, insbesondere größer als 7 mm, bevorzugt größer als 8 mm, insbesondere größer als 9mm, bevorzugt größer als 10 mm, insbesondere größer als 11 mm, bevorzugt größer als 12 mm, insbesondere größer als 13 mm, bevorzugt größer als 14 mm, insbesondere größer als 15 mm, bevorzugt größer als 18 mm, insbesondere größer als 20 mm, bevorzugt größer als 25 mm, insbesondere größer als 30 mm sein. $D_y$ in der Bildebene 2102 kann im Bereich von 0,5 mm bis 5 mm liegen, bspw. bis 1 mm, bevorzugt bis 2 mm, insbesondere bis 3 mm, ganz besonders bevorzugt bis 4mm. Typischerweise ist $D_r$ in der Bildebene 2102 im Bereich von 10 mm bis 50 mm. $D_r$ kann beispielsweise 15 mm oder mehr, beispielsweise 20 mm oder mehr, insbesondere 25 mm oder mehr, bevorzugt 30 mm oder mehr in der Bildebene 2102 betragen.

Allgemein gesprochen kann für andere Feldformen bspw. ein Rechteckfeld das Projektionsobjektiv 2101 eine maximale Felddimension bzw. Feldabmessung mehr als 1 mm, insbesondere mehr als 3 mm, bevorzugt mehr als 4 mm, insbesondere mehr als 5 mm, bevorzugt mehr als 6 mm, insbesondere mehr als 7 mm, bevorzugt mehr als 8 mm, insbesondere mehr als 9 mm, bevorzugt mehr als 10 mm, insbesondere mehr als 11 mm, bevorzugt mehr als 12 mm, insbesondere mehr als 13 mm, bevorzugt mehr als 14 mm, insbesondere mehr als 15 mm, bevorzugt mehr als 18 mm, insbesondere mehr als 20 mm oder mehr als 25 mm, insbesondere mehr als 30 mm in der Bildebene 2102 betragen. In Fig. 1e eingetragen ist des Weiteren der zentrale Feldpunkt Z. Im zentralen Feldpunkt Z ist ein lokales x-y-z-Koordinatensystem angegeben. Bei scannenden Mikrolithographiesystemen ist im Allgemeinen die y-Richtung die Scan-Richtung.

Im Allgemeinen kann das Projektionsobjektiv 2101 unter Verwendung kommerziell erhältlicher optischer Designprogramme wie ZEMAX, OSLO, Code V, optimiert und analysiert werden. Beginnend mit der Festlegung der Wellenlänge, der Feldgröße und der numerischen Apertur können die optischen Eigenschaften optimiert werden, die für ein Projektionsobjektiv benötigt werden, wie bspw. der Wellenfrontfehler, die Telezentrie, die Uniformität sowie die Verzeichnung und die Bildfeldkrümmung. Nachfolgend sollen Ausführungsbeispiele der Erfindung eingehend mit optischen Daten beschrieben werden. In vorliegender Anmeldung sind alle angegebenen optischen Daten im Code-V-Format.

In Figur 1g ist eine Mikrolithographie-Projektionsbelichtungsanlage gemäß dem Stand der Technik, wie aus der Anmeldung US 2005/088760 bekannt, detailliert dargestellt. Das Projektionsobjektiv 1 weist eine negative Schnittweite auf. Das Beleuchtungssystem umfasst eine primäre Lichtquelle 3 und ein sammelndes optisches Element einen sog. Kollektor 5. Der Kollektor 5 ist ein grazing-incidence-Kollektor. Die von der Lichtquelle ausgesandte Strahlung wird mit Hilfe des spektralen Filterelementes 7 zusammen mit der Aperturblende 9 gefiltert, so dass hinter der Aperturblende nur Nutzstrahlung, bspw. von 13,5 nm vorliegt. Der Spektralfilter in Form eines Gitterelementes beugt das auf das Gitterelement auftreffende Licht in unterschiedliche Richtungen bspw. in die -1. Beugungsordnung. Die Aperturblende ist in oder nahe des Zwischenbildes 11 der primären Lichtquelle 3 in der -1. Beugungsordnung angeordnet. Die Projektionsbelichtungsanlage umfasst des Weiteren ein erstes facettiertes optisches Element 13 mit ersten Facetten sog. Feldrasterelementen, die als kleine Facettenspiegel ausgebildet sind und ein zweites optisches Element 15 mit zweiten Facetten sog. Pupillenrasterelementen. Das erste optische Element 13, umfassend die Feldfacetten zerlegt das Lichtbüschel 17, dass von der primären Lichtquelle 3 her auftrifft in eine Vielzahl von Lichtbündeln. Jedes Lichtbündel wird fokussiert und bildet eine sekundäre Lichtquelle aus am Ort oder nahe des Ortes, an der das zweite optische Element 15 mit Pupillenrasterelementen angeordnet ist.

Besitzen die Feldrasterelemente die Form des auszuleuchtenden Feldes wie in dem dargestellten Ausführungsbeispiel, so ist es nicht erforderlich einen Spiegel für die Feldformung vorzusehen.

In der Objektebene 20 der Mikrolithographie-Projektionsbelichtungsanlage ist ein Retikel auf einem Transportsystem 19 angeordnet. Das in der Objektebene 20 angeordnete Retikel 21 wird mit Hilfe des Projektionsobjektives 1 auf ein lichtsensitives Substrat 22 bspw. einen Wafer, der ebenfalls auf einem Trägersystem 23 angeordnet ist, abgebildet. Das dargestellte Projektionsobjektiv umfasst sechs Spiegel, einen ersten Spiegel S1, einen zweiten Spiegel S2, einen dritten Spiegel S3, einen vierten Spiegel S4, einen fünften Spiegel S5 und einen sechsten Spiegel S6, die um eine gemeinsame optische Achse HA zentriert angeordnet sind. Das Projektionsobjektiv 1 hat eine negative Schnittweite der Eintrittspupille. In oder nahe der Ebene der zugehörigen gespiegelten Eintrittspupille RE ist das zweite facettierte optische Element 15 des Beleuchtungssystems angeordnet.

Wie aus Figur 1g deutlich zu erkennen ist, ist aufgrund des Aufbaus des Projektionsobjektives gemäß dem Stand Technik der Strahlengang zwischen dem Beleuchtungssystem und dem Projektionsobjektiv überkreuzt, so dass das System keinen modularen Aufbau aufweist, der eine Trennung von Beleuchtungssystem und Projektionsobjektiv zulässt.

In Figur 1h ist der Strahlverlauf für eine Vielzahl der in dieser Anmeldung dargestellten Ausführungsbeispiele von Projektionsobjektiven mit negativer Schnittweite im Bereich von Objektebene 51 des Projektionsobjektives und des im Lichtweg von der Objektebene zur nicht dargestellten Bildebene ersten Spiegels S1 gezeigt. In Figur 1h bezeichnet CRE den auf den ersten Spiegel einfallenden Hauptstrahl und CRR den reflektierten Hauptstrahl zu ein und demselben Feldpunkt des Objektfeldes, bspw. zum zentralen Feldpunkt des Objektfeldes. Wie in Figur 1h zu erkennen liegt bei einer bevorzugten Ausgestaltung der Erfindung der Hauptstrahl CRE des einfallenden Strahlbüschels in der Meridionalebene des Projektionsobjektives zwischen dem an der Oberfläche des Spiegels S1 reflektierten Hauptstrahles CRR des reflektierten Strahlbüschels und der optischen Achse HA des Projektionsobjektives.

In Figur 1h des Weiteren eingezeichnet ist das lokale x-, y-, z-Koordinatensystem, die Normale NO, die senkrecht auf der Objektebene 51, in der ein Objektfeld ausgebildet wird, steht und der positive Hauptstrahlwinkel γ unter dem der Hauptstrahl CRE an einem Objekt (nicht dargestellt) in der Objektebene 51 reflektiert wird.

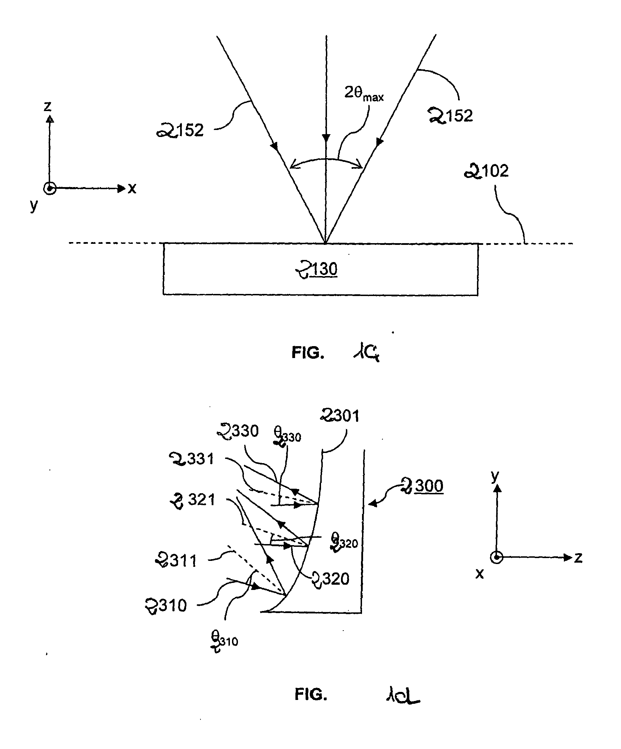

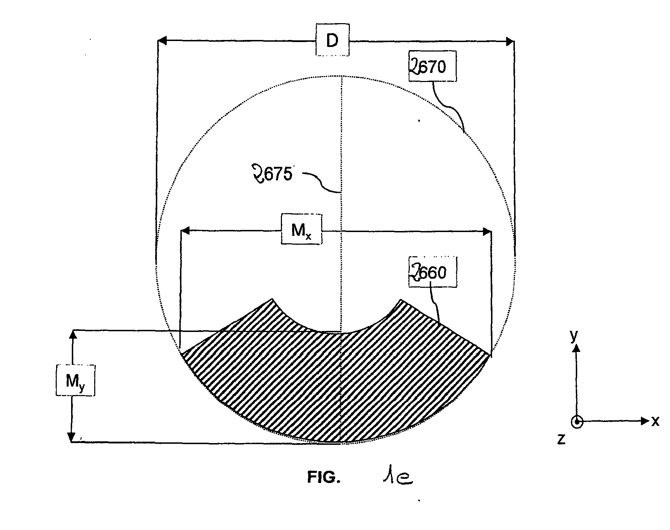

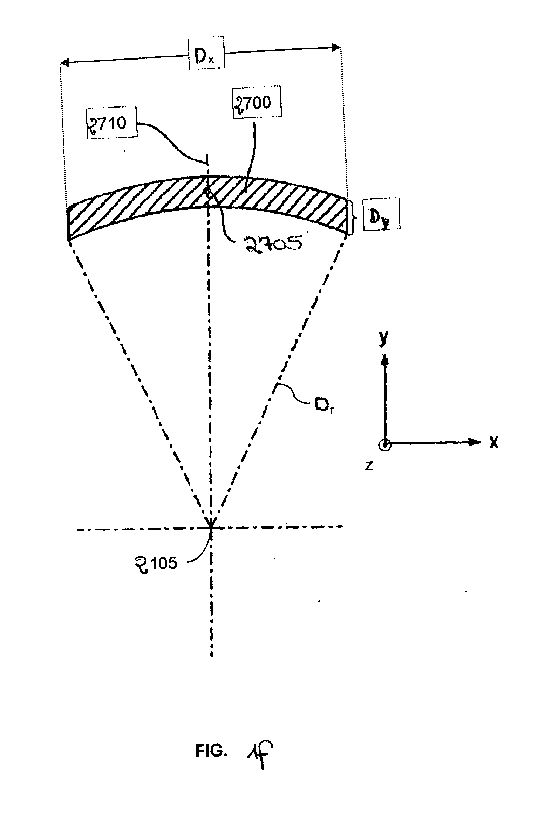

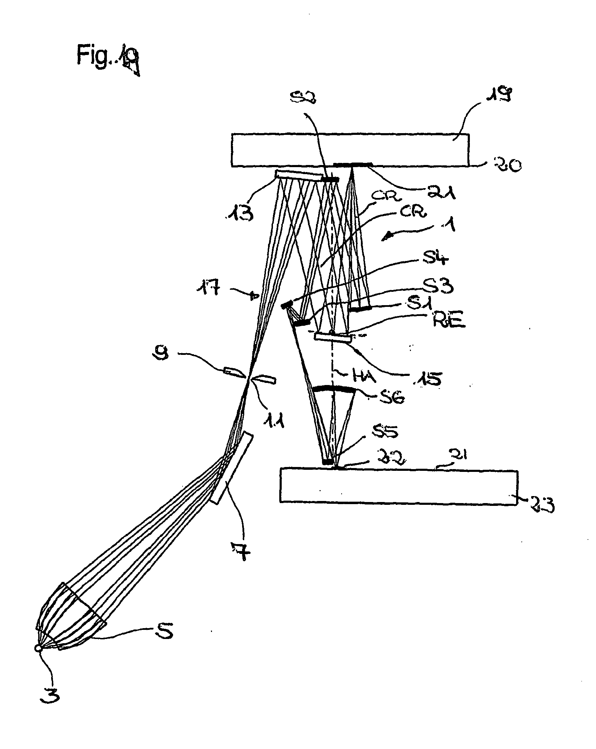

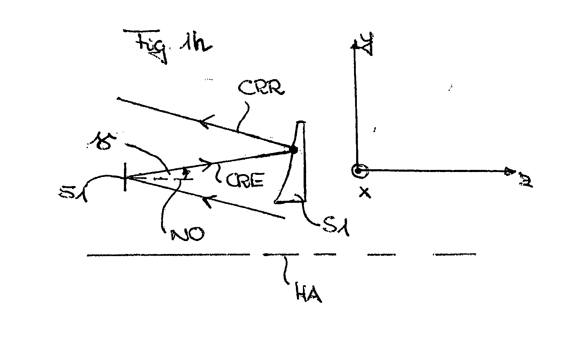

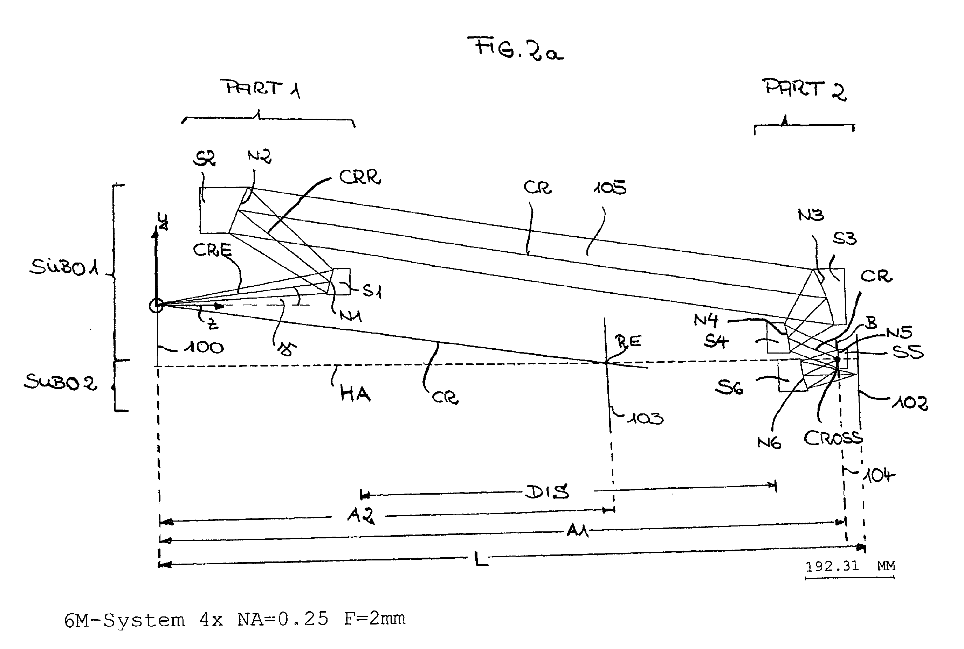

In Figur 2a wird eine erste Ausführungsform eines 6-Spiegel-Projektionsobjektives angegeben, das eine negative Schnittweite der Eintrittspupille aufweist, aber einen modularen Aufbau einer Mikrolithographie-Projektionsbelichtungsanlage zulässt. Das Objektiv gemäß Figur 2a umfasst eine Objektebene 100, eine Bildebene 102, einen ersten Spiegel S1, einen zweiten Spiegel S2, einen dritten Spiegel S3, einen vierten Spiegel S4, einen fünften Spiegel S5, einen sechsten Spiegel S6.

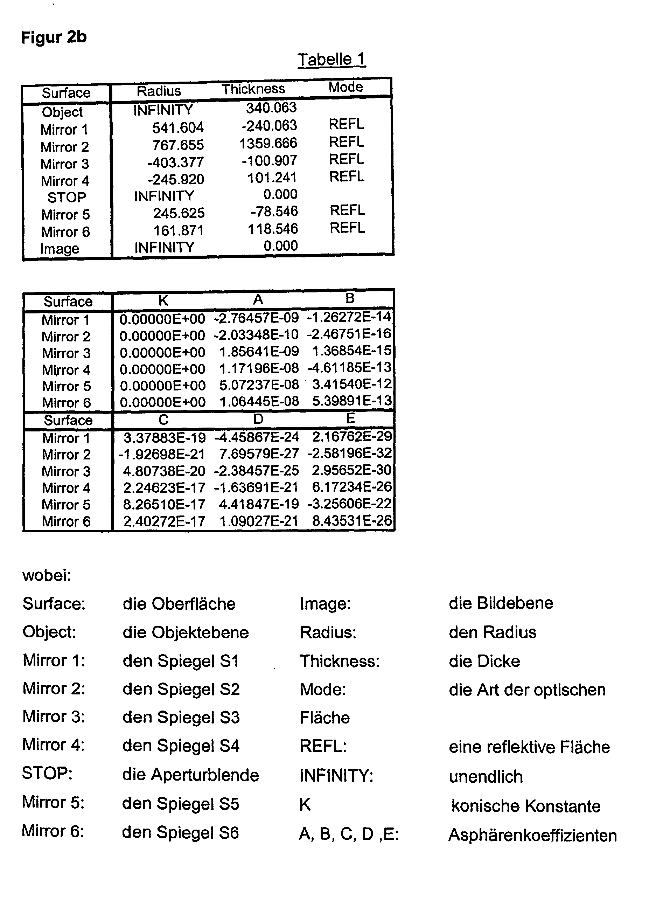

Wie deutlich zu erkennen ist, wird im Lichtweg von der Objektebene 100 zur Bildebene 102 bei dem in Figur 2a dargestellten Projektionsobjektiv kein Zwischenbild ausgebildet. Das Objektiv hat lediglich eine einzige Blendenebene 104, die bei dem dargestellten Ausführungsbeispiel im hinteren Objektivteil bestehend aus dem fünften S5 und dem sechsten Spiegel S6, auf dem fünften Spiegel S5 zu Liegen kommt. Eine derartige Anordnung der Blendenebene 104 erlaubt es, die Spiegel S1 und S2 im vorderen Objektivteil mit einem großen Abstand zur optischen Achse HA anzuordnen. Wird ein derartiges Projektionsobjektiv in einer Projektionsbelichtungsanlage mit einem reflektiven Objekt in einer Objektebene eingesetzt, so wird es aufgrund der Anordnung der Spiegel im vorderen Objektivteil mit großem Abstand zur optischen Achse möglich, Komponenten des Beleuchtungssystems, insbesondere ein facettiertes optisches Element des Beleuchtungssystems, in diesem Bereich auf der optischen Achse der Projektionsoptik und damit in oder nahe der gespiegelten Eintrittspupille RE anzuordnen. Das in Figur 2a dargestellte Projektionsobjektiv weist eine bildseitige numerische Apertur von NA=0,25 und eine Verkleinerung 4x auf. Die Feldgröße des in der Bildebene abgebildeten Feldes beträgt 2 x 26 mm², d.h. die Abmessung $D_y$ des Feldes entlang der y-Achse des in Fig. 1e gezeigten Feldes beträgt 2 mm und die Abmessung $D_x$ 26 mm. Bei dem in Figur 2 gezeigten Ausführungsbeispiel liegt in der Meridionalebene der Hauptstrahl CRE des auf die Spiegeloberfläche des ersten Spiegels S1 auftreffenden Strahlbüschels zwischen dem reflektierten Hauptstrahl CRR zum selben Feldpunkt des reflektierten Strahlbüschels und der optischen Achse HA des Projektionsobjektives. Des Weiteren ist die gespiegelte Eintrittspupille RE des Projektionsobjektives eingezeichnet, die in der Ebene 103 liegt. Der Schnittpunkt des Hauptstrahles CR des von der Objektebene zur Bildebene verlaufenden Strahlenganges 105 mit der optischen Achse ist mit CROSS bezeichnet. Dieser Schnittpunkt CROSS liegt erfindungsgemäß im hinteren Objektivteil im Meridionalschnitt zwischen der Ebene 103, in der die gespiegelte Eintrittspupille RE liegt, und der Ebene, die den Schnittpunkt CROSS umfasst. Die Auflösung der Ausgestaltung des Projektionsobjektives gemäß Figur 2a beträgt 22 nm, der bildseitige Wellenfrontfehler RMS 0,008 λ, die bildseitige Feldkrümmung 7 nm und die Verzeichnung 2,5 nm. Das Objektiv weist kein Zwischenbild auf und eine zugängliche Blendenebene 104. Die Aperturblende B wird wie zuvor beschrieben in der zugänglichen Blendenebene 104, die gleichzeitig auch eine Pupillenebene ist, die den Schnittpunkt CROSS umfasst, auf dem fünften Spiegel ausgebildet. Des Weiteren sind in Fig. 2a der Abstand A1 der Ebene 104, die den Schnittpunkt CROSS enthält zur Objektebene 100 entlang der optischen Achse HA sowie der Abstand A2, der Ebene 103, die die gespiegelte Eintrittspupille RE enthält, zur Objektebene 100 angegeben. Es gilt A2 < A1. Des Weiteren in Figur 2a eingezeichnet sind ein erstes Subobjektiv (SUB01) sowie ein zweites Subobjektiv (SUB02), wobei das zweite Subobjektiv (SUB02) die Aperturblende B umfasst.

Des Weiteren ist Figur 2a zu entnehmen, dass das Projektionsobjektiv in zwei Teilsysteme, ein erstes Teilsystem PART1 und ein zweites Teilsystem PART2 unterteilt ist. Das erste Teilsystem PART1 mit den Spiegeln S1 und S2 weist einen Abstand DIS entlang der optischen Achse HA zum zweiten Teilsystem PART2 mit Spiegeln S3, S4, S5 und S6 auf.

Der Abstand DIS ergibt sich aus dem Abstand der Rückflächen des Spiegels des ersten Teilsystems PART1, der den größten Abstand zur Objektebene 100 aufweist und der Rückfläche des Spiegels des zweiten Teilsystems PART2, der den größten Abstand zur Bildebene 102 aufweist. Vorliegend ist dies der Abstand zwischen der Rückfläche des ersten Spiegels S1 und der Rückfläche des vierten Spiegels S4

Der Abstand zwischen Objektebene 100 und Bildebene 102 beträgt 1500 mm, der maximale Spiegeldurchmesser, d. h. die maximale Dimension $M_y$ aller Spiegel im Meridionalschnitt 131 mm und der maximale Spiegeldurchmesser aller Spiegel in x-Richtung, d. h. die maximale Dimension $M_x$ 370 mm.

Die Spiegelabfolge von erstem Spiegel S1, zweitem Spiegel S2, drittem Spiegel S3, viertem Spiegel S4, fünftem Spiegel S5, sechstem Spiegel S6 ist NPPNNP, d. h. konvex - konkav - konkav - konvex - konvex - konkav.

Der Hauptstrahlwinkel γ beim Ausführungsbeispiel 1 des Hauptstrahles CR zum mittleren Feldpunkt des Feldes in der Objektebene 100 beträgt γ=7° gegenüber der Normalen am Objekt. Der Abstand des mittleren Feldpunktes von der optischen Achse beträgt 132 mm. Hieraus ergibt sich nach Rechnung, dass die gespiegelte Eintrittspupille RE einen axialen Abstand von 1075 mm zur Objektebene besitzt. Die optischen Daten der in Figur 2a dargestellten Ausführungsform sind in Code V-Format in Tabelle 1 in Figur 2b im Anhang zusammengestellt.

Bei den Code V-Daten, wie in dieser Anmeldung in den Figuren 2b, 3b, 5b, 6b, 6d, angegeben, bezieht sich der Begriff "thickness" beziehungsweise Dicke für reflektive Systeme darauf, daß "thickness" bzw. Dicke den Luftraum zwischen zwei benachbarten optischen Flächen bezeichnet, d.h. den Abstand entlang der optischen Achse eines rotationssysmmetrischen Systems zwischen zwei im Lichtweg aufeinanderfolgenden Flächen.

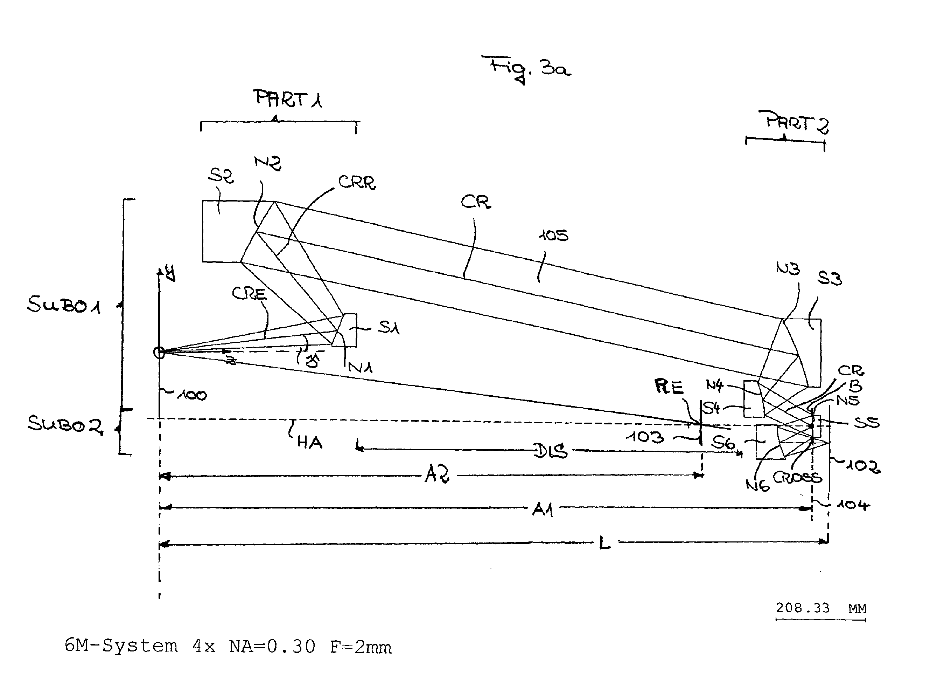

In Figur 3a ist ein zweites Ausführungsbeispiel eines erfindungsgemäßen 6-Spiegel-Projektionsobjektivs ohne Zwischenbild und mit negativer Schnittweite der Eintrittspupille gezeigt. Das Ausführungsbeispiel besitzt eine bildseitige numerische Apertur von NA=0.30 und eine Feldgröße $D_y$ x $D_x$ von 2 x 26mm$^2$ sowie eine Verkleinerung von 4x. Der bildseitige Wellenfrontfehler beträgt 0,03 λ, die bildseitige Feldkrümmung 18 nm und die Verzeichnung 4 nm. Die Spiegelabfolge im Lichtweg von der Objektebene zur Bildebene ist NPPNNP, d. h. konvex - konkav - konkav - konvex - konvex - konkav. Das Projektionsobjektiv umfasst eine zugängliche Blendenebene 104. Die Blende B ist in der zugänglichen Blendenebene 104 auf dem fünften Spiegel angeordnet. Die Blendenebene ist zugleich auch eine Pupillenebene, die den Schnittpunkt CROSS des Hauptstrahles CR mit der optischen Achse HA umfasst. Der Abstand von Objektebene 100 zu Bildebene 102 beträgt 1600 mm, der maximale Spiegeldurchmesser, d. h. die Abmessung $M_y$ für alle Spiegel im Meridionalschnitt 176 mm, der maximale Spiegeldurchmesser, d. h. die Abmessung $M_x$ für alle Spiegel in x-Richtung 459 mm.

Der Hauptstrahlwinkel des mittleren Feldpunktes beträgt γ=7° am Objekt und der Abstand des mittleren Feldpunktes von der optischen Achse HA 159 mm. Die gespiegelte Eintrittspupille RE in der Ebene 103 besitzt einen axialen Abstand A2 von 1295mm von der Objektebene 100. Gleiche Bauteile wie in Figur 2a sind mit denselben Bezugsziffern belegt. Wie in Figur 2a liegt der Hauptstrahl CRE des einfallenden Strahlbüschels auf die Oberfläche des ersten Spiegels S1 im Meridionalschnitt zwischen dem Hauptstrahl CRR des an der Oberfläche des ersten Spiegels reflektierten Strahlbüschels zum gleichen Feldpunkt und der optischen Achse. Der Schnittpunkt CROSS des Hauptstrahles CR des zentralen Feldpunkts mit der optischen Achse HA des Projektionsobjektives liegt geometrisch zwischen der Ebene 103 mit der gespiegelten Eintrittspupille RE des Projektionsobjektives und der Bildebene 102. Der Abstand der Ebene 104, in der der Schnittpunkt CROSS zu liegen kommt, entlang der optischen Achse zur Objektebene wird mit A1 bezeichnet, der Abstand der Ebene 103, in der die gespiegelte Eintrittspupille RE zu liegen kommt zur Objektebene mit A2. Die Lage des Schnittpunktes CROSS zwischen der gespiegelten Eintrittspupille RE und der Bildebene führt dazu, dass A2 < A1 für die vorliegende Ausführungsform gilt.

Wie aus Figur 3a zu entnehmen, hat der Hauptstrahl im Lichtweg der Objektebene 100 zur Bildebene 102 genau einen Schnittpunkt CROSS mit der optischen Achse. Erfindungsgemäß liegen somit alle Schnittpunkte des Projektionsobjektives zwischen der Ebene 103 der gespiegelten Eintrittspupille RE und der Bildebene 102.

Auch das zweite Ausführungsbeispiel umfasst zwei Teilsysteme, ein erstes Teilsystem PART1 und ein zweites Teilsystem PART2, die einen Abstand DIS zueinander aufweisen.

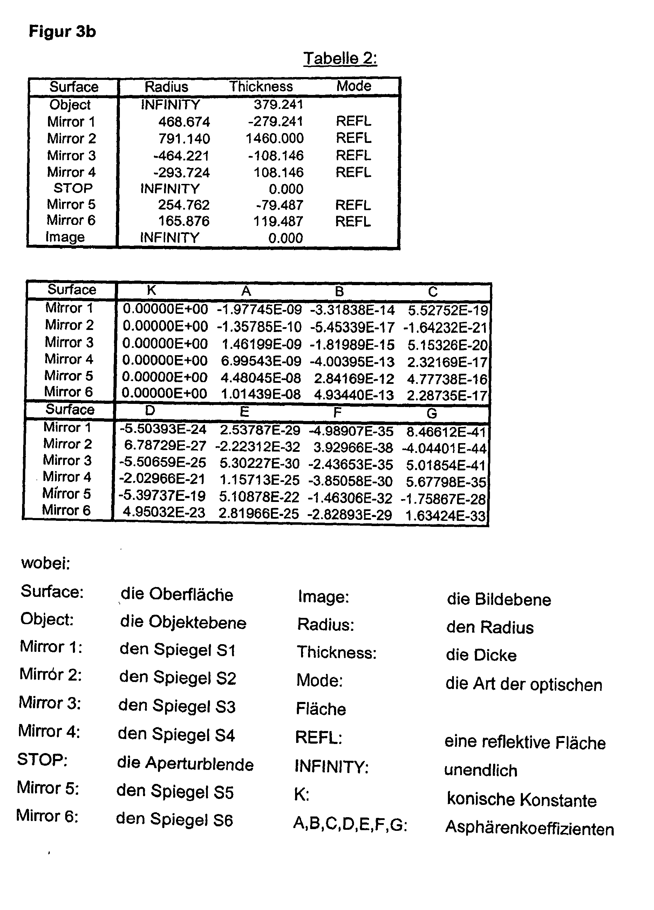

Für das zweite Ausführungsbeispiel gemäß Figur 3a sind in Tabelle 2 in Figur 3b die Systemdaten im Code V-Format angegeben.

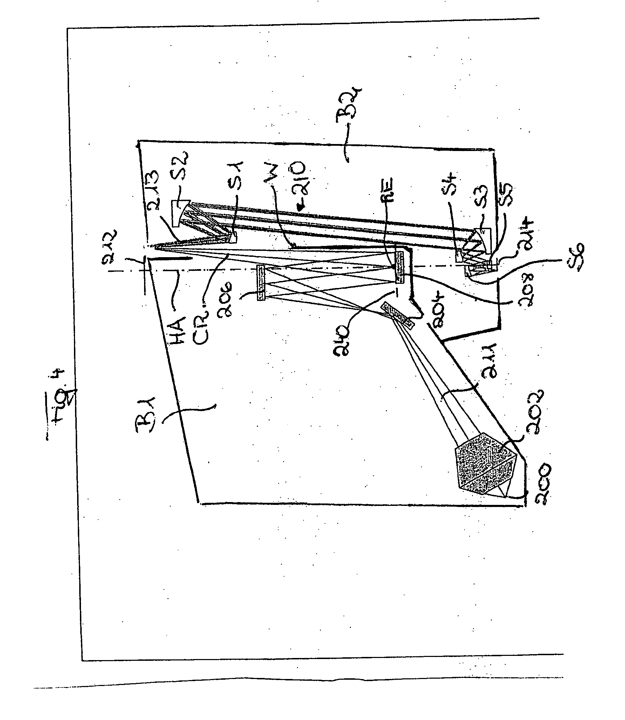

In Figur 4 ist eine Mikrolithographie-Projektionsbelichtungsanlage mit einem Projektionsobjektiv gemäß dem Ausführungsbeispiel in Figur 2a und Figur 2b gezeigt. Figur 4 entnimmt man, dass keine Strahlüberkreuzung zwischen dem Strahlengang der Projektionsoptik und dem Strahlengang der Beleuchtungsoptik auftritt, im Gegensatz zum System wie in Fig. 1., d. h. das Beleuchtungsstrahlbüschel 211 überkreuzt im Lichtweg von der vor letzten optischen Komponente 206 zur Objektebene 212, in der das Objekt bspw. ein Retikel angeordnet ist, sich in der Meridionalebene nicht mit dem Abbildungsstrahlengang 213, der im Projektionsobjektiv von der Objektebene 212 bis zur Bildebene 214 verläuft, mit Ausnahme der notwendigen Überkreuzung am Retikel. Die Meridionalebene ist vorliegend die Papierebene, die die optische Achse HA umfasst. Die optischen Elemente beider Teile einer Projektionsbelichtungsanlage - Beleuchtungssystem und Projektionssystem - sind in getrennten Bauräumen angeordnet. Die optischen Elemente des Beleuchtungssystems sind in einem ersten Bauraum B1 angeordnet; die optischen Elemente des Projektionssystems in einem zweiten Bauraum B2. Der erste Bauraum B1 ist bspw. durch eine Wand W vom zweiten Bauraum B2 separiert. Durch die Separation in zwei unterschiedlichen Bauräumen B1 und B2 ergibt sich für die Projektionsbelichtungsanlage ein modularer Aufbau. Weiterhin erkennt man, dass bspw. für den Einbau des Pupillenfacettenspiegels 208 eines doppeltfacettierten Beleuchtungssystems ausreichend Platz vorhanden ist.

Die in Figur 4 dargestellte Projektionsbelichtungsanlage für Wellenlängen < 100 nm ist ein Beispiel für eine Projektionsbelichtungsanlage insbesondere für die EUV-Lithographie mit einer bildseitigen numerischen Apertur NA $\geq$ 0,25; bevorzugt > 0,26 und weniger als 10 optischen Elementen, die eine normal-incidence-Reflektion aufweisen, wobei eine Strahlüberkreuzung zwischen Beleuchtungsstrahlengang und Projektionsobjektiv-Strahlengang vermieden wird.

Das in Figur 4 gezeigte Beleuchtungssystem der Mikrolithographie-Projektionsbelichtungsanlage umfasst eine Lichtquelle 200, einen genesteten grazing-incidence-Kollektor 202 sowie einen Gitterspektralfilter 204. Der Gitterspektralfilter ist mit der Bezugsziffer 204 belegt, die dem Gitterspektralfilter nachgeordnete Blende ist vorliegend nicht dargestellt. Im Strahlengang auf den Gitterspektralfilter folgen die beiden facettierten optischen Elemente des doppelt facettierten Beleuchtungssystems. Das erste facettierte optische Element, das eine Vielzahl von ersten Rasterelementen, sog. Feldfacetten umfasst, ist mit der Bezugsziffer 206 bezeichnet, das zweite facettierte optische Element, der sog. Pupillenfacettenspiegel mit Bezugsziffer 208. Das zweite facettierte optische Element 208 ist in der Ebene der gespiegelten Eintrittspupillen RE des Projektionsobjektives angeordnet. Aufgrund der negativen Schnittweite der Eintrittspupille des Projektionsobjektives 210 liegt die gespiegelte Eintrittspupille RE bildseitig von der Objektebene 212, in der beispielsweise das reflektive Retikel angeordnet ist. Die Objektebene ist mit 212 bezeichnet, die Bildebene mit 214, die optische Achse mit HA, der erste Spiegel mit S1, der zweite Spiegel mit S2, der dritte Spiegel mit S3, der vierte Spiegel mit S4, der fünfte Spiegel mit S5, der sechste Spiegel mit S6.

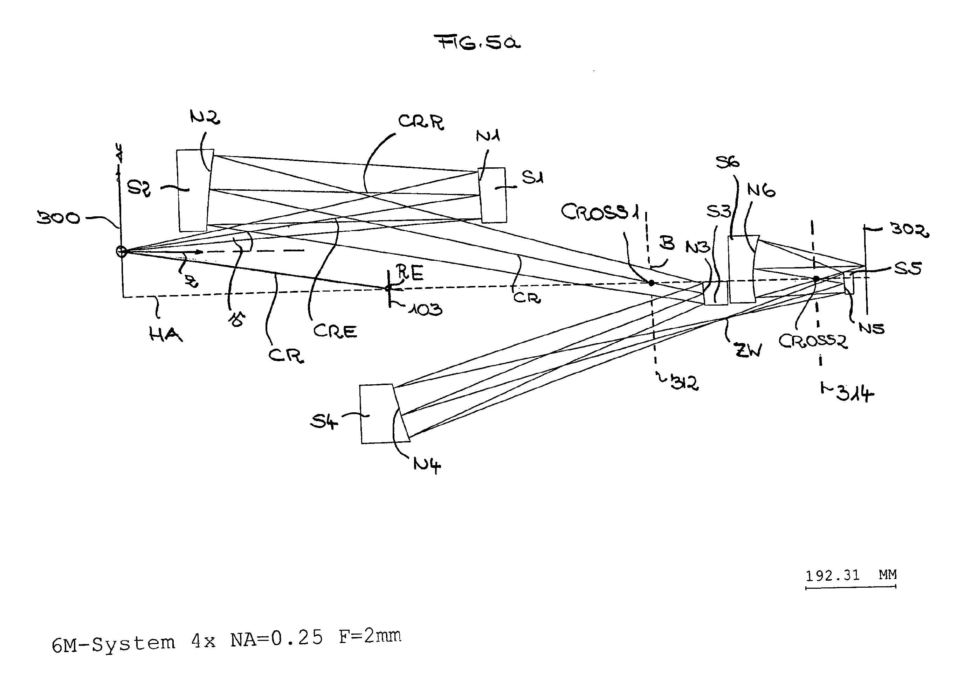

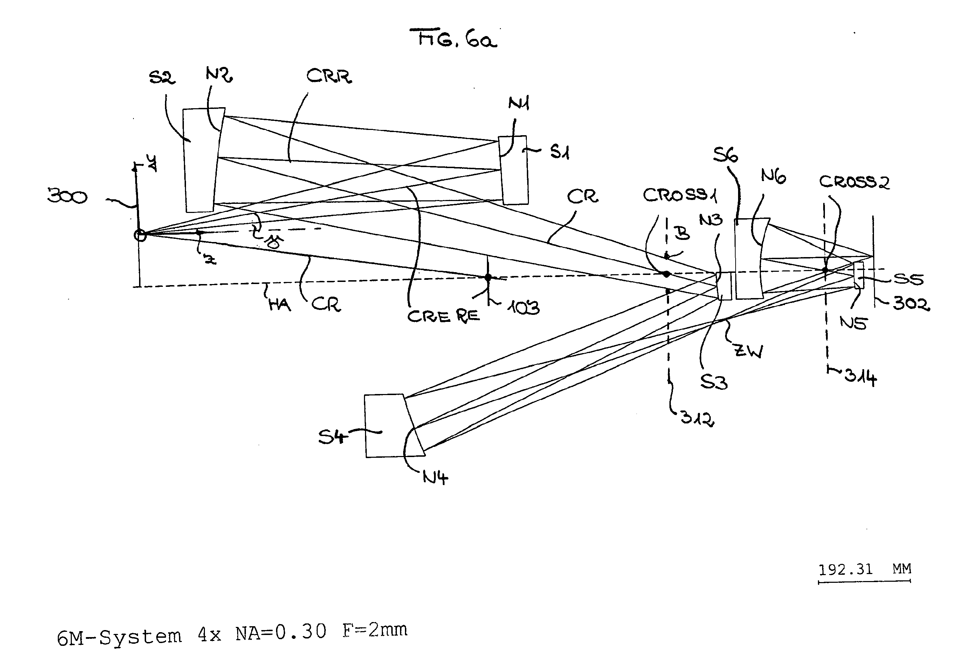

In den nachfolgenden Ausführungsbeispielen von Mikrolithographie-Projektionsobjektiven mit negativer Schnittweite der Eintrittspupille gemäß den Figuren 5a bis 5b und 6a bis 6d wird Raum in der Mikrolithographie-Projektionsbelichtungsanlage im Bereich der gespiegelten Eintrittspupille RE dadurch geschaffen, dass eine Strahlbündelkreuzung im vorderen Objektivteil vorgesehen ist. Der vordere Objektivteil ist der Teil des Projektionsobjektives, der diejenigen Spiegel umfasst, die am nächsten zur Objektebene angeordnet sind. Durch eine derartige Ausgestaltung kann insbesondere der zweite Spiegel S2 des in den Ausführungsbeispielen in Figur 5a und 6a gezeigten 6-Spiegel-Objektives mit einem großen Abstand zur optischen Achse HA des Projektionsobjektives angeordnet werden. Die Strahlüberkreuzung in der Meridionalebene, die die optische Achse HA des Projektionsobjektives enthält, findet bei den dargestellten Ausführungsbeispielen gemäß Figur 5a bis 5b und 6a bis 6d zwischen dem Strahlbündel, das von der Objektebene 300 zum ersten Spiegel S1 läuft und dem Strahlbündel, das vom zweiten Spiegel S2 zum dritten Spiegel S3 läuft, statt. Die Aperturblende B ist im Strahlengang vom zweiten Spiegel S2 zum dritten Spiegel S3 angeordnet. Aufgrund des großen Abstandes der Spiegel im vorderen Objektivteil zur optischen Achse ist es möglich, eine Mikrolithographie-Projektionsbelichtungsanlage zu konstruieren, bei der sich der Strahlengang des Beleuchtungssystems nicht mit dem Strahlengang des Projektionsobjektives in der Meridionalebene überkreuzt, so dass eine Trennung von Beleuchtungssystem und Projektionsobjektiv möglich ist, wie bspw. bei dem in Figur 4 gezeigten System.

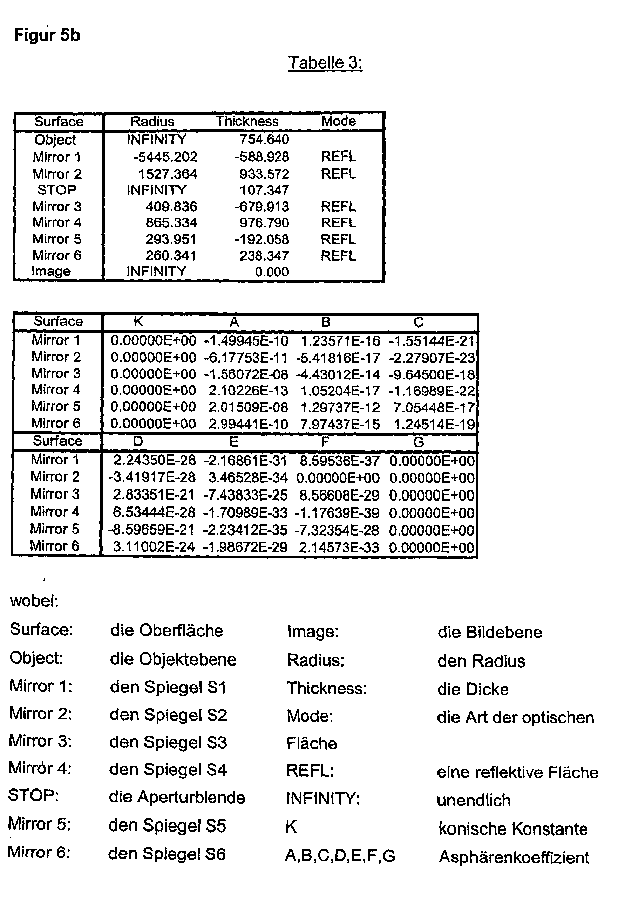

In dem in Figur 5a gezeigten Ausführungsbeispiel eines 6-Spiegel-Projektionsobjektives mit Strahlbündelüberkreuzung im vorderen Objektivteil wird ein Zwischenbild ZW zwischen dem vierten Spiegel S4 und fünften Spiegel S5 ausgebildet. Der erste Spiegel ist mit S1, der zweite Spiegel mit S2, der dritte Spiegel mit S3 sowie der im Lichtweg von der Objektebene 300 zur Bildebene 302 sechste Spiegel mit S6 bezeichnet. In Fig. 5a sind wie schon in den Fig. 2a und Fig. 3a lediglich die Nutzbereiche der jeweiligen Spiegel gezeigt. Hierbei bezeichnet N1 den Nutzbereich des ersten Spiegels S1, N2 den Nutzbereich des zweiten Spiegels S2, N3 den Nutzbereich des dritten Spiegels S3, N4 den Nutzbereich des vierten Spiegels S4, N5 den Nutzbereich des fünften Spiegels S5 und N6 den Nutzbereich des sechsten Spiegels S6. Der Nutzbereich eines Spiegels ist der Bereich, auf den die Strahlen des Lichtbüschels, die von der Objektebene zur Bildebene laufen, auftreffen. Das Ausführungsbeispiel gemäß Figur 5 hat eine bildseitige numerische Apertur von NA=0.25, eine Verkleinerung von 4x, und eine Feldgröße des Feldes in der Objektebene von 2 x 26mm$^2$, d. h. $D_y$=2 mm und $D_x$=26 mm. Der Hauptstrahlwinkel des mittleren Feldpunktes beträgt $\gamma$=7° am Objekt und der Abstand des mittleren Feldpunktes von der optischen Achse 93mm. Hieraus ergibt sich, dass die gespiegelte Eintrittspupille RE einen axialen Abstand von 757mm von der Objektebene besitzt. die Auflösung beträgt 22 nm, der bildseitige Wellenfronfehler RMS 0,006 $\lambda$, die bildseitige Feldkrümmung 1,5 nm, die Verzeichnung 6 nm. Die Spiegelabfolge ist PPNPNP, d. h. konkav - konkav - konvex - konkav - konvex - konkav. Im System werden zwei Ebenen, die konjugiert zur Eintrittspupille sind, sog. Pupillenebenen 312, 314 ausgebildet. Die Pupillenebene 312 umfasst den Schnittpunkt CROSS1 des Hauptstrahles CR mit der optischen Achse, die Pupillenebene 314 den Schnittpunkt CROSS2. Das Projektionsobjektiv ist bildseitig telezentrisch, so dass die Austrittspupille im Unendlichen liegt. Das System zeichnet sich dadurch aus, dass die Austrittspupille nicht obskuriert ist. Unter Austrittspupille versteht man das Bild der Aperturblende unter der Abbildung des nach der Aperturblende angeordneten Teilobjektivs. In einer Pupillenebene der beiden Pupillenebenen 312, 314, die zumindest von einer Seite des Projektionsobjektives zugänglich ist, ist eine zugängliche Aperturblende B angeordnet. Die Aperturblende B ist vorliegend zwischen dem zweiten und dritten Spiegel ausgebildet. Der maximale Spiegeldurchmesser, d. h. die maximale Abmessung $M_y$ für alle Spiegel im meridionalen Schnitt beträgt 157 mm, der maximale Spiegeldurchmesser, d. h. die maximale Abmessung $M_x$ für alle Spiegel in x-Richtung 389 mm. Der maximale Winkel $\Delta\Theta_{CR(max)}$ des Hauptstrahles zum zentralen Feldpunkt auf allen Spiegeln beträgt 16,4°, der maximale Einfallswinkel $\Theta_{max(max)}$ im meridionalen Schnitt auf allen Spiegeln beträgt 21°. Die maximale Winkelbandbreite $\Delta\Theta_{max}$ der Einfallswinkel auf jedem Spiegel beträgt für alle Spiegel im meridionalen Schnitt 17,3°.

Der Abstand zwischen Objekt- und Bildebene beträgt 1550mm.

In Tabelle 3 in Figur 5b sind die optischen Daten des Ausführungsbeispieles gemäß Figur 5a im Code V-Format zusammengestellt.

Figur 6a zeigt ein weiteres Ausführungsbeispiel eines erfindungsgemäßen 6-Spiegel-Projektionsobjektiv mit Zwischenbild und mit negativer Schnittweite der Eintrittspupille. Das Ausführungsbeispiel besitzt eine bildseitige numerische Apertur von NA=0.30, eine Verkleinerung 4x und eine Feldgröße von 2 x 26mm$^2$, d. h. $D_y$= 2mm, $D_x$=26 mm. Der Hauptstrahlwinkel $\gamma$ des mittleren Feldpunktes beträgt $\gamma$=8° am Objekt und der Abstand des mittleren Feldpunktes von der optischen Achse 106mm. Der Abstand zwischen Objekt 300 und Bildebene 302 beträgt 1520mm. Die gespiegelte Eintrittspupille RE besitzt einen axialen Abstand von 754mm von der Objektebene. Die Auflösung des Systems beträgt 18 nm, der bildseitige Wellenfrontfehler RMS 0,018 $\lambda$, die bildseitige Feldkrümmung 11 nm, die Verzeichnung 3,2 nm. Die Spiegelabfolge im Lichtweg der 6 Spiegel ist PPNPNP, d. h. konkav - konkav - konvex - konkav - konvex - konkav. Es werden im Lichtweg von der Objektebene zur Bildebene zwei Pupillenebenen ausgebildet, wovon eine Pupillenebene zugänglich ist. In der zugänglichen Pupillenebene wird die Aperturblende B angeordnet. Die Aperturblende B ist zwischen dem zweiten und dem dritten Spiegel ausgebildet. Der maximale Spiegeldurchmesser, d. h. die maximale Abmessung $M_y$ sämtlicher Spiegel im Projektionsobjektiv im meridionalen Schnitt beträgt 189 mm, der maximale Durchmesser, d. h. die maximale Abmessung $M_x$ für alle Spiegel in x-Richtung 423 nm, der maximale Einfallswinkel $\Theta_{CR(max)}$ des Hauptstrahles zum zentralen Feldpunkt für alle Spiegel des Systems beträgt 19°, der maximale Winkel $\Theta_{max(max)}$ für alle Spiegel im meridionalen Schnitt beträgt 24,1° und der maximale Winkelbereich $\Delta\Theta_{max}$ der Einfallswinkel für alle Spiegel 19,8°. Gleiche Bauteile wie in Figur 5a sind mit denselben Bezugsziffern belegt. Sowohl beim System gemäß Figur 5a wie beim System gemäß Figur 6a ist die räumliche Anordnung der Spiegel im vorderen Objektivteil entlang der optischen Achse HA wie folgt:

zweiter Spiegel S2 - vierter Spiegel S4 - erster Spiegel S1 - dritter Spiegel S3

Des Weiteren wird bei beiden Ausführungsbeispielen gemäß Figur 5a und 6a die Aperturblende B zwischen dem zweiten Spiegel S2 und dritten Spiegel S3 in oder nahe der Pupillenebene 312 ausgebildet.

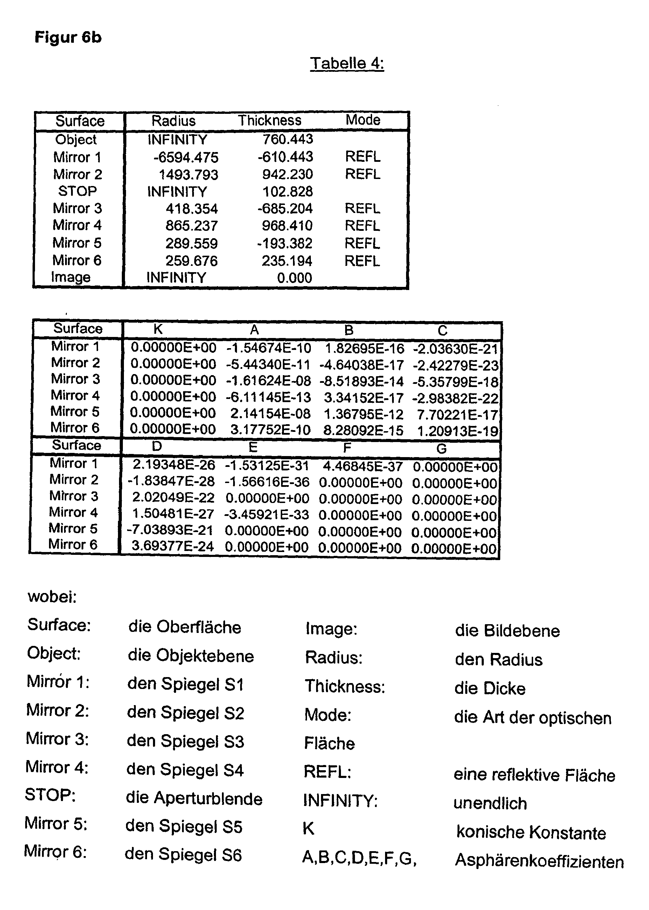

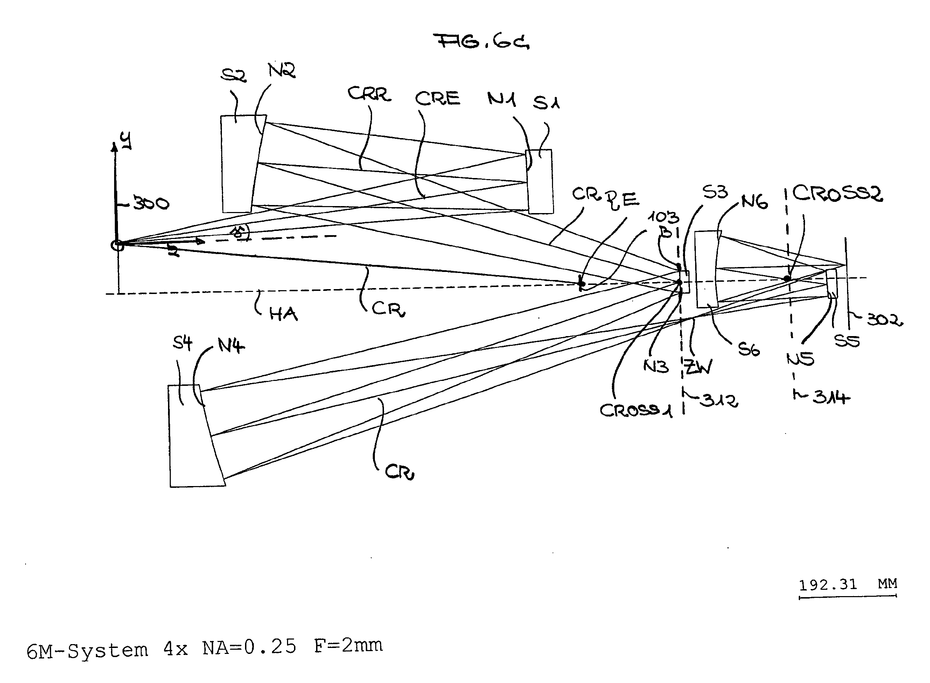

Die optischen Daten des Ausführungsbeispieles gemäß Figur 6a ergeben sich aus Tabelle 4 in Figur 6b im Code V-Format.

In Figur 6c ist ein alternatives Ausführungsbeispiel zu den Systemen gemäß Figur 5a und 6a gezeigt. Bei dem Ausführungsbeispiel gemäß Figur 6c liegt die Aperturblende B direkt auf dem dritten Spiegel S3 in der Pupillenebene 312. Durch die Blendenlage auf einem Spiegel müssen die vorbeilaufenden Strahlbündel nicht so stark räumlich separiert werden, wodurch entweder die Einfallswinkel verkleinert werden können, oder aber die Baulänge bei gleich bleibenden Einfallswinkeln reduziert werden kann, wie in vorliegendem Fall. Ein weiterer Vorteil des Systems gemäß Fig. 6c sind die kleinen Einfallswinkel auf allen Spiegeln. Die räumliche Anordnung der Spiegel im vorderen Objektivteil ist wie folgt:

vierter Spiegel S4 - zweiter Spiegel S2 - erster Spiegel S1 - dritter Spiegel S3, d.h. die Spiegel S2 und S4 sind verglichen mit dem Ausführungsbeispiel gemäß Figur 6a räumlich vertauscht entlang der optischen Achse HA.

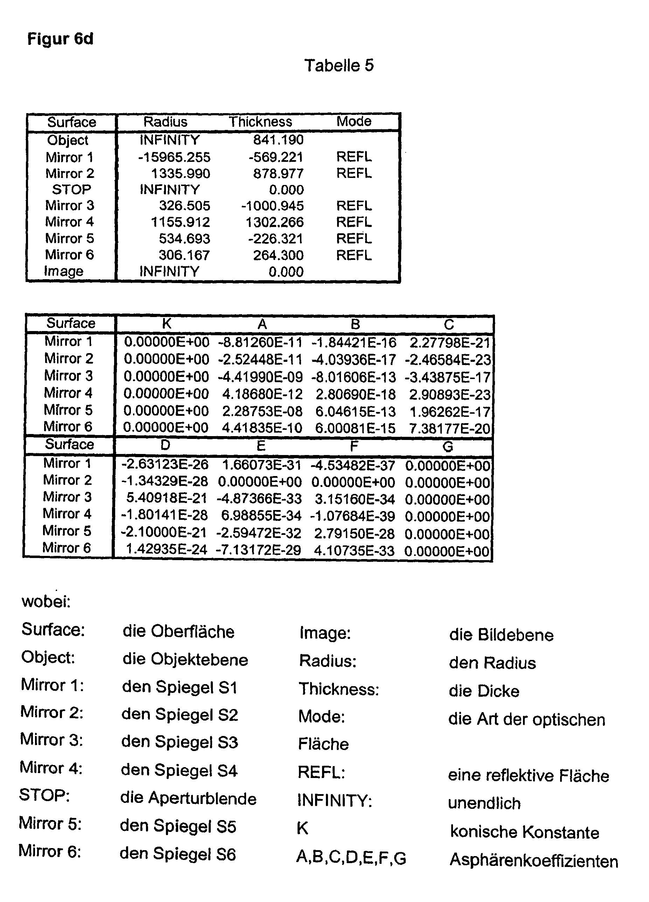

Figur 6c zeigt einen Linsenschnitt des zuvor beschriebenen Systems. Die optischen Daten für dieses System sind in Tabelle 5 in Figur 6d im Code-V-Format wiedergeben. Die bildseitige numerische Apertur des Systems beträgt NA=0.25 und die Feldgröße 2 x 26mm², wobei das Feld als Ringfeldsegment ausgelegt ist. Die Verkleinerung des Systems gemäß Figur 6c beträgt 4x, die bildseitige Auflösung 22 nm, der bildseitige Wellenfrontfehler RMS 0,019 λ, die bildseitige Feldkrümmung 20 nm sowie die Verzeichnung 0,8 nm. Die insgesamt sechs Spiegel weisen eine Spiegelabfolge PPNPNP, d. h. konkav - konkav - konvex - konkav - konvex - konkav auf. Insgesamt weist das System zwei Pupillenebenen 312, 314 auf, wovon eine zugänglich ist. Die zugängliche Pupillenebene ist zugleich die Ebene, in der die Aperturblende B angeordnet ist. Die Aperturblende B ist auf dem dritten Spiegel angeordnet. Die Entfernung zwischen der Objektebene 100 und der Bildebene 102 beträgt 1490 mm, der maximale Spiegeldurchmesser, d. h. die Abmessung $M_y$ in meridionaler Richtung für alle Spiegel beträgt 197 mm, der maximale Spiegeldurchmesser in x-Richtung, d. h. die maximale Abmessung $M_x$ für alle Spiegel beträgt 464 mm, der maximale Einfallswinkel $\Theta_{CR(max)}$ des Hauptstrahles im zentralen Feldpunkt beträgt für alle Spiegel 16,6°, der maximale Einfallswinkel $\Theta_{max(max)}$ aller Strahlen für alle Spiegeln im Meridionalschnitt beträgt 19,2° und der maximale Winkelbereich $\Delta\Theta_{max}$ der Einfallswinkel für alle Spiegel im meridionalen Schnitt 16,7°.

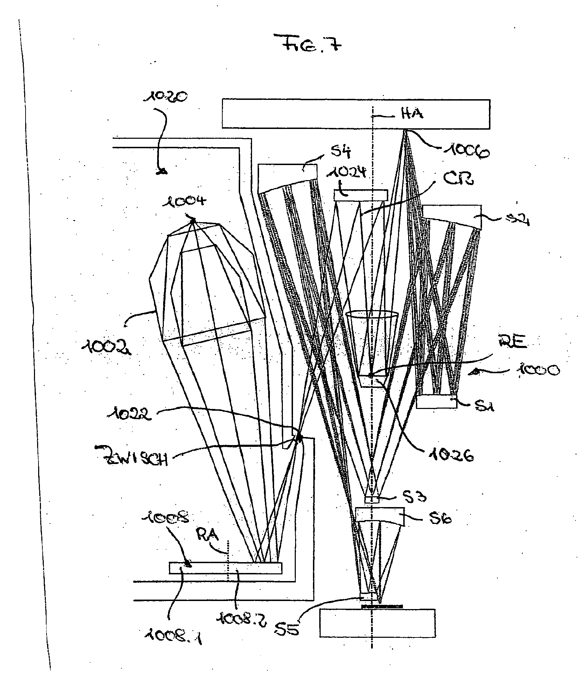

In nachfolgenden Figuren 7 bis 13 sind vorteilhafte Ausgestaltungen von Mikrolithographie-Projektionsbelichtungsanlagen gezeigt, bei denen Projektionsobjektive mit negativer Schnittweite der Eintrittspupille, wie in der vorliegenden Anmeldung offenbart, oder auch in der US 2005/0088760 dargestellt, verwandt werden können.

Bei den bislang bekannten Beleuchtungssystemen weisen die Projektionsobjektive meist eine positive Schnittweite der Eintrittspupille auf. Die optischen Elemente, wie bspw. ein holographischer Diffusor oder aber auch eine zweite facettierte optische Komponente eines Beleuchtungssystems, das doppelt facettiert ausgebildet ist, können bei Projektionssystemen mit Projektionsobjektiven mit positiver Schnittweite nicht in der Eintrittspupille des Projektionsobjektivs platziert werden, sondern werden mit Hilfe von optischen Elementen in eine Eintrittspupille die im Lichtweg von einer Lichtquelle zu einer Bildebene nach der Objektebene, abgebildet.

Bei einer negativen Schnittweite der Eintrittspupille des Projektionsobjektives kommt die gespiegelte Eintrittspupille bildseitig von der Objektebene, in der bspw. das reflektive Retikel angeordnet ist, zu liegen. Bei diesen Systemen kann ein optischer Integrator, bspw. ein Diffusor oder aber der Pupillenfacettenspiegel bei einem doppelt facettierten Beleuchtungssystem in oder nahe der gespiegelten Eintrittspupille RE angeordnet werden.

Eine erste Ausführungsform eines derartigen Systems ist in Figur 7 dargestellt. Das System gemäß Figur 7 umfasst ein Projektionsobjektiv 1000 mit einem ersten Spiegel S1, einem zweiten Spiegel S2, einem dritten Spiegel S3, einem vierten Spiegel S4 sowie einem fünften Spiegel S5, sowie einem sechsten Spiegel S6 mit negativer Schnittweite. Das Beleuchtungssystem umfasst des Weiteren einen im Strahlengang der Lichtquelle nachgeordneten genesteten grazing-incidence-Kollektor 1002, der die Strahlung der Lichtquelle 1004 in einem Halbraum mit einer großen Apertur NA ≥ 0,7 aufnimmt. Der dargestellte Kollektor umfasst in der schematischen Skizze lediglich zwei um eine Rotationsachse rotationssymmetrische Spiegelschalen, wobei an jeder Schale zwei Reflektionen auftreten. Selbstverständlich wäre auch ein Kollektor mit mehr als 2 Schalen und mit mehr als zwei Reflektionen pro Schale denkbar. Bei den in Figur 7 gezeigten Ausführungsbeispiel ist im Strahlengang von der Lichtquelle 1004 zur Objektebene 1006 ein Normal-incidence-Spiegel 1008 angeordnet, der aufgrund seiner Beschichtung mit Vielfachschichten, bspw. 40 bis 70 Mo/Si-Schichten als schmalbandiger Wellenlängenfilter wirkt. Die Verwendung eines normal-incidence-Spiegels der durch eine Vielfachschicht bzw. Multilayer-Beschichtung als schmalbandiger Wellenlängenfilter wirkt, ist bekannt. Ein derartiger Spiegel kann in den unterschiedlichen Positionen verfahren werden, so dass unterschiedliche Nutzbereiche 1008.1 sowie 1008.2 in den Strahlengang verbracht werden können. Im vorliegenden Ausführungsbeispiel erfolgt das Verfahren in die jeweilige Stellung durch Drehen um die Rotationsachse RA. Der aus dem Strahlengang herausgebrachte Bereich des Multilayer-Spiegels 1008 kann dann bspw. mit Hilfe einer Reinigungsvorrichtung gereinigt werden. Zusätzlich kann auf den jeweiligen Nutzbereich 1008.1, 1008.2 des normal-incidence Multilayer-Spiegel 1008 ein Gitterspektralfilter aufgebracht sein. Bei dem bekannten Spektralfilter wird Licht, das nicht der Nutzwellenlänge entspricht, dadurch gefiltert, dass das Licht der Lichtquelle auf ein Gitter trifft, das wenigstens eine Gitterperiode in einer Gitterebene aufweist, die wesentlich größer als die Nutzwellenlängen ist, bevorzugt 150 bis 200 mal größer als die Nutzwellenlänge. Liegt die Nutzwellenlänge bspw. bei 13,5 nm, so liegt die Periodizität eines binären Gitters, das als derartiger Spektralfilter wirkt, im µm-Bereich.

Im Lichtweg von der Lichtquelle zum ersten facettierten Element wird in der dargestellten Ausführungsform im Beleuchtungsstrahlengang ein erstes Zwischenbild IMI ausgebildet. Die im Beleuchtungsstrahlengang vor dem Zwischenbild IMI liegenden optischen Komponenten, Lichtquelle 1004, Kollektor 1002 sowie normal-incidence-Spiegel 1008 sind in einem ersten Raum 1020 zusammengefasst. Dieser erste Raum 1020 ist gegenüber den übrigen Komponenten durch eine Abschirmung, abgetrennt. Einzige Öffnung ist die als Aperturblende ausgebildete Öffnung 1022, in der im Wesentlichen das Zwischenbild IMI zu Liegen kommt. Die erste facettierte optische Komponente umfasst einen Spiegel, den sog. Feldfacettenspiegel 1024, mit einer Vielzahl von Feldfacetten, die in vorliegendem Ausführungsbeispiel dieselbe Form aufweisen, wie das auszuleuchtende Feld in der Objektebene. Die Feldfacetten sind daher bogenförmig ausgebildet. Der Feldfacettenspiegel 1024 kann zum Einstellen des Beleuchtungssettings optional gegen einen anderen Feldfacettenspiegel ausgetauscht werden. Eine Möglichkeit wie bspw. ein Facettenspiegel gegen einen anderen getauscht werden kann, besteht darin Feldfacettenspiegel mit unterschiedlicher Facettenanordnung auf einem um eine Achse drehbaren Bauteil aufzubringen.

Der Feldfacettenspiegel 1024 zerlegt das auf ihn einfallende Lichtbüschel in eine Vielzahl von Lichtbüscheln, die den einzelnen Feldfacetten zugeordnet sind. Jedes einer Feldfacette zugeordnete Lichtbüschel bildet eine sekundäre Lichtquelle aus. Am Ort der sekundären Lichtquelle oder nahe diesem Ort ist das zweite facettierte optische Element in oder nahe der Ebene, in der die gespiegelte Eintrittspupille RE des Projektionsobjektives zu liegen kommt, angeordnet. Das zweite facettierte optische Element wird auch als Pupillenfacettenspiegel 1026 bezeichnet und die auf ihm angeordneten Rasterelemente als Pupillenfacetten. Wie der Feldfacettenspiegel umfasst auch der Pupillenfacettenspiegel 1026 200 bis 300 facettierte Elemente, hier Pupillenfacetten. Die einzelnen Pupillenfacetten können zur Settingeinstellung schaltbar ausgebildet sein. In dem nicht genutzten Bereich kann der Pupillenfacettenspiegel mit Aussparungen versehen sein, so dass der Strahlengang im Projektionsobjektiv nicht behindert wird. Um Streulicht zu unterdrücken und vom Eintritt in das Projektionsobjektiv abzuhalten, ist oberhalb des Facettenspiegels eine Abschirmung 1030 angebracht. Alternativ zu einer Settingeinstellung mit Hilfe einer Veränderung der Kanalzuordnung kann vor dem Pupillenfacettenspiegel auch eine Blende eingebracht werden, die allerdings in vorliegender Ausführungsform nicht dargestellt ist.

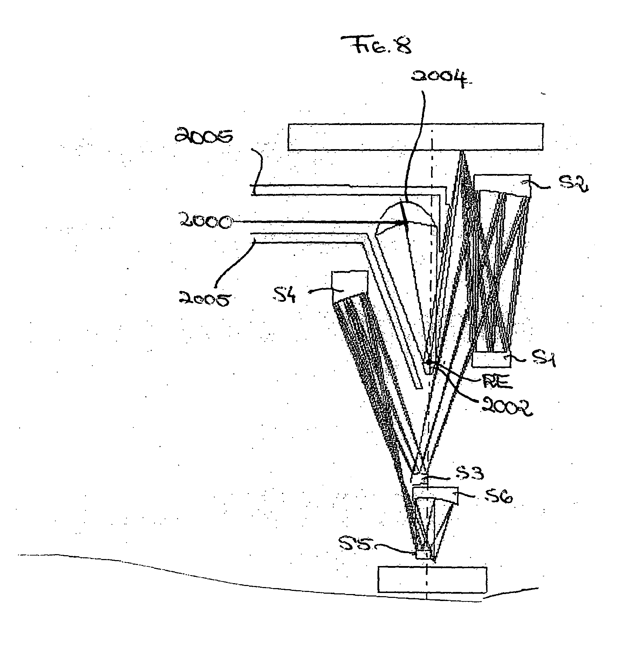

Figur 8 zeigt eine alternative Ausgestaltung eines Beleuchtungssystems bei dem der optische Integrator als Diffusor, ausgebildet ist. Die Lichtquelle in Figur 8 ist mit Bezugsziffer 2000 gekennzeichnet. Bei der Lichtquelle 2000 handelt es sich in diesem Beispiel um eine Laser-Plasma-Quelle mit einem horizontalen Pumpstrahl. Um die rückwärtig abgestrahlte Strahlung der Strahlungsquelle zu sammeln ist ein normal-incidence-Kollektorspiegel 2004 vorgesehen, der als Rotations-Ellipsoid ausgebildet sein kann. Alternativ ist es möglich, das Licht mit mehr als einem Kollektor zu sammeln, bspw. einem Doppelkollektor. Bei einem Doppelkollektorsystem handelt es sich um ein schiefspiegeliges normal-incidence Kollektorsystem mit zwei normal-incidence Kollektorspiegeln. Auf dem Ellipsoid des Kollektors kann ein Gitterspektralfilter, integriert sein.

Der Diffusor 2002 ist in der Regel als Diffusorspiegel mit 500 bis 1000 kleinen Spiegelfacetten ausgebildet oder alternativ als ein holographisches Gitter.

Das Beleuchtungssystem ist wie Figur 8 zeigt, sehr kompakt aufgebaut, und besteht lediglich aus der Lichtquelle 2000, dem Kollektor 2004 sowie dem Diffusor 2002. Um das Beleuchtungssystem vom Projektionsobjektiv mit negativer Schnittweite der Eintrittspupille, sind Abschirmungen, die bevorzugt als kühlbare Schutzschilder ausgebildet sein können, in die Mikrolithographie-Projektionsbelichtungsanlage eingebracht. Die Abschirmung ist mit 2005 bezeichnet. Das Projektionsobjektiv ist ein 6-Spiegel-Projektionsobjektiv mit einem, ersten Spiegel S1, einem zweiten Spiegel S2, einem dritten Spiegel S3, einem vierten Spiegel S4, einem fünften Spiegel S5 sowie einem sechsten Spiegel S6. Der Diffusor 2002 als optischer Integrator bei dem in Figur 8 gezeigten System ist wiederum in oder nahe der gespiegelten Eintrittspupille RE des Projektionsobjektives angeordnet. Aufgrund des begrenzten Bauraums und der Ausbreitungswinkel ist es bei den Systemen gemäß Figur 7 und 8 nicht möglich, ein Setting mit σ>1 zu ermöglichen.

Das System gemäß Figur 8 umfasst nur 8 Spiegel im Lichtweg von der Lichtquelle zur Bildebene des Projektionsobjektives, in der das zu belichtende Objekt, bspw. ein Wafer angeordnet ist. Bei der Spiegelzahl für das System gemäß Figur 8 wurde jedoch das reflektive Retikel in der Objektebene nicht berücksichtigt. Bei dem System gemäß Figur 8 kann der Kollektor 2004 alternativ bspw. durch einen anderen Kollektor, bspw. einen grazing-incidence-Kollektor ersetzt werden. Selbst bei einem derartigen System mit einem grazing-incidence-Kollektor kann eine EUV-Projektionsbelichtungsanlage mit neun Spiegeln oder weniger angegeben werden, wobei eine bildseitige numerische Apertur von NA ≥ 0,25, bevorzugt NA ≥ 0,3 bei einer Feldgröße von 2 x 26mm² möglich ist.

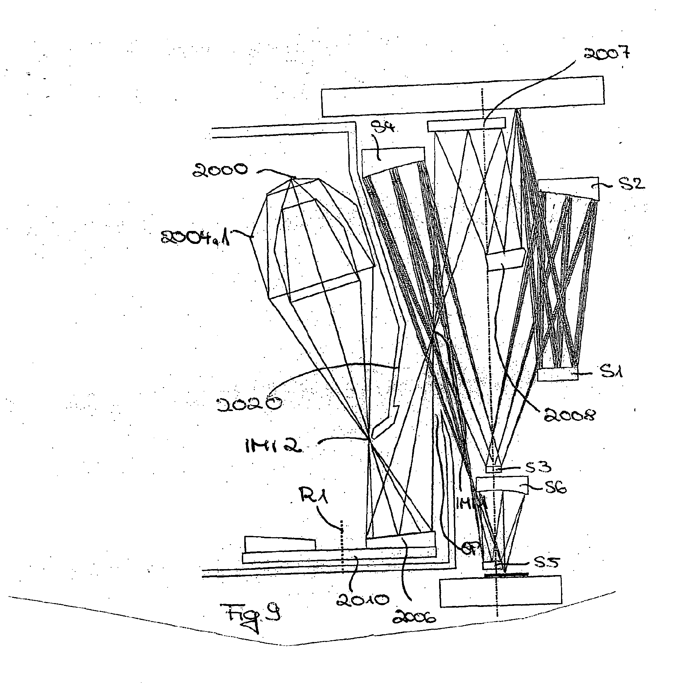

Um ein Setting mit σ>1 zu ermöglichen, ist es vorteilhaft, den Strahlengang im Beleuchtungssystem zu falten, bspw. mit Hilfe eines Planspiegels. Dies ist bei dem System in Fig. 9 gezeigt. Gleiche Bauteile sind mit denselben Bezugsziffern belegt. Mit Hilfe des Spiegels 2008 wird der Strahlengang von dem zweiten optischen Element 2007 mit zweiten Rasterelementen (nicht gezeigt) zum in der Objektebene 2009 angeordneten Retikel gefaltet und erlaubt so die Anordnung des ersten optischen Elements 2006 mit ersten Rasterelementen, d. h. den Feldfacettenspiegel in einem leicht zugänglichen Bauraum. Der Feldfacettenspiegel kann auf einer um eine Rotationsachse R1 drehbaren Träger 2010 angeordnet sein, der verschiedene Feldfacettenspiegel umfasst. Der drehbare Träger kann dazu dienen, Facettenspiegel gleicher Ausgestaltung auszutauschen, um den ausgetauschten Spiegel bei Vorliegen von Verschmutzungen zu reinigen. Alternativ können aber auch unterschiedliche Facettenspiegel, d. h. Facettenspiegel mit einer unterschiedlichen Anordnung von Rasterelementen auf dem Trägerelement des Facettenspiegels vorliegen, so dass durch Verdrehen um die Achse R1 unterschiedliche Settingeinstellungen realisiert werden können. Auch Kombinationen sind möglich.

Der Faltspiegel 2008 kann optional Brechkraft aufweisen. In dem in Figur 9 gezeigten System sind die Feldfacetten den jeweiligen Pupillenfacetten über Kreuz zugeordnet. Das heißt eine im Meridionalschnitt wie in Figur 9 gezeigte im rechten Teil des Feldfacettenspiegels angeordnete Feldfacette wird eine im Meridionalschnitt linken Teil angeordnete Pupillenfacette zugeordnet. Durch diese überkreuzte Zuordnung ergibt sich eine Einschnürung des Strahlenganges bzw. ein Zwischenbild IMI1 der Lichtquelle im Lichtweg vom ersten facettierten optischen Element zum zweiten facettierten optischen Element. Die Einschnürung bzw. das Zwischenbild IMI1 erlaubt es eine begrenzte Durchtrittsöffnung OP wie in Figur 9 dargestellt zwischen der Einheit, die die Lichtquelle 2000, den Kollektor 2004.1 und das erste facettierte optische Element 2006 umfasst, der Einheit, die das Projektionsobjektiv umfasst, in einer Schutzwand 2020. Desweiteren wird auch in der Einheit, die die Lichtquelle 2000, den Kollektor 2004.1 und das erste facettierte optische Element 2006 umfasst ein Zwischenbild IMI2 der Lichtquelle ausgebildet.

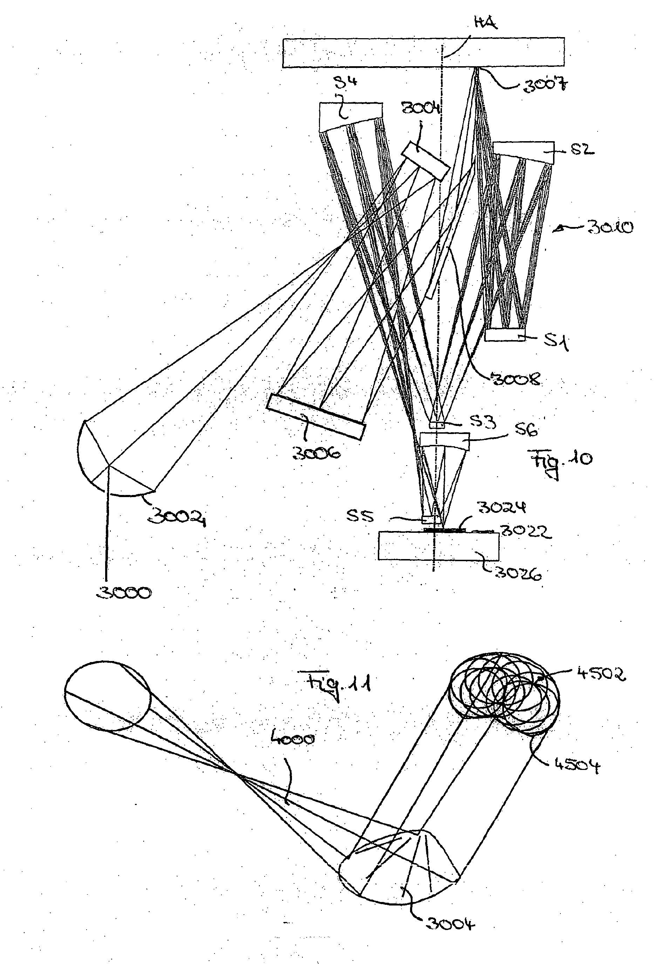

In Figur 10 ist eine weitere Ausführungsform einer Mikrolithographie-Projektionsbelichtungsanlage insbesondere für EUV-Wellenlängen gezeigt, bei der der optische Integrator nicht in der gespiegelten Eintrittspupillenebene angeordnet ist.

Das Beleuchtungssystem dieser Mikrolithographie-Projektionsbelichtungsanlage umfasst einen ortsvarianten Diffusor 3006. Dieser Diffusor 3006 ist derart ausgelegt, dass er nicht in der Ebene der gespiegelten Eintrittspupille oder einer hierzu konjugierten Ebene angeordnet sein muss, sondern in nahezu jeder beliebigen Ebene angeordnet sein kann. Der Diffusor weist eine Vielzahl von einzelnen Spiegelfacetten, bevorzugt mehr als 1000 Spiegelfacetten auf, die in Abhängigkeit vom Ort, an dem der Diffusor im Beleuchtungssystem angeordnet wird, solche Ablenkwinkel aufweisen, dass jede Facette Licht von der Lichtquelle aufnimmt und auf einen zugeordneten, diskreten Punkt eines in der Objektebene 3007 des Beleuchtungssystems ausgebildeten Feldes (nicht dargestellt) lenkt. Die diskreten Punkte in der Objektebene 3007 sind derart gewählt, dass ein Feld in der Objektebene 3007 in einer vorbestimmten Form, bspw. in einer bogenförmigen Form ausgeleuchtet wird. Des Weiteren ist die Facette so angeordnet, dass sie mit den jeweils zugeordneten diskreten Punkt im in der Objektebene ausgebildeten Feld einen bestimmten Bereich in einer Pupillenebene des Projektionsobjektives ausleuchtet.

Der Diffusor 3006 wird auch als sog. spekularer Reflektor bezeichnet. Dieser zeichnet sich insbesondere dadurch aus, dass die Facetten unterschiedliche Größe und Position haben sowie unterschiedliche Neigungswinkel, wobei die Neigungswinkel durch den jeweils zugeordneten Feldpunkt definiert sind. Bevorzugt weist der spekulare Reflektor eine im Wesentlichen ähnliche Form auf, wie das auszuleuchtende Feld. Bei einem auszuleuchtenden bogenförmigen Feld hat der spekulare Reflektor eine nierenförmige Form.

Aufgrund der beliebigen Anordnung des ortsvarianten Diffusors 3006 kann bei der Auslegung des Beleuchtungssystems daher eine optimale Position des Diffusors 3006 unabhängig von der restlichen Systemauslegung gewählt werden. Bevorzugt wird der Diffusor so angeordnet, dass das System optimal ausgelegt ist und der Diffusor eine optimale Größe aufweist. Ein System mit ortsvariantem Diffusor 3006 ist in Figur 10 dargestellt. Das System gemäß Figur 10 umfasst eine Lichtquelle 3000. Das Licht der Lichtquelle wird über einen Kollektorspiegel 3002 gesammelt und auf einen Faltspiegel 3004 gelenkt. Der Faltspiegel 3004 ist notwendig, um den Strahlengang des Beleuchtungssystems von demjenigen der Projektionsoptik zu trennen. Das auf den Spiegel 3004 auftreffende Licht wird reflektiert und trifft auf den ortsvarianten Diffusor 3006 auf. Im Gegensatz zu den zuvor gezeigten Systemen ist der ortsvariante Diffusor 3006 in einer beliebigen Ebene angeordnet, also weder in einer gespiegelten Eintrittspupillenebene oder einer hierzu konjugierten Ebene noch in einer Feldebene bzw. Objektebene oder einer hierzu konjugierten Ebene.

Im Strahlengang von der Lichtquelle 3000 zum Diffusor ist dem ortsvarianten Diffusor 3006 der normal-incidence-Spiegel 3004 vorangestellt, der wie in den zuvor beschriebenen Ausführungsbeispielen die Aufgabe hat, eine Filterwirkung für das auf den ortsvarianten Diffusor auftreffende Licht zu übernehmen. Aufgrund dieser Filterwirkung kommt auf dem ortsvarianten Diffusor nur noch Nutzstrahlung, bspw. EUV-Licht mit einer Wellenlängen von 13,5 nm an. Hierdurch wird die Strahlenbelastung auf dem Diffusor 3006 minimiert, was eine geringere Termallast und eine geringere Kontamination zur Folge hat.

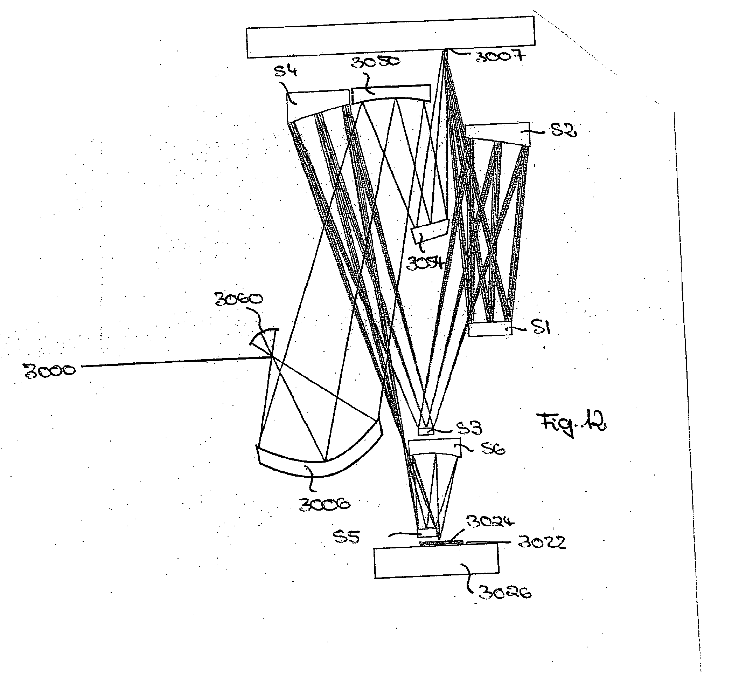

Bevorzugt kann der normal-incidence-Spiegel 3004 als Freiformfläche mit einem außeraxialen konischen Anteil ausgebildet sein. Die Wirkung eines derartigen normal-incidence-Spiegels ist in Figur 11 dargestellt. Wie aus Figur 11 zu entnehmen ist, wird durch die Ausbildung des normal-incidence-Spiegels als Freiformfläche bspw. mit einem außeraxialen konischen Anteil, der nierenförmig auszulegende ortsvariante Diffusor 3006 nierenförmig und somit weitgehend verlustfrei ausgeleuchtet.

In Figur 11 ist das von der Lichtquelle her einfallende Lichtbüschel mit 4000 bezeichnet. Das Lichtbüschel 4000 fällt auf den in Figur 11 dreidimensional dargestellten normal-incidence-Spiegel 3004 mit konischen Anteil und wird von diesem reflektiert. Die sich aufgrund dieser Reflektion ergebende Ausleuchtung der Ebene, in der der ortsvariante Reflektor angeordnet ist, ist mit 4502 gekennzeichnet. Wie deutlich in Figur 11 zu erkennen ist, ist die Ausleuchtung in der Ebene, in der der ortsvariante Diffusor angeordnet ist, nierenförmig und besteht aus versetzten Subpupillen 4504.

Alternativ zu einem normal-incidence-Spiegel kann eine weitgehend nierenförmige Ausleuchtung auch mit einem grazing-incidence-Spiegel erreicht werden, bspw. einer Schale eines grazing-incidence-Kollektors.

Des Weiteren kann der normal-incidence-Spiegel zusätzlich zur Formung der Ausleuchtung auch noch eine optische Wirkung aufweisen. Die optische Wirkung kann dadurch erreicht werden, dass zusätzlich zum konischen Anteil ein sphärischer, torischer oder allgemein asphärischer Anteil hinzukommt, um dem Spiegel Brechkraft zu verleihen.

Beim System gemäß Figur 10 wird das Licht des Diffusors 3006 mittels eines grazing-incidence-Spiegels 3008 in die Objektebene 3007 gelenkt. Das Objekt in der Objektebene wird mittels des Projektionsobjektives 3010 mit sechs Spiegeln S1, S2, S3, S4, S5 und S6 in die Bildebene 3022 gelenkt, in der das zu belichtende Objekt, beispielsweise der Wafer 3024 auf einem Träger 3026 angeordnet ist. Das Projektionsobjektiv 3010 mit negativer Schnittweite weist eine optische Achse HA auf.

Bei dem System gemäß Figur 10 wird eine Projektionsbelichtungsanlage zur Verfügung gestellt, die ein Feld mit einer Größe von 26 x 2 mm mit einer bildseitigen numerischen Apertur $\geq 0,25$, bevorzugt NA $\geq 0,3$ ausleuchtet. Die Projektionsbelichtungsanlage besitzt weniger oder maximal 10 Komponenten, an denen normal-incidence-Reflektionen auftreten.

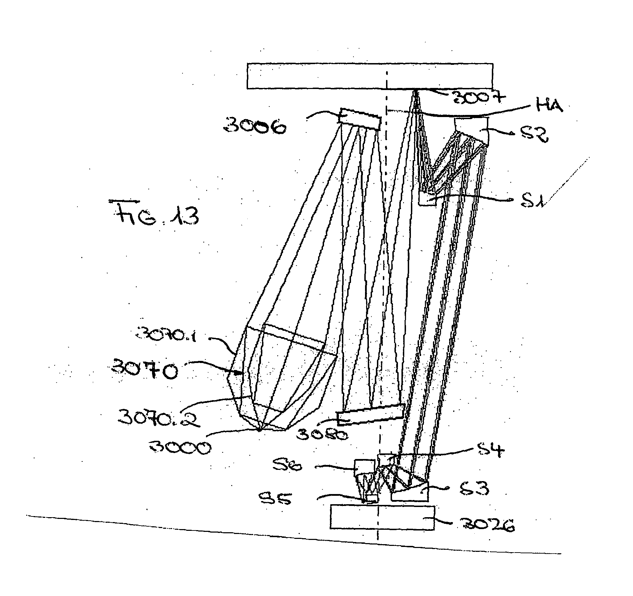

In den Figuren 12 und 13 sind alternative Ausgestaltungen einer Mikrolithographie-Projektionsbelichtungsanlage mit einem ortsvarianten Diffusor im Beleuchtungssystem dargestellt.

Bei der Ausführungsform gemäß Figur 12 ist dem ortsvarianten Diffusor 3006 ein sammelnder normal-incidence-Spiegel im Strahlengang nachgeordnet. Gleiche Bauteile wie in Figur 10 sind mit denselben Bezugsziffern belegt. Das Einbringen des normal-incidence-Spiegels 3050 im Lichtweg von einer Lichtquelle zu einer Bildebene nach dem ortsvarianten Diffusor hat insbesondere den Vorteil, dass die einzelnen Facetten des ortsvarianten Diffusors als Planspiegel ausgelegt werden können. Der sammelnde normal-incidence-Spiegel 3050 bildet die Lichtquelle 3000 in die Objektebene 3007, in der das Retikel angeordnet ist, stark vergrößernd ab, wohingegen der ortsvariante Diffusor eine Überlagerung einer Vielzahl von Quellbildern der Objektebene 3007 sorgt. Dem normal-incidence-Spiegel 3050 mit Brechkraft ist in dem dargestellten Ausführungsbeispiel ein weiterer Spiegel 3054 im Lichtweg nachgeordnet, der als Planspiegel ausgebildet ist. Dieser Spiegel 3054 dient der Faltung des Strahlenganges. Alternativ könnte auch der zweite Normal-incidence-Spiegel 3054 mit Brechkraft versehen sein, so dass in Kombination mit dem ersten normal-incidence-Spiegel 3050 der Abbildungsmaßstab gezielt eingestellt und somit die Größe des ortsvarianten Diffusors beeinflusst werden kann. Dies ermöglicht es, den ortsvarianten Diffusor 3006 sehr groß auszulegen, so dass auch die einzelnen Facettenelemente auf dem ortsvarianten Diffusor eine gewisse Größe haben. Durch die Größe des ortsvarianten Diffusors 3006 und der einzelnen hierauf angeordneten Facetten kann die Thermallast wie zuvor bereits beschrieben stark reduziert werden. Der ortsvariante Diffusor kann auch auf einem gekrümmten Tragkörper ausgebildet werden.

In dem in Figur 12 gezeigten Ausführungsbeispiel eines Systems mit einem ortsvarianten Diffusor ist zum Sammeln des Lichtes der Lichtquelle 3000 ein Rückreflektor 3060 vorgesehen, der derart gestaltet ist, dass ein nierenförmiges Gebiet auf dem ortsvarianten Diffusor 3006 ausgeleuchtet wird. Der Rückreflektor übernimmt anstelle des im Ausführungsbeispiel gemäß Figur 10 und 11 dargestellten normal-incidence-Spiegels mit einer Freiformfläche mit außeraxialem konischem Anteil die weitgehend bogenförmige Ausleuchtung des ortsvarianten Diffusors 3006.

Ein ganz besonders einfaches Beleuchtungssystem mit einem ortsvarianten Diffusor zeigt das Ausführungsbeispiel gemäß Figur 13. Gleiche Bauteile wie in den Figuren 10 - 12 sind mit denselben Bezugsziffern belegt. Beim Ausführungsbeispiel gemäß Figur 13 wird das Licht der Lichtquelle von einem grazing-incidence-Kollektor 3070 mit einer Vielzahl von Spiegelschalen 3070.1, 3070.2 gesammelt. Das von grazing-incidence-Kollektor aufgenommene Licht wird auf einen direkt vor der Objektebene 3007 angeordneten ortsvarianten Diffusor 3006 geleitet. Mittels eines Spiegels 3080 wird das vom ortsvarianten Diffusor 3006 reflektierte Licht in die Objektebene 3007 reflektiert. Durch das Einbringen eines Spiegels 3080 mit dem das von dem Diffusor 3006 reflektierte Licht in die Objektebene 3007 zurückgefaltet wird, kann die geometrische Effizienz des Systems stark erhöht werden. Die in Figur 13 dargestellte Ausführungsform zeichnet sich insbesondere dadurch aus, dass sie sehr einfach aufgebaut ist und kein Zwischenbild im Beleuchtungsstrahlengang des Beleuchtungssystems aufweist.

Sowohl bei dem Projektionsobjektiv gemäß Figur 12 wie Figur 13 wird ein Objektiv mit negativer Schnittweite der Eintrittspupille und sechs Spiegeln S1, S2, S3, S4, S5, S6 eingesetzt.

Mit der Erfindung wird erstmals ein Projektionsobjektiv mit negativer Schnittweite der Eintrittspupille zur Verfügung gestellt, dass derart aufgebaut ist, das in einer Mikrolithographie-Projektionsbelichtungsanlage eine Überkreuzung von Beleuchtungsstrahlengang und Abbildungsstrahlenganges weitgehend vermieden wird. Dies wiederum ermöglicht dann einen modularen Aufbau des Mikrolithographie-Projektionssystems.

Neben den Mikrolithographie-Projektionssystemen mit negativer Schnittweite der Eintrittspupille, die einen derartigen modularen Aufbau ermöglichen, stellt die Erfindung auch Mikrolithographie-Projektionssysteme zur Verfügung, mit einer geringen Anzahl optischer Komponenten und einer bildseitigen numerischen Apertur NA $\geq 0,25$, bevorzugt NA $\geq 0,3$ bei einer maximalen Dimension ($D_x$, $D_y$) eines bildseitigen Feldes von mehr als 1 mm, insbesondere mehr als 3 mm, bevorzugt mehr als 4 mm, insbesondere mehr als 5 mm, besonders bevorzugt mehr als 6 mm, insbesondere bevorzugt mehr als 8 mm, insbesondere bevorzugt mehr als 10 mm, insbesondere bevorzugt mehr als 12 mm, insbesondere bevorzugt mehr als 15 mm, insbesondere bevorzugt mehr als 20 mm, ganz besonders bevorzugt mehr als 25 mm. Bevorzugt weist ein derartiges System 10 oder weniger Reflektionen an optischen Elementen in normal-incidence zwischen der Lichtquelle und der Bildebene auf, wobei die Reflektion am in der Objektebene angeordneten reflektiven Objekt, insbesondere dem reflektiven Retikel nicht mitgerechnet wird. Die Größe des Bildfeldes kann bspw. 2 x 26 mm$^2$ betragen. Insbesondere vorteilhaft sind in diesem Zusammenhang Mikrolithogarphie-Projektionssysteme, bei denen lediglich ein optischer Integrator notwendig ist. Bei Systemen mit nur einem optischen Integrator sind von ganz besonderem Vorteil solche Systeme, die sich dadurch auszeichnen, dass der optische Integrator an einem beliebigen Ort in der Mikrolithographie-Projektionsbelichtungsanlage platziert werden kann. Optische Integratoren die diese Anforderungen erfüllen, sind insbesondere sog. ortsvariante optische Integratoren oder spekulare Reflektoren.

**Patentansprüche**

1. Projektionsobjektiv umfassend:

   - eine Objektebene (20, 100, 300, 2103), in der ein Objektfeld ausgebildet wird,
   - eine Eintrittspupille (VE)
   - eine durch Spiegelung an der Objektebene (20, 100, 300, 2103) erhaltene gespiegelte Eintrittspupille (RE) in einer gespiegelten Eintrittspupillenebene (103),
   - eine Bildebene (21, 102, 302, 2102),
   - eine optische Achse (HA),
   - wenigstens einen ersten Spiegel (S1) und einen zweiten Spiegel (S2),

   wobei das Projektionsobjektiv eine negative Schnittweite der Eintrittspupille aufweist und ein Hauptstrahl (CR, CRP), der von einem zentralen Punkt des Objektfeldes ausgeht, das Objektiv von der Objektebene zur Bildebene durchläuft und die optische Achse (HA) in mindestens einem Schnittpunkt (CROSS, CROSS1, CROSS2) schneidet, wobei jeder einzelne Schnittpunkt (CROSS, CROSS1, CROSS2) entlang der optischen Achse (HA) jeweils einen ersten Abstand A1 zur Objektebene (20, 100, 300, 2103) und die gespiegelte Eintrittspupillenebene (103) einen zweiten Abstand A2 zur Objektebene aufweist, und jeweils A2 < A1; bevorzugt A2 < 0,9 • A1; ganz bevorzugt A2 < 0,8 • A1; insbesondere bevorzugt A2 < 0,7 • A1; bevorzugt A2 < 0,6 • A1; insbesondere ganz bevorzugt A2 < 0,5 • A1 ist.

2. Projektionsobjektiv umfassend:

   - eine Objektebene (20, 100, 300 2103), in der ein Objektfeld ausgebildet wird,
   - eine Eintrittspupille (VE)
   - eine durch Spiegelung der Eintrittspupille (VE) an der Objektebene (20, 100, 300, 2103) erhaltene gespiegelte Eintrittspupille (RE) in einer gespiegelten Eintrittspupillenebene (103),
   - eine Bildebene (21, 102, 302, 2102),
   - eine optische Achse (HA)
   - wenigstens einen ersten Spiegel (S1) und einen zweiten Spiegel (S2),

   wobei das Projektionsobjektiv eine negative Schnittweite der Eintrittspupille aufweist, und ein Hauptstrahl (CR, CRP) der von einem zentralen Punkt des Objektfeldes ausgeht und das Objektiv von der Objektebene zur Bildebene durchläuft die optische Achse (HA) in mindestens einem Schnittpunkt (CROSS) schneidet, wobei sämtliche Schnittpunkte (CROSS, CROSS1, CROSS2) geometrisch zwischen der Bildebene (21, 102, 302, 2102) und der gespiegelten Eintrittspupillenebene (103) liegen.

3. Projektionsobjektiv nach einem der Ansprüche 1 bis 2, wobei das Projektionsobjektiv wenigstens vier Spiegel (S1, S2, S3, S4) umfasst.

4. Projektionsobjektiv nach einem der Ansprüche 1 bis 3, wobei das Projektionsobjektiv wenigstens sechs Spiegel (S1, S2, S3, S4, S5, S6) umfasst.

5. Projektionsobjektiv nach einem der Ansprüche 1 bis 4, wobei eine Blendenebene (104) ausgebildet wird, in der eine Blende (B) angeordnet ist.

6. Projektionsobjektiv nach Anspruch 5, wobei eine erste Anzahl von Spiegeln, die im Lichtweg von der Objektebene zur Bildebene vor der Blendenebene liegen ein erstes Subobjektiv (SUB01) ausbilden und eine zweite Anzahl von Spiegeln ein zweites Subobjektiv (SUB02), wobei das zweite Subobjektiv die Blendenebene (104) umfasst.

7. Projektionsobjektiv nach Anspruch 6, wobei das zweite Subobjektiv (SUB02) zwei Spiegel aufweist.

8. Projektionsobjektiv nach einem der Ansprüche 6 bis 7, wobei das Projektionsobjektiv wenigstens sechs Spiegel, einen ersten Spiegel (S1), einen zweiten Spiegel (S2), einen dritten Spiegel (S3), einen vierten Spiegel (S4), einen fünften Spiegel (S5) und einen sechsten Spiegel (S6) umfasst und das erste Subobjektiv (SUB01) wenigstens den ersten (S1), den zweiten (S2), den dritten (S3) sowie den vierten Spiegel (S4) umfasst.

9. Projektionsobjektiv nach Anspruch 8, wobei das zweite Subobjektiv (SUB02) den fünften (S5) und sechsten Spiegel (S6) umfasst.

**10.** Projektionsobjektiv nach einem der Ansprüche 1 bis 9, wobei die bildseitige numerische Apertur ≥ 0,2; bevorzugt ≥ 0,25; ganz bevorzugt ≥ 0,3 ist.

**11.** Projektionsobjektiv nach einem der Ansprüche 1 bis 10, wobei das Projektionsobjektiv wenigstens sechs Spiegel umfasst, einen ersten Spiegel (S1), einen zweiten Spiegel (S2), einen dritten Spiegel (S3), einen vierten Spiegel (S4), einen fünften Spiegel (S5) und einen sechsten Spiegel (S6), wobei der erste Spiegel (S1) konvex, der zweite Spiegel (S2) konkav, der dritte Spiegel (S3) konkav, der vierte Spiegel (S4) konvex, der fünfte Spiegel (S5) konvex und der sechste Spiegel (S6) konkav ausgebildet ist.

**12.** Projektionsobjektiv nach einem der Ansprüche 1 bis 6, wobei im Lichtweg von der Objektebene (300) zur Bildebene (302) ein Zwischenbild (ZW) ausgebildet wird.

**13.** Projektionsobjektiv nach Anspruch 12, wobei das Projektionsobjektiv wenigstens sechs Spiegel aufweist, einen ersten Spiegel (S1), einen zweiten Spiegel (S2), einen dritten Spiegel (S3), einen vierten Spiegel (S4), einen fünften Spiegel (S5) sowie einen sechsten Spiegel (S6), wobei das Zwischenbild (ZW) zwischen dem vierten (S4) und dem fünften Spiegel (S5) ausgebildet wird.

**14.** Projektionsobjektiv nach einem der Ansprüche 13, wobei der erste Spiegel (S1) konkav, der zweite Spiegel (S2) konkav, der dritte Spiegel (S3) konvex, der vierte Spiegel (S4) konkav, der fünfte Spiegel (S5) konvex und der sechste Spiegel (S6) konkav ausgebildet ist.

**15.** Projektionsobjektiv nach einem der Ansprüche 13 bis 14, wobei eine Blende (B) zwischen dem zweiten Spiegel (S2) und dem dritten Spiegel (S3) oder auf dem dritten Spiegel (S3) angeordnet ist.

**16.** Projektionsobjektiv nach einem der Ansprüche 12 bis 15, wobei die bildseitige numerische Apertur NA ≥ 0,2, bevorzugt ≥ 0,25, ganz bevorzugt ≥ 0,3 ist.

**17.** Projektionsobjektiv umfassend:

- mindestens fünf Spiegel,
- eine Eintrittspupille (VE),
- eine Objektebene (100, 300), in der ein Objektfeld ausgebildet wird,
- eine Bildebene (102, 302), sowie
- eine nicht obskurierte Austrittspupille,

wobei die wenigstens fünf Spiegel einen ersten Spiegel (S1) umfassen, wobei das Projektionsobjektiv eine negative Schnittweite der Eintrittspupille (VE) aufweist und ein Hauptstrahl (CRE), der von einem zentralen Punkt des Objektfeldes ausgeht und auf den ersten Spiegel (S1) auftrifft, zwischen dem an dem ersten Spiegel (S1) reflektierten Hauptstrahl (CRR) zum zentralen Punkt des Objektfeldes und einer optischen Achse (HA) des Projektionsobjektives verläuft.

**18.** Projektionsobjektiv nach Anspruch 17, **dadurch gekennzeichnet, dass** das Objektiv derart aufgebaut ist, dass kein Zwischenbild im Lichtweg von der Objektebene zur Bildebene ausgebildet wird.

**19.** Projektionsobjektiv nach Anspruch 17 oder 18, wobei eine Blendenebene in oder nahe einer Pupillenebene (104, 312, 314) ausgebildet wird, in der eine Blende (B) angeordnet ist.

**20.** Projektionsobjektiv nach Anspruch 19, wobei eine erste Anzahl von Spiegeln, die im Lichtweg von der Objektebene (100, 300) zur Bildebene (102, 302) vor der Blende (B) liegen ein erstes Subobjektiv (SUB01) ausbilden und eine zweite Anzahl von Spiegeln ein zweites Subobjektiv (SUB02), wobei das zweite Subobjektiv die Blende (B) umfasst.

**21.** Projektionsobjektiv nach Anspruch 20, wobei das zweite Subobjektiv (SUB02) zwei Spiegel aufweist.

**22.** Projektionsobjektiv nach einem der Ansprüche 20 bis 21, wobei das Projektionsobjektiv wenigstens sechs Spiegel umfasst, einen ersten Spiegel (S1), einen zweiten Spiegel (S2), einen dritten Spiegel (S3), einen vierten Spiegel (S4), einen fünften Spiegel (S5) und einen sechsten Spiegel (S6), wobei das erste Subobjektiv (SUB01) wenigstens den ersten (S1), den zweiten (S2), den dritten (S3) sowie den vierten Spiegel (S4) umfasst.

**23.** Projektionsobjektiv nach Anspruch 22, wobei das zweite Subobjektiv (SUB02) den fünften (S5) und sechsten Spiegel (S6) umfasst.

**24.** Projektionsobjektiv nach einem der Ansprüche 17 bis 23, wobei die bildseitige numerische Apertur ≥ 0,2; bevorzugt ≥ 0,25; ganz bevorzugt ≥ 0,3 ist.

**25.** Projektionsobjektiv nach einem der Ansprüche 20 bis 24, wobei das Projektionsobjektiv wenigstens sechs Spiegel, einen ersten Spiegel (S1), einen zweiten Spiegel (S2), einen dritten Spiegel (S3), einen vierten Spiegel (S4), einen fünften Spiegel (S5) sowie einen sechsten Spiegel (S6) umfasst und der erste Spiegel (S1) konvex, der zweite Spiegel (S2) konkav, der dritte Spiegel (S3) konkav, der vierte Spiegel (S4) konvex, der fünfte Spiegel (S5) konvex und der sechste Spiegel (S6) konkav ausgebildet ist.

**26.** Projektionsobjektiv nach einem der Ansprüche 19 bis 25, wobei das Projektionsobjektiv wenigstens sechs Spiegel umfasst, einen ersten Spiegel (S1), einen zweiten Spiegel (S2), einen dritten Spiegel (S3), einen vierten Spiegel (S4), einen fünften Spiegel (S5), einen sechsten Spiegel (S6) und der erste (S1) und der zweite Spiegel (S2) ein erstes Teilsystem (PART1) sowie der dritte (S3), der vierte (S4), der fünfte (S5) und der sechste Spiegel (S6) ein zweites Teilsystem (PART2) ausbilden.

27. Projektionsobjektiv gemäß Anspruch 26, wobei ein geometrischer Abstand (DIS) vom ersten Teilsystem (PART1) zum zweiten Teilsystem (PART2) entlang einer optischen Achse größer als 30 %; bevorzugt größer als 40 %; ganz bevorzugt größer als 50 %; insbesondere größer als 60 % der Baulänge des Objektives ist.

28. Projektionsobjektiv umfassend:

   - eine Eintrittspupille (VE)
   - eine Objektebene (100, 300), in der ein Objektfeld ausgebildet wird
   - eine Bildebene (102, 302) sowie
   - einen Lichtweg von der Objektebene (100, 300) zur Bildebene (102, 302)
   - mindestens fünf Spiegel , wobei das Projektionsobjektiv eine negative Schnittweite der Eintrittspupille aufweist und das Objektiv derart aufgebaut ist, dass kein Zwischenbild im Lichtweg von der Objektebene (100, 300) zur Bildebene (102, 302) ausgebildet wird

29. Projektionsobjektiv nach Anspruch 28, wobei eine Blendenebene in oder nahe einer Pupillenebene (104, 312, 314) ausgebildet wird, in der eine Blende (B) angeordnet ist.

30. Projektionsobjektiv nach Anspruch 29, wobei eine erste Anzahl von Spiegeln, die im Lichtweg von der Objektebene zur Bildebene vor der Blendenebene (104) liegen, ein erstes Subobjektiv (SUB01) ausbilden und eine zweite Anzahl von Spiegeln ein zweites Subobjektiv (SUB02), wobei das zweite Subobjektiv (SUB02) die Blende (B) umfasst.

31. Projektionsobjektiv nach Anspruch 30, wobei das zweite Subobjektiv (SUB02) zwei Spiegel aufweist.

32. Projektionsobjektiv nach einem der Ansprüche 30 bis 31, wobei das Projektionsobjektiv wenigstens sechs Spiegel umfasst, einen ersten Spiegel (S1), einen zweiten Spiegel (S2), einen dritten Spiegel (S3), einen vierten Spiegel (S4), einen fünften Spiegel (S5) und einen sechsten Spiegel (S6), wobei das erste Subobjektiv (SUB01) wenigstens den ersten (S1), den zweiten (S2), den dritten (S3) sowie den vierten Spiegel (S4) umfasst.

33. Projektionsobjektiv nach Anspruch 32 wobei das zweite Subobjektiv (SUB02) den fünften (S5) und sechsten Spiegel (S6) umfasst.

34. Projektionsobjektiv nach einem der Ansprüche 28 bis 33, wobei die bildseitige numerische Apertur ≥ 0,2; bevorzugt ≥ 0,25; ganz bevorzugt ≥ 0,3 ist.

35. Projektionsobjektiv nach einem der Ansprüche 28 bis 34, wobei das Projektionsobjektiv wenigstens sechs Spiegel, einen ersten Spiegel (S1), einen zweiten Spiegel (S2), einen dritten Spiegel (S3), einen vierten Spiegel (S4), einen fünften Spiegel (S5) sowie einen sechsten Spiegel (S6) umfasst und der erste Spiegel (S1) konvex, der zweite Spiegel (S2) konkav, der dritte Spiegel (S3) konkav, der vierte Spiegel (S4) konvex, der fünfte Spiegel (S5) konvex und der sechste Spiegel (S6) konkav ausgebildet ist.

36. Projektionsobjektiv nach einem der Ansprüche 28 bis 35, wobei das Projektionsobjektiv wenigstens sechs Spiegel umfasst, einen ersten Spiegel (S1), einen zweiten Spiegel (S2), einen dritten Spiegel (S3), einen vierten Spiegel (S4), einen fünften Spiegel (S5), einen sechsten Spiegel (S6) und der erste (S1) und der zweite Spiegel (S2) ein erstes Teilsystem (PART1), sowie der dritte (S3), der vierte (S4), der fünfte (S5) und der sechste Spiegel (S6) ein zweites Teilsystem (PART2) ausbilden.

37. Projektionsobjektiv nach Anspruch 36, wobei ein geometrischer Abstand vom ersten Teilsystem (PART1) zum zweiten Teilsystem (PART2) entlang der optischen Achse HA größer als 30 %; bevorzugt größer als 40 %; ganz bevorzugt größer als 50 %; insbesondere größer als 60 % der Baulänge des Objektives ist.

38. Projektionsobjektiv umfassend:

   - eine Eintrittspupille (VE),
   - eine Objektebene (100, 300), in der ein Objektfeld ausgebildet wird,
   - eine Bildebene (102, 302), sowie ein Lichtweg von der Objektebene zur Bildebene,
   - eine Austrittspupille,
   - wenigstens einen ersten Spiegel (S1) und einen zweiten Spiegel (S2),

   wobei die Austrittspupille eine nicht obskurierte Austrittspupille ist,
   wobei das Projektionsobjektiv eine negative Schnittweite der Eintrittspupille aufweist,
   und das Objektiv derart aufgebaut ist, dass in einer Meridionalebene des Projektionsobjektives sich der Lichtweg von der Objektebene zum ersten Spiegel (S1) mit dem Lichtweg vom zweiten Spiegel (S2) zur Bildebene (102, 302) überkreuzt und zwischen Objektebene (100, 300) und erstem Spiegel (S1) kein weiterer Spiegel abgeordnet ist.

39. Projektionsobjektiv nach Anspruch 38, wobei das Projektionsobjektiv wenigstens vier Spiegel, einen ersten Spiegel (S1), einen zweiten Spiegel (S2), einen dritten Spiegel (S3) und einen vierten Spiegel (S4) umfasst.

40. Projektionsobjektiv nach einem der Ansprüche 38 bis 39, wobei das Projektionsobjektiv wenigstens sechs Spiegel, einen ersten Spiegel (S1), einen zweiten Spiegel (S2), einen dritten Spiegel (S3), einen vierten Spiegel (S4), einen fünften Spiegel (S5) sowie einen sechsten Spiegel (S6) umfasst.

41. Projektionsobjektiv nach einem der Ansprüche Anspruch 39 bis 40, wobei in der Meridionalebene der Lichtweg vom Objekt (100, 300) zum ersten Spiegel (S1) den Lichtweg vom zweiten (S2) zum dritten Spiegel (S3) kreuzt.

42. Projektionsobjektiv nach einem der Ansprüche 38 bis 40, wobei im Lichtweg von der Objektebene (100, 300) zur Bildebene (102, 302) ein Zwischenbild (ZW) ausgebildet wird.

43. Projektionsobjektiv nach einem der Ansprüche 40 bis 42, wobei das Zwischenbild (ZW) zwischen dem vierten (S4) und dem fünften Spiegel (S5) ausgebildet wird.

44. Projektionsobjektiv nach einem der Ansprüche 40 bis 43, wobei der erste Spiegel (S1) konkav, der zweite Spiegel (S2) konkav, der dritte Spiegel (S3) konvex, der vierte Spiegel (S4) konkav, der fünfte Spiegel (S5) konvex und der sechste Spiegel (S6) konkav ausgebildet ist.

45. Projektionsobjektiv nach einem der Ansprüche 40 bis 44, wobei eine Blende (B) zwischen dem zweiten (S2) und dem dritten Spiegel (S3) angeordnet ist.

46. Projektionsobjektiv nach einem der Ansprüche 40 bis 44, wobei eine Blende (B) auf dem dritten Spiegel (S3) angeordnet ist

47. Projektionsobjektiv nach einem der Ansprüche 38 bis 46, wobei die bildseitige numerische Apertur NA $\geq 0,2$; bevorzugt $\geq 0,25$; ganz bevorzugt $\geq 0,3$ ist.

48. Projektionsobjektiv nach einem der Ansprüche 1 bis 47, wobei die Spiegel des Projektionsobjektives rotationssymmetrisch um eine optische Achse (HA) angeordnet sind.

49. Projektionsobjektiv, aufgebaut um Strahlung einer Wellenlänge λ von einer Objektebene (100, 300) in eine Bildebene (102, 302) abzubilden, umfassend eine Vielzahl von Spiegeln, wobei das Projektionsobjektiv ein katoptrisches Projektionsobjektiv ist und eine negative Schnittweite der Eintrittspupille aufweist sowie einen bildseitigen Wellenfrontfehler $W_{RMS} < 0,01 \lambda$, und einen maximalen Einfallswinkel, wobei der maximale Einfallswinkel $\Theta_{max(max)}$ aller auf einen Spiegel auftreffenden Strahlen $\Theta_{max(max)}$ in der Meridionalebene auf jedem Spiegel $\leq 20°$ ist.

50. Projektionsobjektiv nach Anspruch 49, wobei er bildseitige Wellenfrontfehler $W_{RMS} \leq 0,007 \lambda$, insbesondere $\leq 0,006 \lambda$ ist.

51. Projektionsobjektiv nach einem der Ansprüche 49 bis 50, wobei der maximale Einfallswinkel in der Meridionalebene $\Theta_{max(max)} \leq 19,5°$ ist.

52. Projektionsobjektiv nach einem der Ansprüche 49 bis 51, wobei die bildseitige numerische Apertur NA $\geq 0,25$; insbesondere $\geq 0,30$ ist.

53. Projektionsobjektiv nach einem der Ansprüche 49 bis 52, wobei das Projektionsobjektiv wenigstens vier Spiegel umfasst, wobei der in einem Lichtweg von der Objektebene zur Bildebene erste Spiegel (S1) und der vierte Spiegel (S4) je ein Konvexspiegel sind.

54. Projektionsobjektiv nach einem der Ansprüche 49 bis 53, wobei die Spiegel eine Dimension ($M_y$) in der Meridionalebene aufweisen und die maximale Dimension ($M_y$) aller Spiegel in der Meridionalebene kleiner 190 mm, bevorzugt kleiner 180 mm ist.

55. Projektionsobjektiv gemäß einem der Ansprüche 1 bis 54, wobei das Projektionsobjektiv ein katoptrisches Projektionsobjektiv ist.

56. Projektionsobjektiv gemäß einem der Ansprüche 1 bis 54, wobei das Projektionsobjektiv ein katadioptrisches Projektionsobjektiv ist.

57. Projektionsobjektiv aufgebaut um Strahlung von einer Objektebene (100, 300) in eine Bildebene (102, 302) zu leiten umfassend wenigstens vier Spiegel, wobei das Projektionsobjektiv ein katoptrisches Projektionsobjektiv ist und eine negative Schnittweite der Eintrittspupille aufweist, wobei der in einem Lichtweg von der Objektebene (100, 300) zur Bildebene (102, 302) erste Spiegel (S1) und vierte Spiegel (S4) ein Konvexspiegel ist.

58. Projektionsobjektiv nach Anspruch 57, wobei in dem Lichtweg von der Objektebene (100, 300) zur Bildebene (102, 302) kein Zwischenbild ausgebildet wird.

**59.** Projektionsobjektiv nach einem der Ansprüche 57 bis 58, wobei die bildseitige numerische Apertur NA ≥ 0,25; insbesondere ≥ 0,30 ist.

**60.** Projektionsobjektiv aufgebaut um Strahlung von einer Objektebene (100, 300) in eine Bildebene (102, 302) zu leiten umfassend eine Vielzahl von Spiegeln, wobei die Spiegel je eine Dimension ($M_y$) in der Meridionalebene aufweisen und die maximale Dimension ($M_y$) aller Spiegel in der Meridionalebene kleiner 190 mm, bevorzugt kleiner 180 mm ist.

**61.** Projektionsobjektiv nach Anspruch 58, wobei der maximale Einfallswinkel $\Theta_{max(max)}$ aller auf einen Spiegel einfallenden Strahlen auf jedem Spiegel < 25°, insbesondere ≤ 21°, bevorzugt ≤ 20° ist.

**62.** Projektionsobjektiv nach einem der Ansprüche 49 bis 61, wobei das Projektionsobjektiv einen ersten Spiegel (S1), einen zweiten Spiegel (S2), einen dritten Spiegel (S3), einen vierten Spiegel (S4), einen fünften Spiegel (S5) sowie einen sechsten Spiegel (S6) umfasst.

**63.** Projektionsobjektiv gemäß einem der Ansprüche 1 bis 62, wobei das Projektionsobjektiv aufgebaut ist, um Strahlung von einer Objektebene in eine Bildebene mit einer Wellenlänge λ zu leiten, wobei λ ≤ 193 nm, bevorzugt λ ≤ 100 nm, insbesondere bevorzugt im Bereich von 1 nm < λ ≤ 30 nm liegt.

**64.** Mikrolithographie- Projektionsbelichtungsanlage umfassend
ein Beleuchtungssystem, das von einem Beleuchtungsstrahlbüschel (211) durchlaufen wird;
eine Objektebene (212), in der ein Objektfeld ausgeleuchtet wird;
ein Projektionsobjektiv (210), wobei das Projektionsobjektiv (210) von einem Abbildungsstrahlengang (213) von der Objektebene (212) zu einer Bildebene (214) durchlaufen wird und das Projektionsobjektiv (210) eine negative Schnittweite einer Eintrittspupille aufweist und die Mikrolithographie-Projektionsbelichtungsanlage derart aufgebaut ist, dass das Beleuchtungsstrahlbüschel (211), das von einer in einem Lichtweg vorletzten optischen Komponente (206) des Beleuchtungssystems bis zur Objektebene (212) verläuft, sich mit dem Abbildungsstrahlengang (213) bis auf den Bereich der Reflektion an der Objektebene (212) nicht in einer Meridionalebene überkreuzt.

**65.** Mikrolithographie-Projektionsbelichtungsanlage gemäß Anspruch 64, wobei das Beleuchtungsstrahlbüschel (211) des Beleuchtungssystems und der Abbildungsstrahlengang (213) des Projektionsobjektives sich in einem Lichtweg von der Objektebene in die Bildebene in der Meridionalebene nicht überkreuzt.

**66.** Mikrolithographie-Projektionsbelichtungsanlage umfassend

- ein Beleuchtungssystem,
- ein Projektionsobjektiv, wobei das Projektionsobjektiv eine negative Schnittweite der Eintrittspupille aufweist und die Mikrolithographie-Projektionsbelichtungsanlage ein Projektionsobjektiv gemäß einem der Ansprüche 1 bis 65 umfasst.

**67.** Mikrolithographie-Projektionsbelichtungsanlage nach einem der Ansprüche 64 bis 66, wobei durch die Spiegelung der Eintrittspupille (VE) an der Objektebene (212) eine gespiegelte Eintrittspupille (RE) des Projektionsobjektives (210) bildseitig von der Objektebene (212) ausgebildet wird und das Beleuchtungssystem einen optischen Integrator aufweist, der in oder nahe einer Ebene, in der die gespiegelte Eintrittspupille (RE) ausgebildet wird, angeordnet ist.

**68.** Mikrolithographie-Projektionsbelichtungsanlage (2002, 3006) gemäß Anspruch 67, wobei der optische Integrator ein facettierter Spiegel ist.

**69.** Mikrolithographie-Projektionsbelichtungsanlage gemäß Anspruch 68, wobei der optische Integrator ein Diffusor ist.

**70.** Mikrolithographie-Projektionsbelichtungsanlage nach Anspruch 69, wobei der Diffusor mehr als 500 Spiegelfacetten umfasst.

**71.** Mikrolithographie-Projektionsbelichtungsanlage gemäß Anspruch 70, wobei der Diffusor ein holographisches Gitter ist.

**72.** Mikrolithographie-Projektionsbelichtungsanlage gemäß einem der Ansprüche 64 bis 71, wobei im Lichtweg eine Blende vor dem Diffusor angeordnet ist.

**73.** Mikrolithographie-Projektionsbelichtungsanlage gemäß einem der Ansprüche 64 bis 66, wobei das Beleuchtungssystem ein erstes facettiertes optisches Element mit einer Vielzahl von ersten Rasterelementen sowie ein zweites facettiertes optisches Element mit einer Vielzahl von zweiten Rasterelementen umfasst, wobei das zweite facettierte optische Element in oder nahe der Ebene der gespiegelten Eintrittspupille (RE) angeordnet ist.

**74.** Mikrolithographie-Projektionsbelichtungsanlage gemäß Anspruch 73, wobei ein erstes Rasterelement im Wesentlichen die Form eines Feldes, das in der Objektebene ausgebildet wird, aufweist.

**75.** Mikrolithographie-Projektionsbelichtungsanlage gemäß Anspruch 74, wobei ein erstes Rasterelement bogenförmig ausgebildet ist.

**76.** Mikrolithographie-Projektionsbelichtungsanlage nach einem der Ansprüche 64 bis 75, wobei wenigstens ein Spiegel im Lichtweg nach dem optischen Integrator und vor der Objektebene angeordnet ist.

**77.** Mikrolithographie-Projektionsbelichtungsanlage gemäß einem der Ansprüche 64 bis 66, wobei durch die Spiegelung der Eintrittspupille (VE) an der Objektebene eine gespiegelte Eintrittspupille in einer gespiegelten Eintrittspupillenebene (103) bildseitig von der Objektebene ausgebildet wird und im Beleuchtungssystem ein optischer Integrator, insbesondere ein Diffusor, nicht in oder nahe der gespiegelten Eintrittspupillenebene (103) angeordnet ist.

**78.** Mikrolithographie-Projektionsbelichtungsanlage gemäß Anspruch 77, wobei der optische Integrator nicht in einer zur Objektebene konjugierten Ebene angeordnet ist.

**79.** Mikrolithographie-Projektionsbelichtungsanlage gemäß einem der Ansprüche 77 oder 78, wobei der optische Integrator mehr als 1000 einzelne Facetten aufweist.

**80.** Mikrolithographie-Projektionsbelichtungsanlage gemäß einem der Ansprüche 77 bis 79, wobei der optische Integrator ein Feld in der Objektebene ausleuchtet, wobei das Feld eine Feldform aufweist.

**81.** Mikrolithographie-Projektionsbelichtungsanlage gemäß Anspruch 80, wobei der optische Integrator eine Form aufweist und dabei die Form mit der Feldform im Wesentlichen übereinstimmt.

**82.** Mikrolithographie-Projektionsbelichtungsanlage gemäß einem der Ansprüche 77 bis 81, wobei der optische Integrator eine nierenförmige Form aufweist.

**83.** Mikrolithographie-Projektionsbelichtungsanlage gemäß einem der Ansprüche 77 bis 82, wobei der optische Integrator eine Vielzahl von Facetten aufweist, wobei jede Facette eine Vielzahl von diskreten Feldpunkten in der Objektebene und Pupillenorten in einer Pupillenebene ausleuchtet.

**84.** Mikrolithographie-Projektionsbelichtungsanlage gemäß einem der Ansprüche 77 bis 83, wobei im Lichtweg von der Lichtquelle zum optischen Integrator vor dem optischen Integrator ein normal-incidence-Spiegel angeordnet ist.

**85.** Mikrolithographie-Projektionsbelichtungsanlage gemäß Anspruch 84, wobei der normal-incidence Spiegel eine Spiegeloberfläche aufweist, die eine außeraxiale konische Fläche umfasst.

**86.** Mikrolithographie-Projektionsbelichtungsanlage gemäß Anspruch 84, wobei der normal-incidence-Spiegel eine Spiegeloberfläche aufweist, die als Freiformfläche ausgebildet ist.

**87.** Mikrolithographie-Projektionsbelichtungsanlage gemäß Anspruch 86, wobei die Freiformfläche eine Freiformfläche ist, die einen außeraxialen konischen Anteil aufweist.

**88.** Mikrolithographie-Projektionsbelichtungsanlage gemäß einem der Ansprüche 77 bis 83, wobei im Lichtweg von der Lichtquelle zum Diffusor vor dem Diffusor ein grazing-incidence-Spiegel angeordnet ist.

**89.** Mikrolithographie-Projektionsbelichtungsanlage gemäß Anspruch 88, wobei der grazing-incidence-Spiegel eine Spiegelfläche aufweist, die eine außeraxiale konische Fläche umfasst.

**90.** Mikrolithographie-Projektionsbelichtungsanlage gemäß einem der Ansprüche 84 bis 89, wobei der grazing-incidence-Spiegel oder der normal-incidence-Spiegel einen sphärischen, torischen oder asphärischen Anteil ausleuchtet.

**91.** Mikrolithographie-Projektionsbelichtungsanlage gemäß einem der Ansprüche 77 bis 90, wobei im Lichtweg von der Lichtquelle zur Objektebene nach dem optischen Integrator ein normal-incidence-Spiegel angeordnet ist.

**92.** Projektionsbelichtungsanlage aufgebaut um Strahlung von einer Lichtquelle in eine Bildebene zu leiten, umfassend:

- eine Vielzahl von Elementen, die derart angeordnet sind, dass die Strahlung von der Lichtquelle in die Bildebene geleitet wird, wobei die Vielzahl von Elementen Spiegel sind, wobei die Anzahl der Spiegel, die die Strahlung unter normal-incidence-Bedingungen reflektiert, maximal 10 ausschließlich eines in der Objektebene angeordneten reflektiven Objektes ist,

wobei die Mikrolithographie-Projektionsbelichtungsanlage eine bildseitige numerische Apertur NA > 0,25; insbesondere > 0,26; bevorzugt ≥ 0,3 und eine maximale Dimension ($D_x$, $D_y$) eines bildseitigen Feldes von mehr als 1 mm; bevorzugt mehr als 4 mm; ganz bevorzugt mehr als 8 mm; insbesondere bevorzugt mehr als 12 mm; insbesondere bevorzugt mehr als 16 mm; ganz besonders bevorzugt mehr als 20 mm; insbesondere bevorzugt mehr als 25 mm aufweist.

**93.** Projektionsbelichtungsanlage nach Anspruch 92, wobei die Anzahl der Spiegel, die die Strahlung unter normal-incidence-Bedingungen reflektiert, maximal 9 ausschließlich eines in der Objektebene angeordneten reflektiven Objektes ist.

**94.** Mikrolithographie-Projektionsbelichtungsanlage gemäß Anspruch 92 oder 93, wobei die Strahlung eine Wellenlänge $\lambda$ aufweist und die Wellenlänge $\lambda \leq 100$ nm; bevorzugt $\lambda \leq 30$ nm; insbesondere $\lambda \leq 15$ nm ist.

**95.** Mikrolithographie-Projektionsbelichtungsanlage gemäß einem der Ansprüche 89 bis 90, wobei ein erster Anteil der Elemente Teil eines Beleuchtungssystems ist und ein zweiter Anteil der Elemente ein Projektionsobjektiv ausbildet.

**96.** Mikrolithographie-Projektionsbelichtungsanlage, gemäß einem der Ansprüche 92 bis 95, wobei in einer Meridionalebene der Mikrolithographie-Projektionsbelichtungsanlage die Strahlung einen maximalen Einfallswinkel $\Theta_{max(max)}$ bezüglich einer Oberfläche eines jeden Elementes, auf das die Strahlung unter normal-incidence einfällt, von weniger als 20°, bevorzugt weniger als 17° aufweist.

**97.** Mikrolithographie-Projektionsbelichtungsanlage gemäß einem der Ansprüche 92 bis 96, wobei die Vielzahl von Elementen einen optischen Integrator umfassen.

**98.** Mikrolithographie-Projektionsbelichtungsanlage gemäß Anspruch 97, wobei der optische Integrator ein facettierter Spiegel ist.

**99.** Mikrolithographie-Projektionsbelichtungsanlage gemäß Anspruch 97, wobei der optische Integrator ein Diffusor ist.

**100.** Mikrolithographie-Projektionsbelichtungsanlage gemäß Anspruch 99, wobei der Diffusor mehr als 500 Spiegelfacetten umfasst.

**101.** Mikrolithographie-Projektionsbelichtungsanlage gemäß einem der Ansprüche 92 bis 96, wobei die Vielzahl von optischen Elementen ein erstes facettiertes optisches Element mit ersten Rasterelementen sowie ein zweites facettiertes optisches Element mit zweiten Rasterelementen umfasst.

**102.** Mikrolithographie-Projektionsbelichtungsanlage gemäß Anspruch 97, wobei der optische Integrator mehr als 1000 einzelne Facetten aufweist.

**103.** Mikrolithographie-Projektionsbelichtungsanlage gemäß einem der Ansprüche 92 bis 102 wobei die Vielzahl von optischen Elementen einen grazing-incidence-Kollektor umfassen.

**104.** Mikrolithographie-Projektionsbelichtungsanlage gemäß einem der Ansprüche 92 bis 103, wobei die Mikrolithographie-Projektionsbelichtungsanlage eine Vorrichtung zur variablen SettingEinstellung umfasst.

EP 1 840 622 A2

Fig. 1a

29

FIG. 1b

**FIG.** 1c

**FIG.** 1d

FIG. 26

FIG. 1f

Fig. 19

Fig. 1h

FIG. 2a

6M-System 4x NA=0.25 F=2mm

EP 1 840 622 A2

**Figur 2b**

Tabelle 1

| Surface | Radius | Thickness | Mode |
|---|---|---|---|
| Object | INFINITY | 340.063 | |
| Mirror 1 | 541.604 | -240.063 | REFL |
| Mirror 2 | 767.655 | 1359.666 | REFL |
| Mirror 3 | -403.377 | -100.907 | REFL |
| Mirror 4 | -245.920 | 101.241 | REFL |
| STOP | INFINITY | 0.000 | |
| Mirror 5 | 245.625 | -78.546 | REFL |
| Mirror 6 | 161.871 | 118.546 | REFL |
| Image | INFINITY | 0.000 | |

| Surface | K | A | B |
|---|---|---|---|
| Mirror 1 | 0.00000E+00 | -2.76457E-09 | -1.26272E-14 |
| Mirror 2 | 0.00000E+00 | -2.03348E-10 | -2.46751E-16 |
| Mirror 3 | 0.00000E+00 | 1.85641E-09 | 1.36854E-15 |
| Mirror 4 | 0.00000E+00 | 1.17196E-08 | -4.61185E-13 |
| Mirror 5 | 0.00000E+00 | 5.07237E-08 | 3.41540E-12 |
| Mirror 6 | 0.00000E+00 | 1.06445E-08 | 5.39891E-13 |

| Surface | C | D | E |
|---|---|---|---|
| Mirror 1 | 3.37883E-19 | -4.45867E-24 | 2.16762E-29 |
| Mirror 2 | -1.92698E-21 | 7.69579E-27 | -2.58196E-32 |
| Mirror 3 | 4.80738E-20 | -2.38457E-25 | 2.95652E-30 |
| Mirror 4 | 2.24623E-17 | -1.63691E-21 | 6.17234E-26 |
| Mirror 5 | 8.26510E-17 | 4.41847E-19 | -3.25606E-22 |
| Mirror 6 | 2.40272E-17 | 1.09027E-21 | 8.43531E-26 |

wobei:

| | | | |
|---|---|---|---|
| Surface: | die Oberfläche | Image: | die Bildebene |
| Object: | die Objektebene | Radius: | den Radius |
| Mirror 1: | den Spiegel S1 | Thickness: | die Dicke |
| Mirror 2: | den Spiegel S2 | Mode: | die Art der optischen |
| Mirror 3: | den Spiegel S3 | Fläche | |
| Mirror 4: | den Spiegel S4 | REFL: | eine reflektive Fläche |
| STOP: | die Aperturblende | INFINITY: | unendlich |
| Mirror 5: | den Spiegel S5 | K | konische Konstante |
| Mirror 6: | den Spiegel S6 | A, B, C, D ,E: | Asphärenkoeffizienten |

Fig. 3a

6M-System 4x NA=0.30 F=2mm

EP 1 840 622 A2

**Figur 3b**

Tabelle 2:

| Surface | Radius | Thickness | Mode |
|---|---|---|---|
| Object | INFINITY | 379.241 | |
| Mirror 1 | 468.674 | -279.241 | REFL |
| Mirror 2 | 791.140 | 1460.000 | REFL |
| Mirror 3 | -464.221 | -108.146 | REFL |
| Mirror 4 | -293.724 | 108.146 | REFL |
| STOP | INFINITY | 0.000 | |
| Mirror 5 | 254.762 | -79.487 | REFL |
| Mirror 6 | 165.876 | 119.487 | REFL |
| Image | INFINITY | 0.000 | |

| Surface | K | A | B | C |
|---|---|---|---|---|
| Mirror 1 | 0.00000E+00 | -1.97745E-09 | -3.31838E-14 | 5.52752E-19 |
| Mirror 2 | 0.00000E+00 | -1.35785E-10 | -5.45339E-17 | -1.64232E-21 |
| Mirror 3 | 0.00000E+00 | 1.46199E-09 | -1.81989E-15 | 5.15326E-20 |
| Mirror 4 | 0.00000E+00 | 6.99543E-09 | -4.00395E-13 | 2.32169E-17 |
| Mirror 5 | 0.00000E+00 | 4.48045E-08 | 2.84169E-12 | 4.77738E-16 |
| Mirror 6 | 0.00000E+00 | 1.01439E-08 | 4.93440E-13 | 2.28735E-17 |

| Surface | D | E | F | G |
|---|---|---|---|---|
| Mirror 1 | -5.50393E-24 | 2.53787E-29 | -4.98907E-35 | 8.46612E-41 |
| Mirror 2 | 6.78729E-27 | -2.22312E-32 | 3.92966E-38 | -4.04401E-44 |
| Mirror 3 | -5.50659E-25 | 5.30227E-30 | -2.43653E-35 | 5.01854E-41 |
| Mirror 4 | -2.02966E-21 | 1.15713E-25 | -3.85058E-30 | 5.67798E-35 |
| Mirror 5 | -5.39737E-19 | 5.10878E-22 | -1.46306E-32 | -1.75867E-28 |
| Mirror 6 | 4.95032E-23 | 2.81966E-25 | -2.82893E-29 | 1.63424E-33 |

wobei:

| | | | |
|---|---|---|---|
| Surface: | die Oberfläche | Image: | die Bildebene |
| Object: | die Objektebene | Radius: | den Radius |
| Mirror 1: | den Spiegel S1 | Thickness: | die Dicke |
| Mirror 2: | den Spiegel S2 | Mode: | die Art der optischen |
| Mirror 3: | den Spiegel S3 | Fläche | |
| Mirror 4: | den Spiegel S4 | REFL: | eine reflektive Fläche |
| STOP: | die Aperturblende | INFINITY: | unendlich |
| Mirror 5: | den Spiegel S5 | K: | konische Konstante |
| Mirror 6: | den Spiegel S6 | A,B,C,D,E,F,G: | Asphärenkoeffizienten |

Fig. 4

EP 1 840 622 A2

40

FIG.5a

6M-System 4x NA=0.25 F=2mm

192.31 MM

## Figur 5b

| Surface | Radius | Thickness | Mode |
|---|---|---|---|
| Object | INFINITY | 754.640 | |
| Mirror 1 | -5445.202 | -588.928 | REFL |
| Mirror 2 | 1527.364 | 933.572 | REFL |
| STOP | INFINITY | 107.347 | |
| Mirror 3 | 409.836 | -679.913 | REFL |
| Mirror 4 | 865.334 | 976.790 | REFL |
| Mirror 5 | 293.951 | -192.058 | REFL |
| Mirror 6 | 260.341 | 238.347 | REFL |
| Image | INFINITY | 0.000 | |

| Surface | K | A | B | C |
|---|---|---|---|---|
| Mirror 1 | 0.00000E+00 | -1.49945E-10 | 1.23571E-16 | -1.55144E-21 |
| Mirror 2 | 0.00000E+00 | -6.17753E-11 | -5.41816E-17 | -2.27907E-23 |
| Mirror 3 | 0.00000E+00 | -1.56072E-08 | -4.43012E-14 | -9.64500E-18 |
| Mirror 4 | 0.00000E+00 | 2.10226E-13 | 1.05204E-17 | -1.16989E-22 |
| Mirror 5 | 0.00000E+00 | 2.01509E-08 | 1.29737E-12 | 7.05448E-17 |
| Mirror 6 | 0.00000E+00 | 2.99441E-10 | 7.97437E-15 | 1.24514E-19 |
| Surface | D | E | F | G |
| Mirror 1 | 2.24350E-26 | -2.16861E-31 | 8.59536E-37 | 0.00000E+00 |
| Mirror 2 | -3.41917E-28 | 3.46528E-34 | 0.00000E+00 | 0.00000E+00 |
| Mirror 3 | 2.83351E-21 | -7.43833E-25 | 8.56608E-29 | 0.00000E+00 |
| Mirror 4 | 6.53444E-28 | -1.70989E-33 | -1.17639E-39 | 0.00000E+00 |
| Mirror 5 | -8.59659E-21 | -2.23412E-35 | -7.32354E-28 | 0.00000E+00 |
| Mirror 6 | 3.11002E-24 | -1.98672E-29 | 2.14573E-33 | 0.00000E+00 |

wobei:

| | | | |
|---|---|---|---|
| Surface: | die Oberfläche | Image: | die Bildebene |
| Object: | die Objektebene | Radius: | den Radius |
| Mirror 1: | den Spiegel S1 | Thickness: | die Dicke |
| Mirror 2: | den Spiegel S2 | Mode: | die Art der optischen |
| Mirror 3: | den Spiegel S3 | Fläche | |
| Mirror 4: | den Spiegel S4 | REFL: | eine reflektive Fläche |
| STOP: | die Aperturblende | INFINITY: | unendlich |
| Mirror 5: | den Spiegel S5 | K | konische Konstante |
| Mirror 6: | den Spiegel S6 | A,B,C,D,E,F,G | Asphärenkoeffizient |

FIG. 6a

6M-System 4x NA=0.30 F=2mm

192.31 MM

## Figur 6b

<u>Tabelle 4:</u>

| Surface | Radius | Thickness | Mode |
|---------|--------|-----------|------|
| Object | INFINITY | 760.443 | |
| Mirror 1 | -6594.475 | -610.443 | REFL |
| Mirror 2 | 1493.793 | 942.230 | REFL |
| STOP | INFINITY | 102.828 | |
| Mirror 3 | 418.354 | -685.204 | REFL |
| Mirror 4 | 865.237 | 968.410 | REFL |
| Mirror 5 | 289.559 | -193.382 | REFL |
| Mirror 6 | 259.676 | 235.194 | REFL |
| Image | INFINITY | 0.000 | |

| Surface | K | A | B | C |
|---------|---|---|---|---|
| Mirror 1 | 0.00000E+00 | -1.54674E-10 | 1.82695E-16 | -2.03630E-21 |
| Mirror 2 | 0.00000E+00 | -5.44340E-11 | -4.64038E-17 | -2.42279E-23 |
| Mirror 3 | 0.00000E+00 | -1.61624E-08 | -8.51893E-14 | -5.35799E-18 |
| Mirror 4 | 0.00000E+00 | -6.11145E-13 | 3.34152E-17 | -2.98382E-22 |
| Mirror 5 | 0.00000E+00 | 2.14154E-08 | 1.36795E-12 | 7.70221E-17 |
| Mirror 6 | 0.00000E+00 | 3.17752E-10 | 8.28092E-15 | 1.20913E-19 |

| Surface | D | E | F | G |
|---------|---|---|---|---|
| Mirror 1 | 2.19348E-26 | -1.53125E-31 | 4.46845E-37 | 0.00000E+00 |
| Mirror 2 | -1.83847E-28 | -1.56616E-36 | 0.00000E+00 | 0.00000E+00 |
| Mirror 3 | 2.02049E-22 | 0.00000E+00 | 0.00000E+00 | 0.00000E+00 |
| Mirror 4 | 1.50481E-27 | -3.45921E-33 | 0.00000E+00 | 0.00000E+00 |
| Mirror 5 | -7.03893E-21 | 0.00000E+00 | 0.00000E+00 | 0.00000E+00 |
| Mirror 6 | 3.69377E-24 | 0.00000E+00 | 0.00000E+00 | 0.00000E+00 |

wobei:

| | | | |
|---|---|---|---|
| Surface: | die Oberfläche | Image: | die Bildebene |
| Object: | die Objektebene | Radius: | den Radius |
| Mirror 1: | den Spiegel S1 | Thickness: | die Dicke |
| Mirror 2: | den Spiegel S2 | Mode: | die Art der optischen |
| Mirror 3: | den Spiegel S3 | | Fläche |
| Mirror 4: | den Spiegel S4 | REFL: | eine reflektive Fläche |
| STOP: | die Aperturblende | INFINITY: | unendlich |
| Mirror 5: | den Spiegel S5 | K | konische Konstante |
| Mirror 6: | den Spiegel S6 | A,B,C,D,E,F,G, | Asphärenkoeffizienten |

FIG. 6d

6M-System 4x NA=0.25 F=2mm

192.31 MM

## Figur 6d

### Tabelle 5

| Surface | Radius | Thickness | Mode |
|---|---|---|---|
| Object | INFINITY | 841.190 | |
| Mirror 1 | -15965.255 | -569.221 | REFL |
| Mirror 2 | 1335.990 | 878.977 | REFL |
| STOP | INFINITY | 0.000 | |
| Mirror 3 | 326.505 | -1000.945 | REFL |
| Mirror 4 | 1155.912 | 1302.266 | REFL |
| Mirror 5 | 534.693 | -226.321 | REFL |
| Mirror 6 | 306.167 | 264.300 | REFL |
| Image | INFINITY | 0.000 | |

| Surface | K | A | B | C |
|---|---|---|---|---|
| Mirror 1 | 0.00000E+00 | -8.81260E-11 | -1.84421E-16 | 2.27798E-21 |
| Mirror 2 | 0.00000E+00 | -2.52448E-11 | -4.03936E-17 | -2.46584E-23 |
| Mirror 3 | 0.00000E+00 | -4.41990E-09 | -8.01606E-13 | -3.43875E-17 |
| Mirror 4 | 0.00000E+00 | 4.18680E-12 | 2.80690E-18 | 2.90893E-23 |
| Mirror 5 | 0.00000E+00 | 2.28753E-08 | 6.04615E-13 | 1.96262E-17 |
| Mirror 6 | 0.00000E+00 | 4.41835E-10 | 6.00081E-15 | 7.38177E-20 |

| Surface | D | E | F | G |
|---|---|---|---|---|
| Mirror 1 | -2.63123E-26 | 1.66073E-31 | -4.53482E-37 | 0.00000E+00 |
| Mirror 2 | -1.34329E-28 | 0.00000E+00 | 0.00000E+00 | 0.00000E+00 |
| Mirror 3 | 5.40918E-21 | -4.87366E-33 | 3.15160E-34 | 0.00000E+00 |
| Mirror 4 | -1.80141E-28 | 6.98855E-34 | -1.07684E-39 | 0.00000E+00 |
| Mirror 5 | -2.10000E-21 | -2.59472E-32 | 2.79150E-28 | 0.00000E+00 |
| Mirror 6 | 1.42935E-24 | -7.13172E-29 | 4.10735E-33 | 0.00000E+00 |

wobei:

| | | | |
|---|---|---|---|
| Surface: | die Oberfläche | Image: | die Bildebene |
| Object: | die Objektebene | Radius: | den Radius |
| Mirror 1: | den Spiegel S1 | Thickness: | die Dicke |
| Mirror 2: | den Spiegel S2 | Mode: | die Art der optischen |
| Mirror 3: | den Spiegel S3 | | Fläche |
| Mirror 4: | den Spiegel S4 | REFL: | eine reflektive Fläche |
| STOP: | die Aperturblende | INFINITY: | unendlich |
| Mirror 5: | den Spiegel S5 | K | konische Konstante |
| Mirror 6: | den Spiegel S6 | A,B,C,D,E,F,G | Asphärenkoeffizienten |

Fig. 7

Fig. 8

EP 1 840 622 A2

Fig.9

49

Fig. 10

Fig. 11

Fig. 12

FIG. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050088760 A
- US 2005008760 A

- US 2005088760 A

**In der Beschreibung aufgeführte Nicht-Patentliteratur**

- Handbook of optics. McGraw Hill), Inc, 1995, vol. 1, 35.3